# EUROPEAN PATENT SPECIFICATION

(11) **EP 2 321 605 B1**
(45) Date of publication and mention of the grant of the patent: **12.09.2018**
(21) Application number: 09803636.1
(22) Date of filing: 31.07.2009
(51) Int. Cl.: F28D 15/00, F28D 21/00, F28D 9/00, F28F 3/12, F25B 15/00, F25B 37/00

(54) **MICROSCALE HEAT OR HEAT AND MASS TRANSFER SYSTEM**
MIKROSKALIGES WÄRME- BZW. WÄRME- UND MASSEÜBERTRAGUNGSSYSTEM
SYSTÈME D'ÉCHELLE MICROSCOPIQUE DE TRANSFERT DE CHALEUR OU DE TRANSFERT DE CHALEUR ET DE MASSE

(30) Priority: 31.07.2008 US 85192 P
(43) Date of publication of application: 18.05.2011
(73) Proprietor: Georgia Tech Research Corporation, Atlanta, GA 30332-0415 (US)
(72) Inventor: GARIMELLA, Srinivas, Smyrna, GA 30080 (US); DETERMAN, Matthew, Delos, Atlanta, GA 30363 (US)
(74) Representative: HGF Limited
(86) International application number: PCT/US2009/052362
(87) International publication number: WO 2010/014878

(56) References cited:
- WO-A1-91/12470
- WO-A1-2006/085715
- WO-A2-01/93976
- WO-A2-99/66279
- US-A- 6 129 973
- US-A1- 2005 039 898
- US-A1- 2006 115 413
- US-A1- 2008 000 624
- US-B1- 6 230 408
- US-B1- 6 490 812
- US-B1- 6 631 624

## Description

### TECHNICAL FIELD

The present system relates generally to microscale heat transfer systems or heat and mass transfer systems, and more particularly to monolithic or integrated microscale heat or heat and mass transfer systems or apparatuses comprising a plurality of shims or layers, each shim including a plurality of microchannels for performing heat and/or mass exchange functions.

### BACKGROUND

Traditionally, vapor-compression systems have been used in various heating and cooling applications, such as residential and commercial air conditioners, chillers, and heat pumps. These systems generally comprise four basic components-an evaporator, compressor, condenser, and expansion device. The evaporator and condenser comprise heat exchangers that evaporate and condense refrigerant while absorbing and rejecting heat. The compressor takes the refrigerant vapor from the evaporator and raises its pressure sufficiently to condense the vapor in the condenser. After exiting the condenser, the flow of condensed refrigerant at higher pressure is controlled by the expansion device back into the evaporator, and the cycle repeats to produce continuous heating or cooling effects.

Traditional vapor-compression systems, however, have several disadvantages. For example, most vapor-compression systems rely on synthetic refrigerants that have negative environmental impact. Also, most vapor-compression systems utilize expensive, high-grade electrical energy for power. Further, vapor-compressions systems are often loud and unreliable due to the use of a compressor, and often employ bulky overall system designs that prohibit small-scale or portable use.

An absorption heat pump (also referred to herein as an "absorption cooling and/or heating system") can be considered an environmentally benign replacement for a traditional vapor-compression system. In principle, the compressor of a traditional vapor-compression system is replaced by a combination of a desorber, absorber, liquid solution pump, and recuperative solution heat exchanger to form an absorption heat pump. A benefit of absorption heat pumps is the reduced concern about reliability due to the absence of a major moving part, i.e., the compressor. The lack of a compressor in the absorption heat pump also implies much quieter operation as compared to a vapor-compression system. Further, unlike vapor-compression systems that utilize high-grade electrical energy as the input that drives the system, absorption heat pumps typically run on more readily available and low-grade thermal energy, which may be obtained from combustion of bio-fuels and fossil fuels, from largely untapped waste heat sources (e.g., automobile exhaust, excess manufacturing heat, etc.), from solar thermal energy, and other similar energy sources. In cooling mode operation, this thermal energy input is used to provide cooling and/or dehumidification, while in the heating mode, the heat input is used to pump ambient heat to higher temperatures.

Because the compressor of a vapor-compression system is replaced in an absorption heat pump by a combination of a desorber, absorber, liquid solution pump, and recuperative solution heat exchanger, absorption heat pumps are generally more heat and mass exchange intensive than vapor-compression systems, thereby requiring additional heat transfer surface area. Due to this comparatively larger surface area requirement, absorption heat pumps have typically been relegated to very large commercial and industrial chiller applications, and achieving compact designs while delivering high coefficients of performance (COPs) has been a major challenge. Additionally, several advanced absorption cycles, such as the double-effect, triple-effect, and Generator-Absorber Heat Exchange cycles developed to improve COPs, rely on additional internal recuperation to improve performance, further emphasizing the need for high heat and mass transfer rates per volume. In fact, these cycles have not been widely implemented primarily because of a lack of practically feasible and compact heat and mass exchange devices.

It is desirable, therefore, to achieve a compact absorption cooling and/or heating system that delivers outputs comparable to those of larger systems. However, in absorption systems that use the two most common working fluid pairs (i.e., lithium bromide-water and ammonia-water), processes such as absorption and desorption naturally involve coupled heat and mass transfer in binary fluids, leading to complexities and challenges in system design. Particularly, in ammonia-water systems, due to the presence of both absorbent (i.e., water) and refrigerant (i.e., ammonia) in the liquid and vapor phases throughout the system, such binary fluids processes occur in all components in the system (including the condenser, evaporator, rectifier, and recuperative heat exchangers). With other, less common working fluids (e.g., multi-component fluids), multi-component heat and mass transfer processes are required. For the implementation of absorption systems in compact, high-flux configurations that can take advantage of disperse availability of waste heat, solar thermal energy, or other energy in smaller capacities than at the industrial scales, the heat and mass exchanger designs should provide several features that are difficult to achieve simultaneously. For example, the systems should include low heat and mass transfer resistances for the working fluids, the requisite transfer surface area for the working fluids and the fluids that couple those working fluids to external heat sources and sinks in compact volumes, and low resistances for the coupling fluids, among other similar system properties.

Most of the available absorption component concepts fall short in one or more of these features essential for achieving compact, high-flux designs. For example, the primary configuration employed currently in commercial absorption chillers (i.e., absorption of vapor into solution films falling over tube banks carrying coolant liquid) suffers from high coolant-side resistances and poor wetting of the transfer surface by the liquid film. Additionally, some prior designs enhance absorption/desorption processes, but fail to reduce single-phase resistance on the other side (i.e., coupling fluid side), thereby requiring large system components, and resulting in high working fluid and coupling fluid pressure drop, which results in high parasitic power consumption and also results in losses in driving temperature differences due to decrease in saturation temperatures brought about by pressure drops within system components.

In addition to absorption cooling and/or heating systems, it is further desirable to provide various other heat transfer or heat and mass transfer systems for performing other functions, such as related cooling or heating functions, basic heat transfer, distillation, and other similar functionalities as will occur to one of ordinary skill in the art.

Therefore, there is a long-felt but unresolved need for a microscale heat or heat and mass transfer system or apparatus that provides compact, modular, versatile design that can be applied for high flux heat and mass transfer, both in individual system components and in the overall system assembly, while overcoming the weaknesses of currently-used configurations. There is a further need for a microscale, monolithic absorption heat pump that provides significant heating and cooling outputs from a portable, integrated system. The principal embodiments of the present system, and variants thereof, represent a miniaturization technology highly adaptable to a variety of design conditions, and also to several systems in multiple industries involved in binary, ternary, and other multi-component fluid heat and mass transfer. From US-A-2006115413 microchannel devices are disclosed that are capable of unit process operations involving the transfer of mass or heat.

### BRIEF SUMMARY OF THE DISCLOSURE

Briefly described, and according to one embodiment, aspects of the present disclosure generally relate to systems and apparatuses for absorption cooling and/or heating, or performing other heat and/or mass transfer functions. More particularly, according to one aspect, an array of parallel, aligned alternating shims with integral microscale passages and voids, fluid inlet and outlet passages, and vapor-liquid spaces as necessary, enclosed between cover plates, define the heat and mass transfer system components of a thermally-activated absorption heat pump. The assembly of parallel shims with microscale features directs fluid flow through a defined absorber, recuperative solution heat exchanger, desorber, rectifier (in applications using a working fluid with a volatile absorbent), condenser, recuperative refrigerant heat exchanger, and an evaporator, which together comprise the heat and mass transfer system components of a single-effect absorption heat pump. As described in greater detail herein, in a particular embodiment, the heat and mass transfer components are defined within a microscale, monolithic apparatus or assembly via pairs of alternating shims. In embodiments in which a double-effect, triple-effect, generator-absorber-heat exchange (GAX) cycle, or other advanced absorption cycle is desired, additional microscale features arranged into additional, defined, heat and mass transfer system components are incorporated into the apparatus to accomplish the requisite recuperative heat and mass transfer.

According to one aspect, the absorption cycle working fluid flows in microscale and other passages incorporated into one side of a shim, while the high (heat source), medium (heat rejection), and low (chilled stream) temperature coupling fluids flow on the other side of the shim in thermal contact with the respective working fluid streams on the initial side. Therefore, sets of two shims ("shim pairs"), with somewhat differentiated microscale feature geometries, comprise building blocks of an entire absorption heat pump or other heat or heat and mass transfer system that are duplicated in numbers required to accomplish the desired overall cooling or heating load. The features incorporated into each shim are arrayed in groups, with each group representing the corresponding passages for each heat or heat and mass transfer system component in a heat pump (e.g., absorber, desorber, etc.). Fluid connections between the respective, defined heat and mass transfer system components is achieved through connecting fluid lines external to the system, or through specifically designed routing passages between different parts of the shims or cover plates, or via some other similar connection mechanism. Generally, the working fluid is largely contained within the assembly of shims, therefore reducing fluid inventories several fold over conventional heat pumps that deliver similar capacities.

According to an additional aspect, cooling, heat rejection, and heat source fluid streams enter and leave the heat or heat and mass transfer apparatus through appropriate inlet and outlet connections, enabling versatile deployment of heating or cooling loads, irrespective of the physical location of the heat or heat and mass transfer apparatus. In one aspect, a working solution pump is provided external to the system assembly to pump the working fluid through the heat and mass transfer components and microchannels arrayed across each shim in the assembly. During the heat pump cycle, and according to a further aspect, expansion of the refrigerant stream and the refrigerant-absorbent solution from the low to high-side pressures (and intermediate pressures as necessary for advanced absorption cycles) is accomplished through integral tailored constrictions within the shims or through externally connected valves.

According to various aspects, the microchannels and other microscale passages in the shims comprise square, rectangular, semi-circular, semi-elliptical, triangular or other singly-connected cross-sections to enable fluid flow in single-phase or two-phase state, as necessary, with the microscale cross-section shape and dimensions determined based on heat and mass transfer requirements, operating pressures, structural strength of the assembled apparatus, manufacturing constraints for dimensional tolerances and bonding of the shims and cover plates, and other factors. Generally, the microscale channels in the shims are formed through processes such as lithography, etching, machining, stamping, or other appropriate processes based on overall assembly dimensions as well as microscale channel dimensions. Joining and assembly of a plurality of shim pairs and cover plates to form an embodiment of the microscale heat or heat and mass transfer system is accomplished through processes such as diffusion bonding and brazing for the most commonly utilized metallic assemblies, and if permitted or dictated by the working fluid, operating conditions, and desired loads, by gluing for plastic, ceramic, or other nonmetallic apparatus parts. Modularity in heat duties is achieved by varying the microscale channel dimensions, number of channels, length and width of the shims, and number of shim pairs.

According to another aspect, for large scale implementation of microscale heat or heat and mass transfer assemblies as described herein, multiple assemblies are connected in series and/or parallel arrangements through external plumbing to form a plurality of connected heat or heat and mass transfer assemblies. According to various aspects, for larger capacities, the shims are subdivided into individual assemblies representing each heat and mass transfer system component of the heat or heat and mass transfer system rather than a monolithic heat or heat and mass transfer assembly, to facilitate flexibility in connections, and largely unconstrained increases in delivered loads.

These and other aspects, features, and benefits of the claimed invention(s) will become apparent from the following detailed written description of the preferred embodiments and aspects taken in conjunction with the following drawings, although variations and modifications thereto may be effected without departing from the spirit and scope of the novel concepts of the disclosure.

### BRIEF DESCRIPTION OF THE DRAWINGS

The accompanying drawings illustrate one or more embodiments and/or aspects of the disclosure and, together with the written description, serve to explain the principles of the disclosure. Wherever possible, the same reference numbers are used throughout the drawings to refer to the same or like elements of an embodiment, and wherein:
FIG. 1 illustrates an embodiment of a monolithic, microscale heat or heat and mass transfer apparatus constructed and operated in accordance with various aspects of the claimed invention(s).
FIG. 2 shows an embodiment of the heat or heat and mass transfer apparatus as described herein with a cut out area illustrating a section of the cover plates removed from the apparatus to display a portion of the heat and mass transfer system components formed via the shims.
FIG. 3 illustrates an exemplary, fully-assembled embodiment of the heat or heat and mass transfer apparatus as described herein.
FIGS. 4A-4D show exploded perspective views of the exemplary microscale, heat or heat and mass transfer apparatus according to an embodiment of the present system.
FIG. 5 illustrates a schematic functional representation of the internal heat and mass transfer system components and the fluid flows between the components according to one embodiment of the present heat or heat and mass transfer apparatus.
FIGS. 6A and 6B are perspective views illustrating exemplary representations of shim A and shim B, respectively, according to one embodiment of the present system.
FIGS. 7A and 7B are front plan views illustrating exemplary representations of shim A and shim B, respectively, according to one embodiment of the present system.
FIGS. 8A and 8B show perspective views of portions of shims A and B, respectively, associated with a recuperative solution heat exchanger according to an embodiment of the present apparatus.
FIGS. 9A and 9B are enlarged perspective views of portions of shims A and B , respectively, associated with a recuperative solution heat exchanger according to an embodiment of the present apparatus (i.e., these figures are enlarged views of FIGS. 8A and 8B).
FIGS. 10A and 10B illustrate enlarged, perspective views of portions of a plurality of stacked shims A and B associated with a recuperative solution heat exchanger according to an embodiment of the present apparatus.
FIGS. 11A and 11B illustrate perspective views of portions of shims A and B, respectively, associated with a desorber and rectifier, according to an embodiment of the present apparatus.
FIGS. 12A and 12B illustrate perspective views of portions of shims A and B , respectively, associated with a condenser according to an embodiment of the present apparatus.
FIGS. 13A and 13B illustrate perspective views of portions of shims A and B, respectively, associated with a recuperative refrigerant heat exchanger according to an embodiment of the present apparatus.
FIGS. 14A and 14B illustrate perspective views of portions of shims A and B, respectively, associated with an evaporator according to an embodiment of the present apparatus.
FIGS. 15A and 15B illustrate perspective views of portions of shims A and B, respectively, associated with an absorber according to an embodiment of the present apparatus.
FIGS. 16A and 16B are enlarged perspective views of portions of shims A and B, respectively, associated with an absorber, and specifically illustrating locations of vapor inlet holes and passages in shims A and B according to an embodiment of the present apparatus.
FIG. 17 illustrates a modular embodiment not forming part of the present invention and comprising discrete heat and mass transfer system components associated with an absorption cooling and/or heating system.
FIG. 18 illustrates the steps associated with one embodiment of the photochemical etching process for manufacturing exemplary microchannels as described herein.
FIG. 19 illustrates a representation of a hot press vacuum furnace for diffusion bonding various shims, cover plates, and other system components together according to one embodiment of the present system.
FIG. 20 illustrates a cross-section of a portion of a plurality of stacked shims A and B showing representative arrangements of microchannels within the shims according to an exemplary embodiment of the present system.
FIG. 21 illustrates an enlarged cross-section of shims A and B illustrating a close-up view of specific, exemplary shim and microchannel dimensions according to an exemplary embodiment of the present system.
FIG. 22 shows an enlarged plan view of a header used in a heat and mass transfer system component according to an embodiment of the present system.
FIG. 23 shows a representative cross-section of alternating shims A and B taken from cross-section XX of the header in FIG. 22 according to one embodiment of the present system.
FIG. 24 illustrates a front plan view of exemplary fluid connections and external plumbing arrangements for testing an embodiment of the present system.

### DETAILED DESCRIPTION

Prior to a detailed description of the disclosure, the following definitions are provided as an aid to understanding the subject matter and terminology of aspects of the present systems and methods, are exemplary, and not necessarily limiting of the aspects of the systems and methods, which are expressed in the claims. Whether or not a term is capitalized is not considered definitive or limiting of the meaning of a term. As used in this document, a capitalized term shall have the same meaning as an uncapitalized term, unless the context of the usage specifically indicates that a more restrictive meaning for the capitalized term is intended. However, the capitalization or lack thereof within the remainder of this document is not intended to be necessarily limiting unless the context clearly indicates that such limitation is intended.

### Definitions/Glossary

***Absorbent:*** material or fluid that, either by itself or in multi-component form combined with ammonia or another refrigerant, comprises a working fluid or portion of a working fluid for performing the heat and mass transfer functions of a heat or heat and mass transfer system (e.g., an absorption heat pump) as described herein. Examples include, but are not limited to, water (in ammonia-water mixtures), lithium bromide (in lithium bromide-water mixtures), and other similar materials.

***Coefficient of performance (COP):*** ratio of a desired output (i.e., cooling or heating) from a system embodiment as compared to the input energy.

***Coupling fluid:*** fluid used to transfer heating and/or cooling to and from embodiments of the present system. Generally connects embodiments of the present system to one or more heat sources, heat sinks, ambient spaces, conditioned spaces, etc., generally via hydronic coupling. Examples include, but are not limited to, ethylene glycol-water solution, propylene glycol-water solution, calcium chloride-water solution, high temperature heat transfer fluids (e.g., synthetic oil), and other similar fluids. Sometimes referred to herein as *coolant.*

***Cover plate:*** rigid outer layer on outer sides of embodiments of the present system to provide structure, support, and, in some embodiments, fluid transfer channels to shims contained between cover plates. Cover plates generally include holes or inlet and outlet openings for transferring coupling fluid and working fluid flow streams entering and exiting embodiments of the system.

***Fluid distribution passage:*** channel or passage that transports fluid from voids formed by stacked-up shims (i.e., headers) to microchannels within heat and mass transfer system components or heat exchange components in embodiments of the present system. Generally synonymous with *distribution passage, fluid passage, passage,* or *passageway.*

***Header:*** element within a heat and mass transfer system component that provides an opening or port to receive or expunge fluid. Generally formed by a plurality of stacked-up voids associated with individual shims that, when combined, form a passageway for fluid flow. Types generally comprise *inlet headers* and *outlet headers.*

***Heat or heat and mass transfer system:*** a system for transferring heat or heat and mass comprising properties, features, dimensions, components, etc., as described herein. As will be understood and appreciated, generally describes a heat transfer system or a heat and mass transfer system formed by one or more heat and mass transfer system components, as described herein. Generally synonymous with *heat or heat and mass transfer apparatus, heat or heat and mass transfer assembly,* or *heat and*/*or mass transfer system.*

***Heat and mass transfer system component:*** generic term used to describe any component capable of performing heat and/or mass transfer, generally (although not always) within a larger heat or heat and mass transfer system. Examples include, but are not limited to, an absorber, recuperative solution heat exchanger, desorber, rectifier, condenser, recuperative refrigerant heat exchanger, evaporator, or other similar component. Generally (although not always) includes or comprises at least one *heat exchange component.* Generally synonymous with *heat and mass transfer component.* Sometimes synonymous with *heat exchanger.*

***Heat exchange component:*** generic term used to describe any component capable of performing heat transfer. May comprise a heat and mass transfer system component, or a sub-component thereof. Generally synonymous with *heat exchanger.*

***Microchannel:*** channel or passage of microscale dimensions formed in a shim as described herein for transferring fluid in single-phase or multi-phase state to accomplish heat and/or mass transfer functionality. Generally characterized by circular (or non-circular) cross-sections with hydraulic diameters less than 1 mm (although, as will be understood, channels larger than 1 mm may exhibit fluid flow and heat and mass transfer phenomena similar to microchannels at somewhat larger hydraulic diameters, depending upon the given fluid properties and operating conditions). Generally synonymous with *microscale passage* or *microscale channel.*

***Microscale:*** relatively smaller in size as compared to other systems or components of similar functionality and/or output. Generally miniature, as understood in the art.

***Monolithic:*** constituting one, undifferentiated whole or unit. Generally synonymous with *integrated.*

***Multi-component fluid:*** fluid comprising more than one discrete substance (i.e., more than one species). Examples include, but are not limited to, ammonia-water mixtures and lithium bromide-water mixtures. Generally synonymous with *multi-constituent fluid, multi-part fluid, binary fluid, ternary fluid, quaternary fluid, fluid pair,* etc.

***Refrigerant:*** material or fluid that, either by itself or in multi-component form combined with water or another absorbent, comprises a working fluid or portion of a working fluid for performing the heat and mass transfer functions of a heat or heat and mass transfer system (e.g., an absorption heat pump) as described herein. Examples include, but are not limited to, ammonia (in ammonia-water mixtures), water (in lithium bromide-water mixtures), and other similar materials. Generally synonymous with *ammonia,* as used herein.

***Shim:*** thin, rigid layer defining features associated with one or more heat or heat and mass transfer components as described herein. Generally includes a plurality of microchannels, fluid distribution passages, and voids for transferring working fluid and/or coupling fluid across the shim. Generally synonymous with *layer* or *laminate.*

***Shim group:*** combination of a plurality of shim pairs bonded or otherwise combined together to define one or more heat or heat and mass transfer system components.

***Shim pair:*** combination of two discrete shim types (e.g., A and B, described herein) bonded or otherwise combined together to enable heat and/or mass transfer between fluids flowing in microchannels, voids, and other passages in each shim.

***Void:*** hole or space defined by a plurality of stacked-up shims that enables fluid flow in to our out of a heat or heat and mass transfer system component. Generally relates to the space within or formed by a *header.* Generally synonymous with *stacked-up void* or *vapor-liquid space.*

***Working fluid:*** fluid transferred throughout embodiments of the present system to accomplish heat and/or mass transfer functions. At various stages in an absorption cycle process or other similar heat cycle, can be in liquid state, vapor state, or liquid-vapor mixture. Examples include, but are not limited to, ammonia-water mixtures and lithium bromide-water mixtures. Generally comprises multi-component fluids, but also comprises single-component fluid as needed.

### Overview

For the purpose of promoting an understanding of the principles of the present disclosure, reference will now be made to the embodiments illustrated in the drawings and specific language will be used to describe the same. It will, nevertheless, be understood that no limitation of the scope of the disclosure is thereby intended; any alterations and further modifications of the described or illustrated embodiments, and any further applications of the principles of the disclosure as illustrated therein are contemplated as would normally occur to one skilled in the art to which the disclosure relates. All limitations of scope should be determined in accordance with and as expressed in the claims.

Aspects of the present disclosure generally relate to heat or heat and mass transfer systems or apparatuses. Particularly, one embodiment of the present apparatus comprises a plurality of shims assembled or pressed between two outer plates that, when combined, form discrete but integrated heat and mass transfer system components that make up a microscale, monolithic absorption cooling and/or heating system or absorption heat pump, or other heat or heat and mass transfer system. The shims generally include a plurality of microchannels, voids, and other heat transfer features for transferring working fluids and coupling fluids between defined heat and mass transfer system components throughout the apparatus, and into and out of the apparatus to and from heating and cooling sources and sinks as needed. According to one embodiment, two distinct shim types are used (i.e., shims A and B, described in greater detail below), and the shims are combined (e.g., bonded together) as a plurality of shim pairs, wherein the two distinct shims in each pair comprise slightly different microchannel and fluid passage arrangements as compared to each other to enable thermal contact between the fluids flowing within the microchannels in each shim pair.

According to one aspect, each shim includes the geometries of all of the necessary heat and mass transfer system components that comprise an absorption cooling and/or heating system, namely, an absorber, recuperative solution heat exchanger, desorber, rectifier, condenser, recuperative refrigerant heat exchanger, and an evaporator. As will be appreciated, these heat and mass transfer components perform their conventional functions as understood by one of ordinary skill in the art. Thus, in one embodiment, when a plurality of shim pairs are combined, a microscale absorption heating and/or cooling system is formed. Further, as pairs of shims are stacked and combined together, the number of microchannels (and, hence, the overall heat exchange surface area) of each heat and mass transfer component increases, thereby increasing the heat exchange capacity of each component and the overall system. In this way, embodiments of the present apparatus comprise monolithic, microscale heat or heat and mass transfer systems that can be scaled to meet individual application requirements as desired.

As described in greater detail herein, embodiments of the present invention(s) yield compact overall geometries for absorption heat pumps and other heat or heat and mass transfer apparatuses, with several fold reductions in system volume as compared to conventional systems for equivalent cooling and/or heating loads. As described previously, conventional absorption heat pumps require additional heat and mass transfer components as compared to vapor-compression systems, leading to larger overall system sizes. Accordingly, it has previously not been possible to implement heat-driven absorption heat pumps in small geometries. Embodiments of the present invention(s), however, exploit the inherent and novel advantages of fluid flow and heat and mass transfer phenomena at microscales to enable high cooling and heating capacity systems in relatively small system packages. Therefore, embodiments of the present system are able to take advantage of: a) high heat and mass transfer coefficients in small hydraulic diameter microscale passages, b) large surface-to-volume ratios at small hydraulic diameters, c) flexibility of parallel flows in pluralities of microchannels in multiple parallel shim assemblies to achieve high heat and/or mass transfer rates with low pressure drops, and d) the ability to modify microchannel dimensions, the numbers of microchannels used in each heat and mass transfer component, the number of shims used in the system, and overall system envelope width and length to precisely tailor system size to desired loads. Further, as described in greater detail below, hydronic coupling and the absence of long interconnecting lines between heat and mass transfer system components (due to the relatively small size of system embodiments) minimizes working fluid inventories, overall system size and mass, fluid pressure drops, parasitic power requirements, and undesirable heat losses and gains to and from the ambient.

Generally, embodiments of the present system utilize thermal energy as the input energy source, such as waste heat, solar energy, energy from primary fuel combustion, etc. A wide range of source energy temperatures are utilized to provide cooling and/or heating, and a wide range of heating and cooling loads are supplied using the present system. Accordingly, embodiments of the system inherently allow for modular design of heating or cooling capacities ranging from a few Watts to Megawatts. Generally, the utilization of microscale fluid flow and heat and mass transfer principles enables the realization of compact system assemblies that deliver substantially higher cooling and heating capacities in equivalent system volumes as compared to conventional or prior systems. Embodiments of the system require relatively minimal use of electrical energy to pump the working fluids. Preferably, multi-component fluid mixtures are used as working fluids so that the system need not use synthetic fluids with ozone-depleting and global warming potential, and therefore the system has minimal adverse environmental impact.

As will be appreciated, embodiments of the present system are useful for a variety of commercial applications. Generally, embodiments of the present system can be implemented as replacements for conventional vapor-compression systems or absorption heat pumps in most applications, especially when small-scale applications are needed. However, as will be understood, embodiments of the present apparatus can be utilized in a variety of applications, including but not limited to, waste heat recovery and upgrade applications, heat-driven chillers and heating and air-conditioning systems, cogeneration systems, heat transformers, integrated cooling, heating, and power systems, vehicular, marine, naval, and stationary climate control systems, processing and refrigerated transport of food, medicines, vaccines, and other perishable items, harvesting of ambient moisture for potable water using thermal energy input, micro-reactors and combustors, and a variety of other applications as will occur to one of ordinary skill in the art.

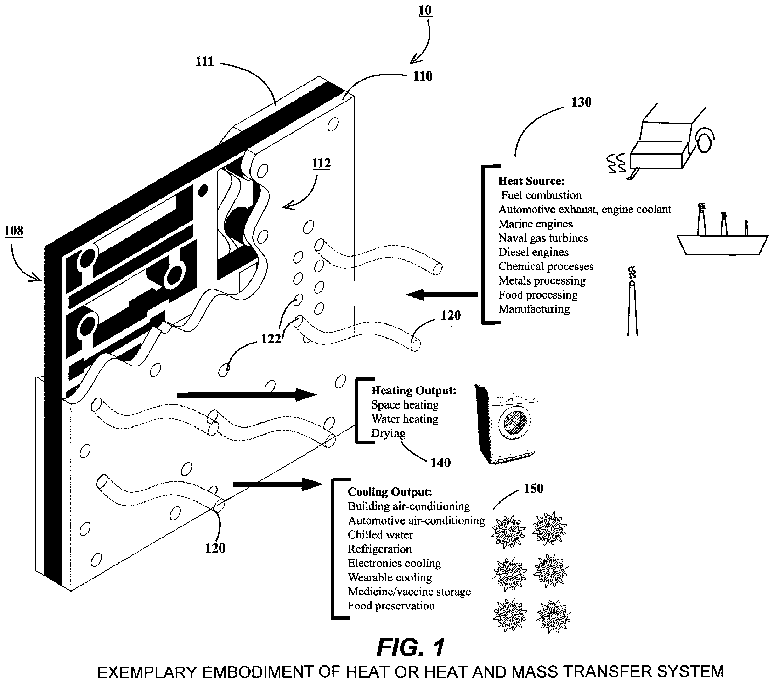

For purposes of example and explanation of the fundamental functions and components of the disclosed systems and apparatuses, reference is made to FIG. 1, which illustrates an embodiment of a monolithic, microscale heat or heat and mass transfer apparatus **10** constructed and operated in accordance with various aspects of the claimed invention(s). The particular embodiment shown in FIG. 1 (and referenced throughout this disclosure) comprises a monolithic, microscale absorption cooling and/or heating system (i.e., absorption heat pump) including various heat and mass transfer system components as described herein. As will be understood and appreciated, however, the exemplary microscale heat or heat and mass transfer system **10** shown in FIG. 1 represents merely one approach or embodiment of the present system, and other aspects are used and contemplated as described herein and as understood by one of ordinary skill in the art.

As shown, the heat or heat and mass transfer apparatus **10** includes two cover plates **110, 111,** a shim group **108** (generally comprising a plurality of shims **102, 104,** described in greater detail below) sandwiched between the cover plates, and a plurality of coupling fluid lines **120** for transferring coupling fluid into and out of the apparatus **10.** As shown, the cover plates comprise two cover plate types, namely, front cover plate **110** and back cover plate **111,** that, depending on the particular embodiment, include various holes **122** for transporting fluid to and from the apparatus **10.** As will be understood, the arrangement of holes **122** and overall structure of the cover plates **110, 111** may or may not vary between each cover plate **110, 111** depending on the particular system embodiment.

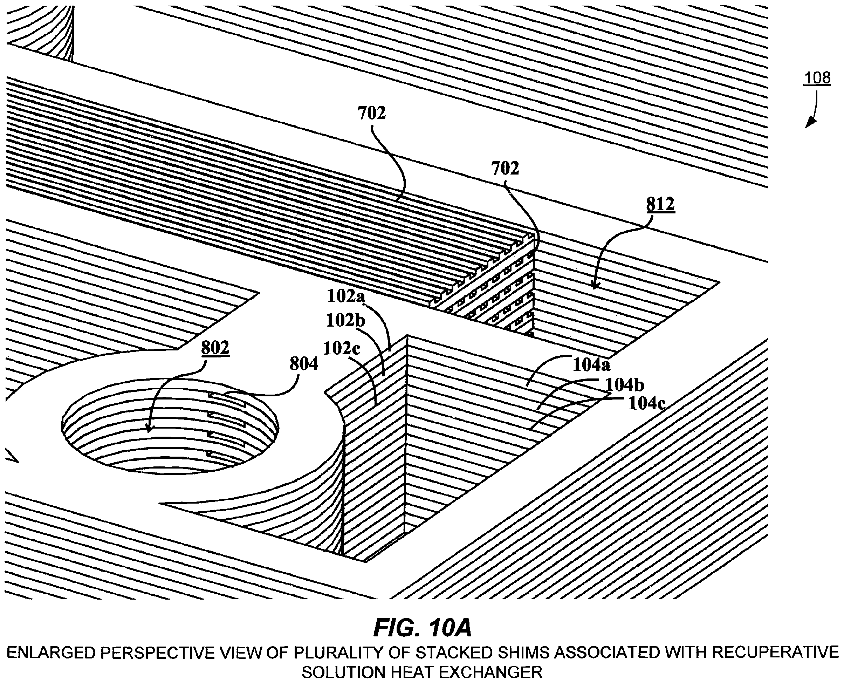

As described herein, shim group **108** generally includes a plurality of shims **102, 104.** Referring briefly to FIG. 10A, an enlarged, perspective view of a portion of a plurality of stacked shims **102, 104** associated with a shim group **108** within an exemplary heat and mass transfer system component according to an embodiment of the present apparatus is shown. The specifics and particulars of FIG. 10A are discussed in greater detail below; the figure is discussed here, however, to illustrate the stacked-up arrangement of shims in a shim group **108** according to one embodiment of the present apparatus **10.** The shims **102, 104** include a plurality of microchannels, voids, and other heat transfer features (described in greater detail below) for effectuating fluid transfer between the shims and between heat and mass transfer components (and, accordingly, for effectuating heat and mass transfer throughout the assembly **10**).

According to one embodiment, the shims comprise two shim types (i.e., shims A **102** and B **104,** described in greater detail below), such that the shims are stacked and aligned in alternating fashion within the heat transfer apparatus **10** to form a plurality of shim pairs (each pair including one of each shim type, A and B). In the embodiment shown in FIG. 10A, the shims are arranged in alternating fashion of the two, described shim types, **102a, 104a, 102b, 104b, 102c, 104c,** ... **102n, 104n,** where "n" represents the total number of shim pairs in the shim group used to perform the desired heat and/or mass transfer functionality. As is described in detail herein, the two disparate shim types include differing microchannel arrangements to enable alternating fluid flows and heat and mass transfer functionality throughout the apparatus **10.**

Returning to FIG. 1, cut out area **112** illustrates a section of the cover plates **110, 111** removed from the apparatus **10** to display a portion of the heat and mass transfer system components formed via the shim group **108** (and the shims **102, 104**). As shown in cut out area **112,** one of the heat and mass transfer system components of the exemplary heat pump is shown in its entirety (specifically, the condenser), as defined by a plurality of combined shims. The design and aspects of each heat and mass transfer system component and its operation with respect to the exemplary, overall absorption cooling and/or heating assembly, is described in greater detail below.

According to various embodiments, the shims **102, 104** are manufactured from steel or other thermally conductive metals, ceramics, plastics (in low temperature applications), and other similar materials as will occur to one of ordinary skill in the art. The cover plates **110, 111** are manufactured from materials similar or dissimilar to those of the shims, as long as the resulting cover plates have adequate strength and rigidity characteristics to hold the assembly **10** together during operation. The microchannels (discussed below) in the shims **102, 104** are generally formed via a photochemical etching process or other etching process, lithography, stamping or machining during shim manufacturing, or other similar micro-cutting technique. Once manufactured, the shims **102, 104** and cover plates **110, 111** are bonded together via diffusion bonding, brazing, or gluing (in low temperature applications), or combined via a bolted or clamped assembly, or otherwise assembled via similar bonding or assembly techniques, to form a monolithic, microscale heat or heat and mass transfer system **10.**

As shown in FIG. 1, the heat or heat and mass transfer system **10** (shown in FIG. 1 as an absorption heat pump) receives input heat from heat source **130** via conventional fluid coupling through coupling fluid lines **120.** The coupling fluid lines are attached to the apparatus **10** via holes **122** in the cover plates **110, 111** to transport coupling fluid into our out of the heat or heat and mass transfer apparatus. According to various embodiments, holes **122** can also be used to transport working fluids from one internal heat and mass transfer component to another via external working fluid lines (not shown). As will be understood, however, working fluids may also be transferred between heat and mass transfer components within the assembly **10** via connections incorporated into the cover plates **110, 111** or the shims **102, 104** themselves. As will be understood, external heating and cooling is not necessarily supplied via hydronic coupling in all embodiments, and it may be supplied via a hot gas stream, e.g., a flue gas stream, condensing steam, or other high temperature condensing fluid, or externally-heated solid conductive heaters, or some other similar technique depending on the particular embodiment. Additionally, although the embodiment of the apparatus **10** shown in FIG. 1 receives heat from a heat source **130** and expunges heating output **140** and/or cooling output **150,** embodiments of the present system can be designed to perform a variety of heating and/or cooling functions as will occur to one of ordinary skill in the art.

As listed in FIG. 1, examples of heat sources **130** include fuel combustion, automotive exhaust, engine coolant, marine engine heat, naval gas turbine heat, diesel engine heat, or heat from chemical processes, metals processing, food processing, and a variety of other manufacturing processes. As described previously, the heat source is derived from thermal energy. Examples of heating outputs **140** (i.e., applications or uses for heat expelled by the system) include space heating (e.g., home or office heating), water heating, and drying. Examples of cooling outputs **150** (i.e., applications or uses for cooling expelled by the system) include building or automotive air-conditioning, dehumidification, chilling water, refrigeration, electronics cooling, wearable cooling applications (e.g., cooling systems in firefighter uniforms), medicine storage, and food preservation. As will be understood and appreciated, the lists of potential heating sources, and heating and cooling outputs (applications) are provided for exemplary purposes only, and are not intended to limit the scope of the present disclosure or the embodiments described herein.

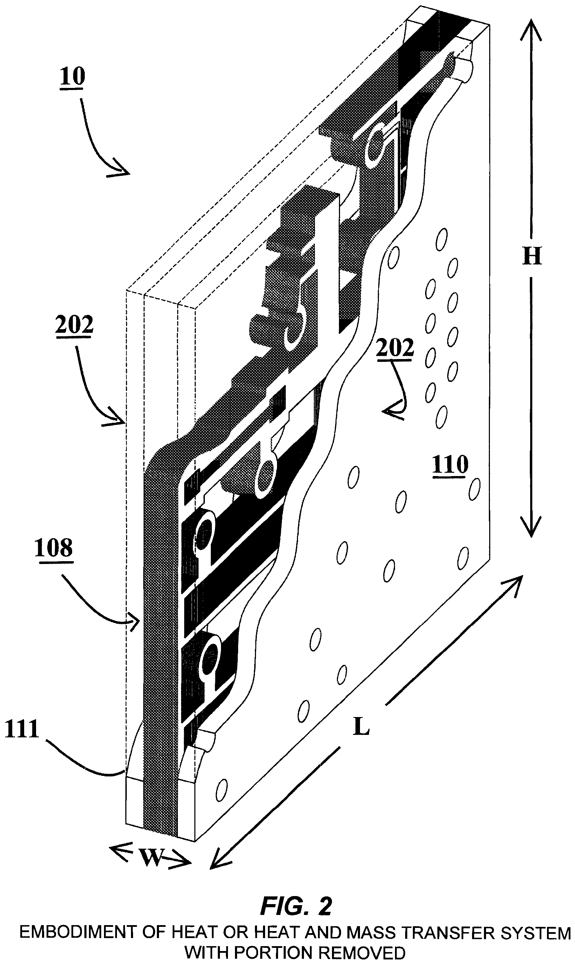

FIG. 2 shows an embodiment of the heat or heat and mass transfer apparatus **10** as described herein with cut out area **202** illustrating a section of the cover plates **110, 111** removed from the apparatus **10** to display a portion of the heat and mass transfer system components formed via the shims **102, 104** in shim group **108.** Portions of shim group **108** are also illustrated as removed to further illustrate the inner workings and geometry of an exemplary embodiment of the present system. As shown, the embodiment in FIG. 2 does not include the coupling fluid lines **120** to facilitate easier viewing of the illustrated system embodiment.

As shown in FIG. 2, the exemplary apparatus **10** generally comprises a rectangular prism shape, and has dimensions L × H × W (i.e., length × height × width). As will be understood, however, other system shapes are used according to other embodiments as needed. As previously described, embodiments of the present system generally comprise micro scale systems that are much smaller in size as compared to conventional heat and mass transfer systems (e.g., conventional absorption heat pumps and other related systems). However, as will be understood, embodiments of the present apparatus **10** can be scaled to fit virtually any application. For example, one specific, exemplary embodiment (described in greater detail below) includes L × H × W dimensions of 200 × 200 × 34 mm³, respectively. However, even smaller embodiments (e.g., 120 × 120 × 25 mm³, and smaller) are used depending on the necessary cooling and heating loads of the particular application. Additionally, individual shim thickness (i.e., width) is variable as well, but an exemplary thickness of 0.5 mm is associated with an exemplary embodiment as described herein.

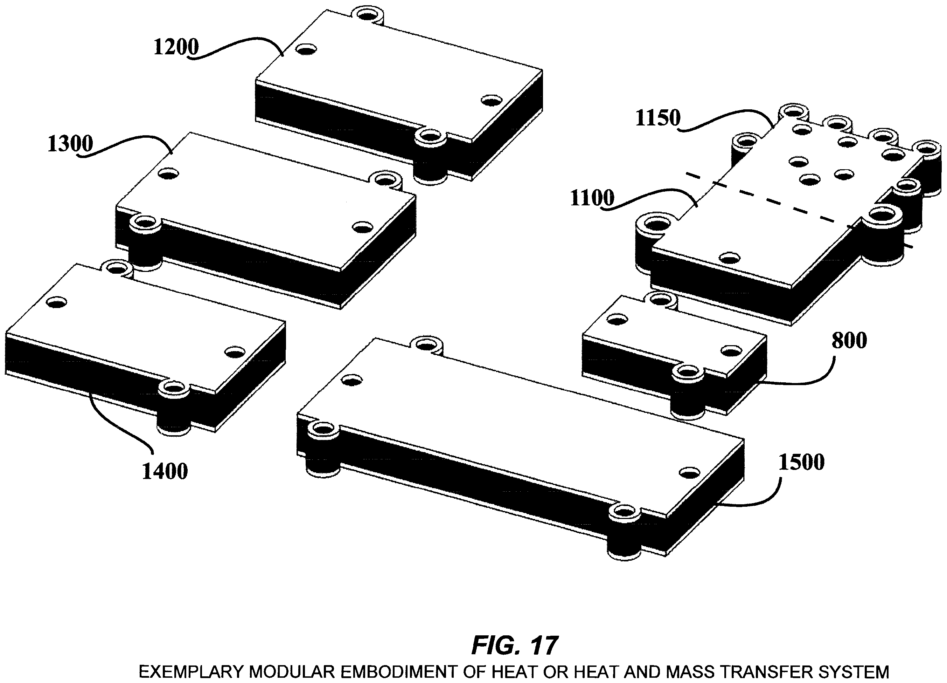

Alternatively, in applications in which size is a relatively insignificant factor, and greater heating and cooling loads and capacities are needed, embodiments of the present system can be scaled to large-scale apparatuses limited only by available storage space and manufacturing constraints. Further, according to various embodiments, the individual heat and mass transfer system components are removed from the overall assembly **10** (i.e., the shims define a singular heat and mass transfer component instead of a plurality of components) to enable modularity in overall system design (described in greater detail below in conjunction with FIG. 17).

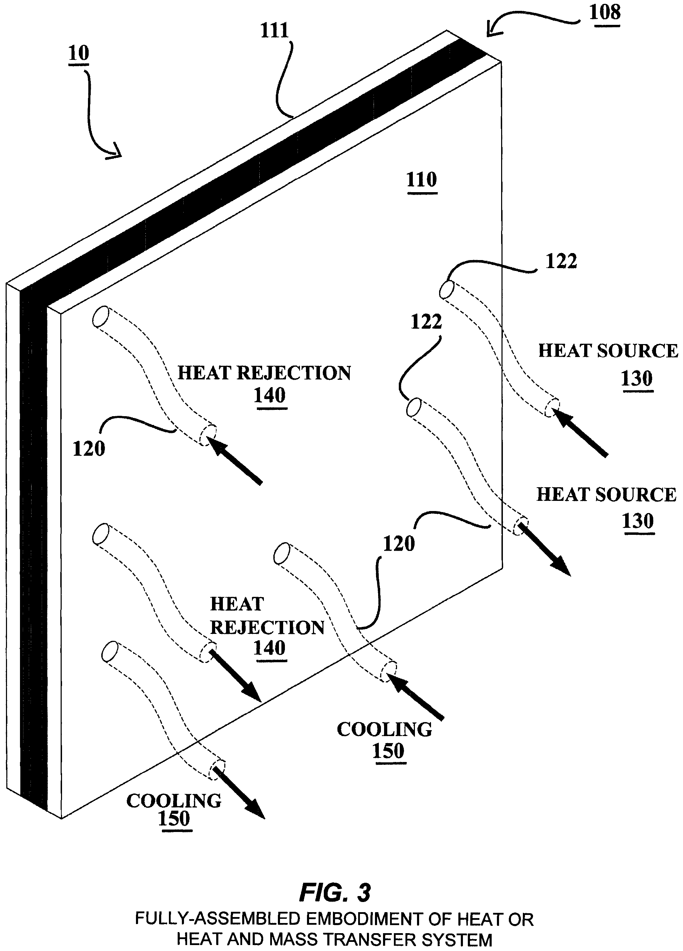

FIG. 3 illustrates an exemplary, fully-assembled embodiment of the heat or heat and mass transfer apparatus **10** as described herein. The apparatus shown in FIG. 3 represents a system wherein all included shims **102, 104** in the shim group **108** and cover plates **110, 111** have been bonded (e.g., via diffusion bonding, brazing, etc.) or otherwise combined together. As shown, all optional holes **122** for the particular embodiment shown have been removed from the cover plates **110, 111,** such that only coupling fluids transferring heat and cooling into and out of the apparatus are entering or exiting the apparatus **10** via the coupling fluid lines **120.** The apparatus **10** shown in FIG. 3 represents an embodiment of the present system, as described previously, that transfers all working fluids internally (i.e., via connections or channels in the cover plates **110, 111** or shims **102, 104** themselves). Accordingly, holes for connecting external working fluid lines to transfer working fluids between internal heat and mass transfer system components are unnecessary in the shown embodiment.

The coupling fluid lines **120** in FIG. 3 illustrate exemplary coupling fluid flow into and out of the apparatus **10.** The coupling fluid lines **120** transfer coupling fluid to and from the heat source **130** to supply heat to the apparatus **10,** to and from the heat rejection (output) **140** to expel heat to an external application, and to and from the cooling output **150** to transfer cooling to a conditioned space. As described previously, however, in some embodiments, heat input is provided not via coupling fluid lines and coupling fluid, but via a hot gas stream, conductive heaters, or other similar techniques.

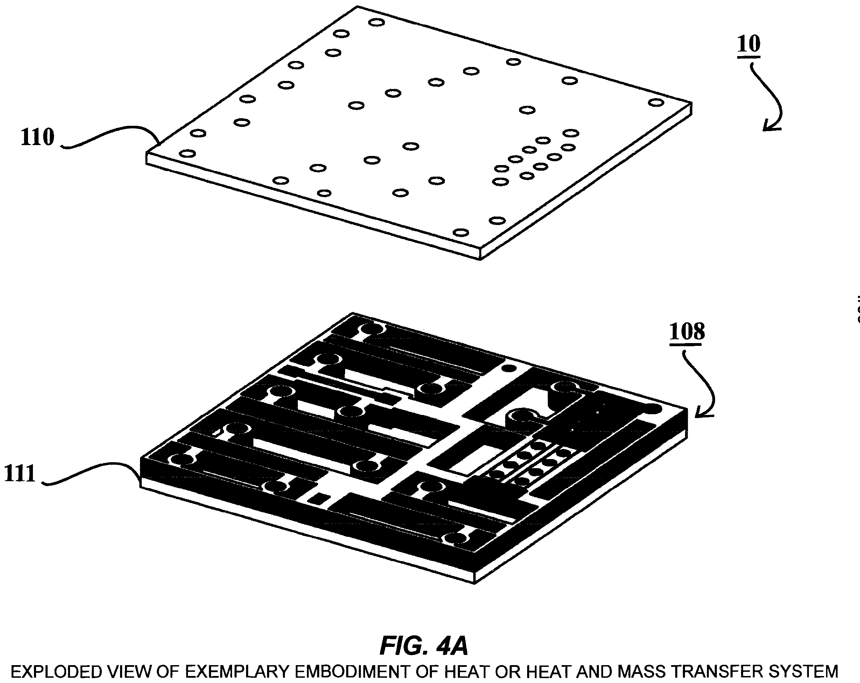

FIGS. 4A-4D show exploded perspective views of the exemplary microscale, heat or heat and mass transfer apparatus **10** according to an embodiment of the present system. FIG. 4A shows a perspective view of an embodiment of the apparatus **10** with a cover plate **110** removed from the remainder of the apparatus (i.e., from the combined plurality of shims **102, 104** in shim group **108** and the cover plate **111** on the alternate side of the apparatus). As shown, a plurality of shim pairs (each shim pair comprising shim A bonded to shim B, the details of each shim described in greater detail below) are combined to form a group of shims **108.** The number of shim pairs included within the apparatus varies depending on the particular application in which the apparatus is used (e.g., based on heating and cooling loads needed, size and weight constraints, etc.).

As will be understood, as more shims (and shim pairs) are combined in the shim group **108,** the corresponding number of microchannels increases, as does the resulting surface area for thermal contact associated with the microchannels in each heat and mass transfer system component within the apparatus **10** (described in greater detail below). Thus, for applications that require greater cooling and or heating outputs, greater numbers of (and/or larger) shim pairs are needed. For example, in its most basic implementation, a single shim pair comprising one shim A **102** and one shim B **104** may be adequate to form the shim group **108** to perform the necessary heat and mass transfer functions of a given application. In other embodiments, tens, hundreds, or more shim pairs may be used. As will be understood, the number of shims used and overall shim and apparatus size depends on the particular use and application of each particular system embodiment.

Still referring to FIG. 4A, exemplary shim group **108** defines the heat and mass transfer system components of an absorption cooling and/or heating system. As shown, each heat and mass transfer system component is formed by a plurality of stacked or combined shim pairs that define the features and geometries of each component in the shim group **108.** The specifics of these heat and mass transfer components and the fluid transfer within and between each component are described in greater detail below.

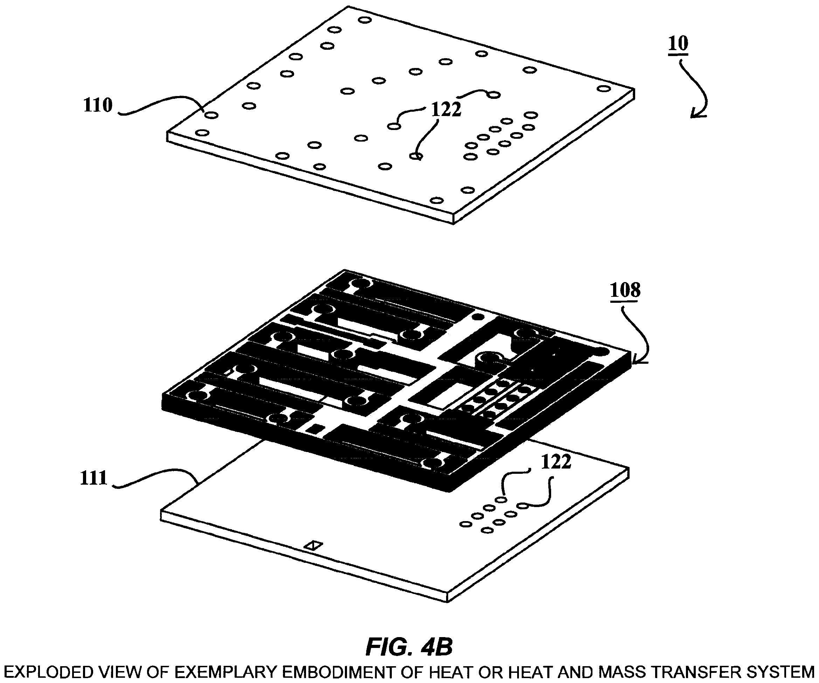

FIG. 4B shows a perspective exploded view of an embodiment of the apparatus **10** with cover plates **110, 111** separated from shim group **108.** In the embodiment shown, the arrangement of holes **122** is different for each of the two cover plates **110, 111.** This difference in hole arrangements is attributed to differences in attachment points for various coupling fluid lines and working fluid lines on either side of the apparatus **10.** As mentioned previously, various embodiments of the present apparatus include varying numbers and locations of holes **122** depending on the manner in which working fluid is transferred between internal heat and mass transfer components (e.g., through connections or channels in the cover plates or via external working fluid lines, etc.), and also depending on how and whether coupling is used to provide and receive heating and cooling to and from the apparatus, etc.

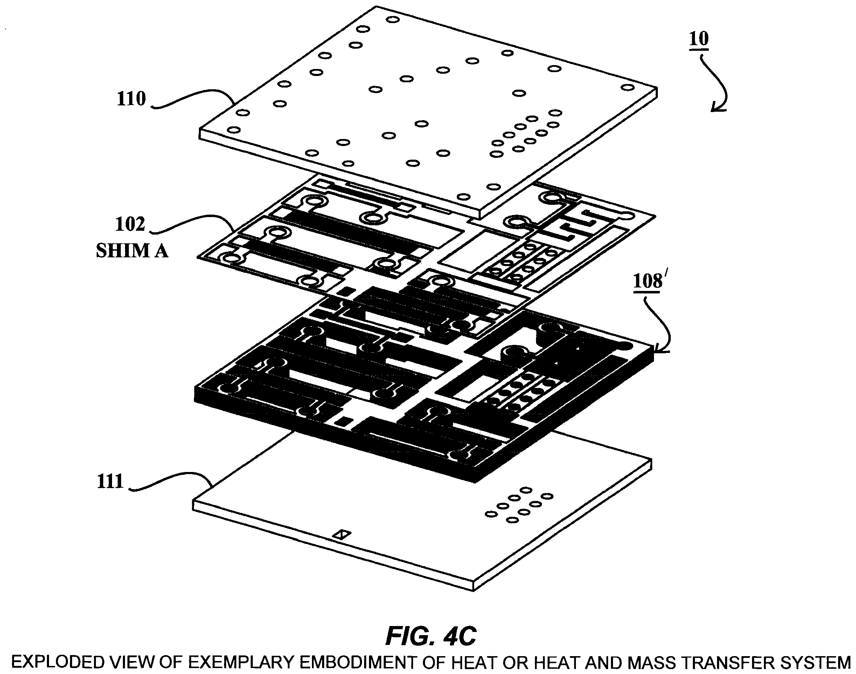

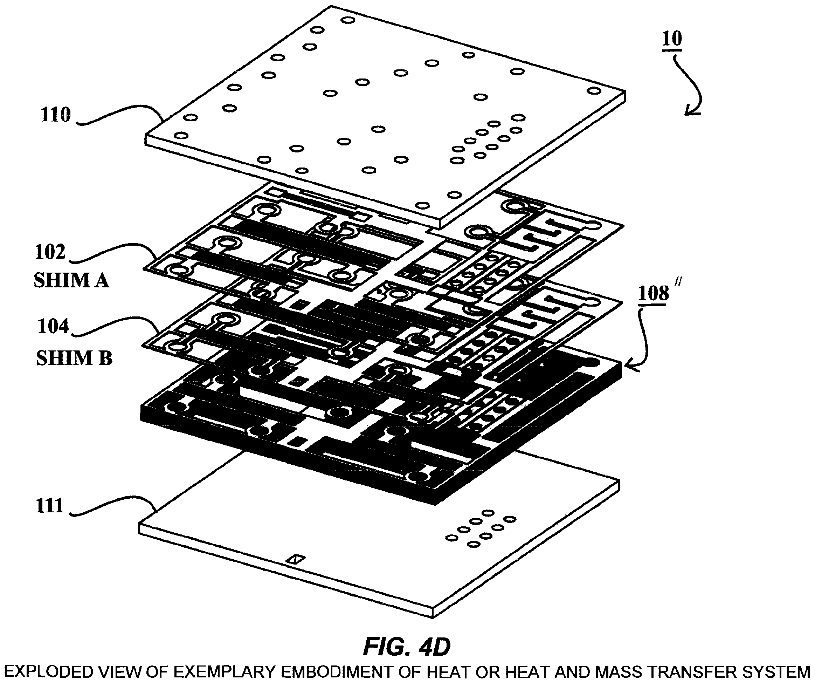

FIG. 4C shows a perspective exploded view of an embodiment of the apparatus **10** with cover plates **110, 111** separated from shim group **108',** and with a single shim A **102** separated from the shim group **108'.** Shim group **108'** is similar to shim group **108** shown previously in FIGS. 4A and 4B, except that one of the plurality of shim A's has been separated from the shim group. FIG. 4D shows a perspective exploded view of an embodiment of the apparatus **10** with cover plates **110, 111** separated from shim group **108",** and with a single shim A **102** and a single shim B **104** separated from the shim group **108".** Shim group **108"** is similar to shim group **108'** shown previously in FIG. 4C, except that one of the plurality of shim B's has been separated from the shim group. As described previously, shims A and B together form a shim pair. Thus, shim group **108"** comprises a plurality of shim pairs, but with one less shim pair as compared to shim group **108** (shown in FIGS. 4A and 4B). As also described previously, when the apparatus **10** is fully assembled, the shims **102, 104** and cover plates **110, 111** are bonded or otherwise combined together to define the necessary heat and mass transfer components of an absorption cooling and/or heating system, or some other similar heat and/or mass transfer device.

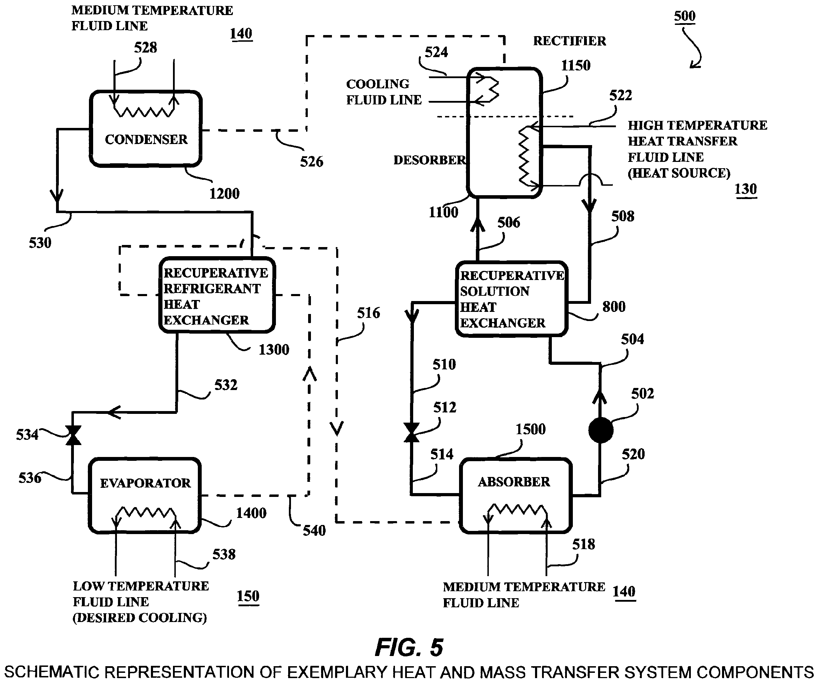

FIG. 5 illustrates a schematic functional representation **500** of the internal heat and mass transfer system components and the fluid flows between the components according to one embodiment of the present heat or heat and mass transfer apparatus **10.** The fundamental functions and processes of the heat and mass transfer components in the exemplary apparatus **10** are shown and described in relation to FIG. 5, whereas an exemplary architecture and geometry of these components as defined by the shims **102, 104** is shown and described in greater detail in relation to subsequent figures below. In the exemplary embodiment shown, the system is arranged for operation as a single-effect, ammonia-water (i.e., working fluid) absorption heat pump in cooling mode. As will be appreciated, however, other arrangements are used according to various embodiments, such as double-effect, triple-effect, and other multi-effect systems utilizing various types of working fluids and multi-component fluids (e.g., lithium bromide-water), as described in greater detail below. Additionally, minor modifications to the system shown in FIG. 5 enable heating mode operation (also described in greater detail below).

With reference to the schematic representation **500** shown in FIG. 5, fluid coupling is used to connect the heat source **130,** ambient for heat rejection **140,** and the conditioned space **150** to the internal heat and mass transfer components within the apparatus **10** carrying the working fluid pair (e.g., ammonia-water). As shown, concentrated ammonia-water solution (i.e., working fluid) exiting the solution pump **502** at the system high-side pressure is carried by fluid line **504** to the recuperative solution heat exchanger **800.** Upon recuperative heating in the recuperative solution heat exchanger **800,** the ammonia-water solution further proceeds via fluid line **506** to the desorber component **1100,** where an ammonia-water vapor mixture is desorbed from the ammonia-water solution. The ammonia-water solution (i.e., dilute solution) exits the desorber by fluid line **508,** and flows to the previously mentioned recuperative solution heat exchanger **800.** The dilute solution is cooled in the recuperative solution heat exchanger **800,** and subsequently exits through fluid line **510,** which carries it to the solution expansion valve **512.**

Upon expansion in the expansion valve **512** to the low-side pressure of the system, the dilute solution exiting through line **514** enters the absorber component **1500,** where it absorbs refrigerant (i.e., ammonia) vapor arriving from the recuperative refrigerant heat exchanger **1300** through line **516** (described in greater detail below). As shown, dashed lines (e.g., line **516**) represent a vapor phase of the working fluid, whereas solid lines (e.g., line **510**) represent a liquid phase. As referred to herein and as understood in the art, when describing ammonia-water working fluid, "ammonia" is generally synonymous with "refrigerant", and "water" is generally synonymous with "absorbent" (although, as is understood, refrigerant may not comprise pure ammonia, as some relatively minimal or trace amounts of water may be present, and vice versa). Alternatively, when describing lithium bromide-water working fluid, "lithium bromide" is generally synonymous with "absorbent", and "water" is again generally synonymous with "refrigerant". These terms are understood in the art as applicable to any refrigerant-absorbent working fluid pair.

Still referring to FIG. 5, heat of absorption rejected by the dilute solution in the absorber **1500** is removed by a medium temperature coupling fluid line **518** that eventually rejects heat to the ambient (e.g., heating output **140**). Upon absorption of refrigerant vapor into the dilute solution in the absorber **1500,** the resulting concentrated ammonia-water solution leaves the absorber through fluid line **520** to the previously described solution pump **502,** where it is again pumped to the recuperative solution heat exchanger **800** (described previously).

Returning to discussion of the desorber **1100,** heat of desorption is conveyed to the desorber by a high-temperature heat transfer fluid line **522,** which is in turn connected to the heat source **130** that drives the system (i.e., fluid coupling with heat source). Ammonia-water vapor leaving the desorber component **1100** (described previously) enters the rectifier component **1150,** wherein a cooling fluid line **524** is employed to rectify the ammonia-water vapor to a higher concentration of ammonia. As shown, the rectifier **1150** and desorber **1100** are combined in a single component; however, as will be understood, these components may be separated according to various embodiments as desired. Depending on the particular embodiment, the cooling fluid employed in cooling fluid line **524** is a medium temperature hydronic fluid, or the concentrated solution exiting the solution pump **502,** or some other fluid depending on the particular system design and operating conditions.

Reflux ammonia-water solution from the rectifier **1150** returns to the desorber **1100,** where it is expunged through fluid line **508** (described previously). High concentration ammonia (i.e., refrigerant) vapor exiting the rectifier **1150** is conveyed to the condenser component **1200** via fluid line **526.** In the condenser **1200,** the concentrated ammonia vapor is condensed and subcooled to liquid refrigerant (i.e., ammonia) by medium temperature hydronic fluid line **528** that eventually rejects heat of condensation to the ambient (e.g., heat rejection **140**). Liquid refrigerant leaving the condenser **1200** through fluid line **530** enters the previously-mentioned recuperative refrigerant heat exchanger **1300,** where it is further cooled by vapor-phase refrigerant exiting the evaporator component **1400** (described below). The cooled liquid refrigerant exits the recuperative refrigerant heat exchanger **1300** through fluid line **532,** which carries it to the refrigerant expansion valve **534.** Upon expansion to the system low-side pressure, the resulting two-phase refrigerant mixture is conveyed to the evaporator component **1400** by fluid line **536.**

In the evaporator component **1400,** vaporization of the two-phase refrigerant mixture effects cooling of the low-temperature coupling fluid entering through line **538.** Fluid line **538** is eventually connected (via hydronic coupling) to the conditioned space where the desired cooling (e.g., space-conditioning **150**) is achieved. Vaporized refrigerant exits the evaporator **1400** through line **540** and flows to the previously-discussed recuperative refrigerant heat exchanger **1300,** where it serves as coolant for the liquid (high pressure) refrigerant exiting the condenser **1200** and entering the recuperative refrigerant heat exchanger **1300** through line **530.** The heated refrigerant vapor exits the recuperative refrigerant heat exchanger **1300** through line **516** and flows to the absorber component **1500** (as described previously) to complete the cycle.

As described previously, minor modifications to the system shown in FIG. 5 enable heating mode operation (as opposed to cooling mode, as shown). For example, coupling the low temperature fluid line **538** of the evaporator **1400** to an outdoor ambient as opposed to a conditioned space, and coupling the medium temperature fluid lines **528, 518** of the condenser **1200** and absorber **1500** to a conditioned space as opposed to outdoor ambient for heat rejection, would enable heating mode operation without changing the assembly or components of the apparatus **10.** As will be understood and appreciated, various arrangements of connections between heat and mass transfer system components and external heating and cooling sources enable various modes of operation of embodiments of the present system.

As also described previously, FIG. 5 illustrates a single-effect system according to one embodiment of the present invention(s). However, other system arrangements (as opposed to the single-effect arrangement) are used according to various other embodiments, such as double-effect, triple-effect, and other multi-effect systems utilizing ammonia-water and other various types of working fluids and multi-component fluids (e.g., lithium bromide-water). Additional recuperative components configured in a similar manner to those shown in FIG. 5 would achieve multi-effect and other advanced heat pump thermodynamic cycle operation. Thus, for example, double-effect operation is achieved for applications with high temperature heat sources by including a second-effect desorber that generates additional refrigerant by recuperatively recovering heat from the vapor exiting desorber **1100** shown in the present embodiment before it flows through the rectifier **1150** and condenser **1200.** Additional examples include a combination of solution-cooled and hydronically-cooled absorbers instead of the solely hydronically-cooled absorber shown in the single-effect embodiment in FIG. 5. Further embodiments comprising other, similar recuperative heat exchange components would yield Generator Absorber Heat Exchange (GAX) heat pump configurations. As will be understood, in embodiments in which relatively high heat source input temperatures are used, greater heating or cooling effect is achieved (as compared to single-effect systems using the same input temperature) through the inclusion of additional recuperative heat exchange components or heat and mass transfer components.

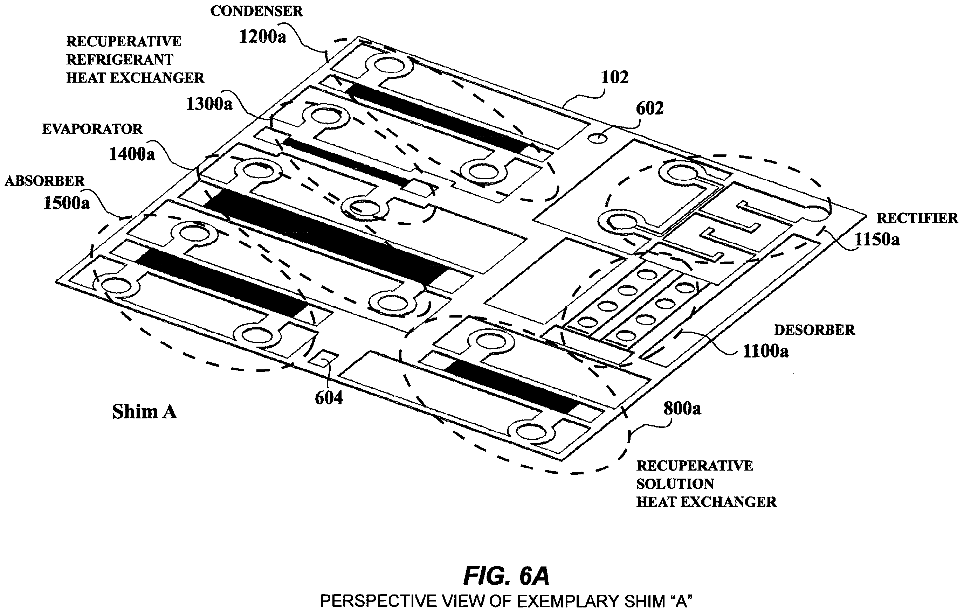

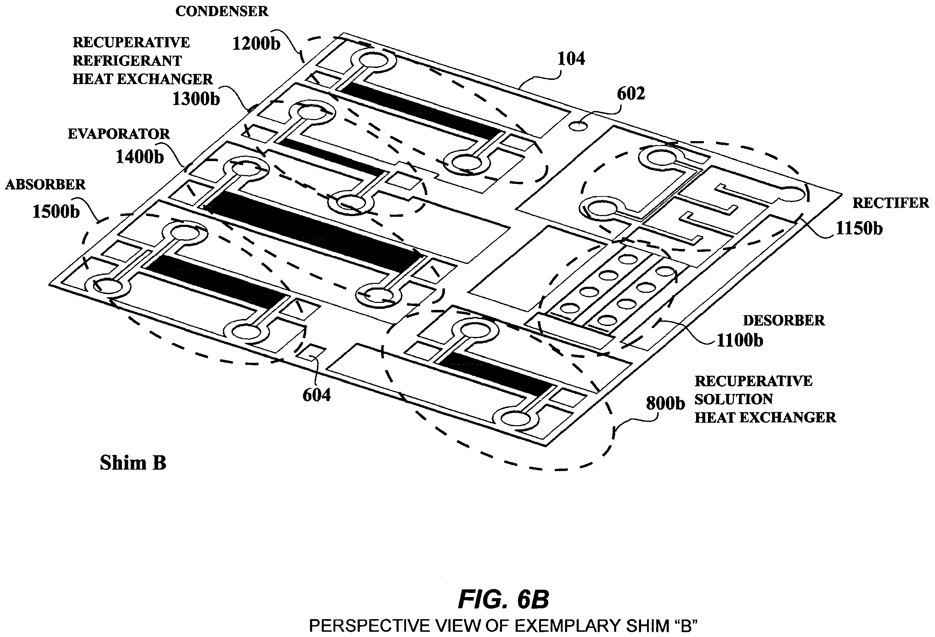

FIGS. 6A and 6B are perspective views illustrating exemplary representations of shim A **102** and shim B **104,** respectively, according to one embodiment of the present system. The shims **102, 104** illustrate the arrangement of heat and mass transfer system components to achieve the specific heat and mass transfer functions for an exemplary absorption heat pump as described herein. As described previously, according to one embodiment, shims A and B are combined to form a shim pair, wherein a plurality of shim pairs are further combined to form the shim group **108.** The number of shim pairs used to comprise shim group **108** is generally dependent upon the desired cooling or heating loads of each particular application. Further, as described in greater detail below, certain features (e.g., number and arrangement of microchannels, microscale passages, and other fluid connecting lines) of shims A **102** and B **104** are similar or identical, whereas others are different. This difference generally corresponds to the notion that one type of shims (e.g., shim A) convey working fluid throughout an embodiment of the apparatus **10,** whereas the other type of shims (e.g., shim B) convey coupling fluid throughout the apparatus (although this is not necessarily the case for each embodiment of the present system or each heat and mass transfer component within a particular embodiment). The specific fluid flows through the exemplary shims A and B are described in greater detail below.

Still referring to FIGS. 6A and 6B, the exemplary heat and mass transfer system components shown and discussed previously in conjunction with FIG. 5 are shown (or specifically, individual layers of the heat exchange components defined by shims A and B are shown) as they are arranged in exemplary shims **102, 104.** As shown, each discrete heat and mass transfer system component that makes up an exemplary absorption cooling and/or heating system is formed by and is a part of each shim **102, 104.** Specifically, individual layers of the recuperative solution heat exchanger **800,** desorber **1100,** rectifier **1150,** condenser **1200,** recuperative refrigerant heat exchanger **1300,** evaporator **1400,** and absorber **1500** for performing their individual functions described previously in conjunction with FIG. 5 (and elsewhere herein) are represented in each of shims A **102** and B **104,** respectively, in FIGS. 6A and 6B.

As described previously, for some heat and mass transfer components, the features (e.g., microchannel arrangement, etc.) of shim A **102** as compared to shim B **104** vary within each individual heat and mass transfer component. According to one embodiment, these differences enable the desired fluid flows and heat transfer functions between the working fluid and coupling fluids exchanging heat therein (e.g., one shim type carries working fluids, whereas the other shim type carries coupling fluids). These differences are shown and described in greater detail below and in subsequent figures. Specifically, the heat and mass transfer components that include internal shim differences to achieve necessary heat transfer functions are the recuperative solution heat exchanger **800a, 800b,** the condenser **1200a, 1200b,** the recuperative refrigerant heat exchanger **1300a, 1300b,** the evaporator **1400a, 1400b,** and the absorber **1500a, 1500b.**

Alternatively, the features within each of shims A and B for the desorber **1100** and rectifier **1150** are the same as compared to each other (e.g., the arrangement of microchannels and other microscale passages are similar). Based on the functions of these heat exchange components, arrangement of internal shim features, and the fluid flows within the shims, disparate arrangements of shim features are not necessary (in one embodiment) for these shim types. Accordingly, shims A **102** and B **104** are identical for the exemplary embodiment shown for the desorber **1100a, 1100b,** and rectifier **1150a, 1150b** portions of the shims.

Additionally, alignment notches **602** and **604** in each shim A **102** and B **104** provide holes in the shims to facilitate precise alignment, assembly, and joining of the plurality of shim pairs and cover plates **110, 111** as desired within each heat transfer apparatus. As shown, exemplary notches **602** and **604** have varying cross sections as compared to each other (i.e., notch **602** is circular-shaped, whereas notch **604** is square-shaped) to enable easy joining and alignment of the shims within the overall assembly (e.g., such that shims are not accidentally reversed during system assembly). As will be understood, depending on the particular embodiment, notches **602, 604** define virtually any cross-sectional shape, or, in some embodiments, are entirely unnecessary and thus not included.

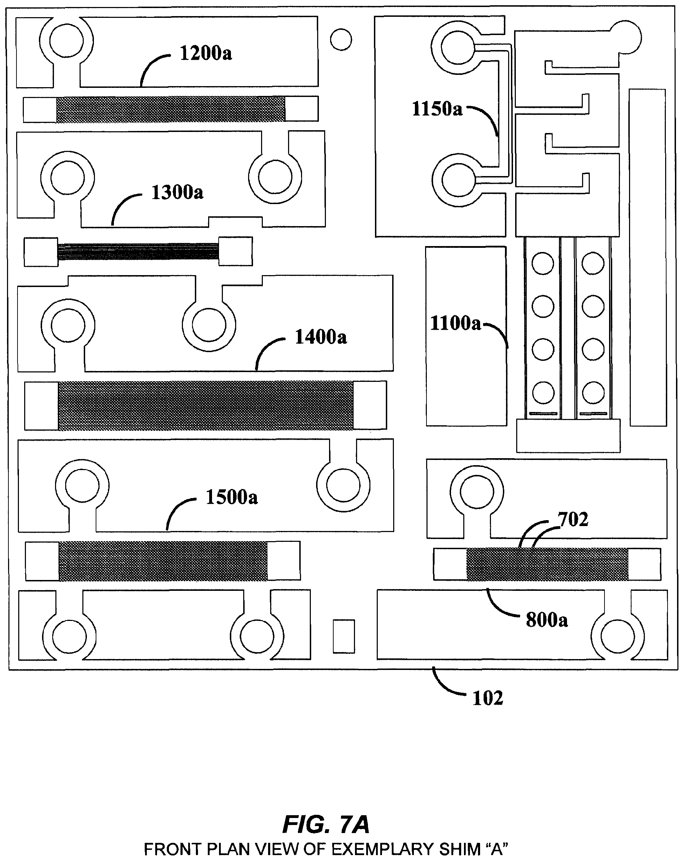

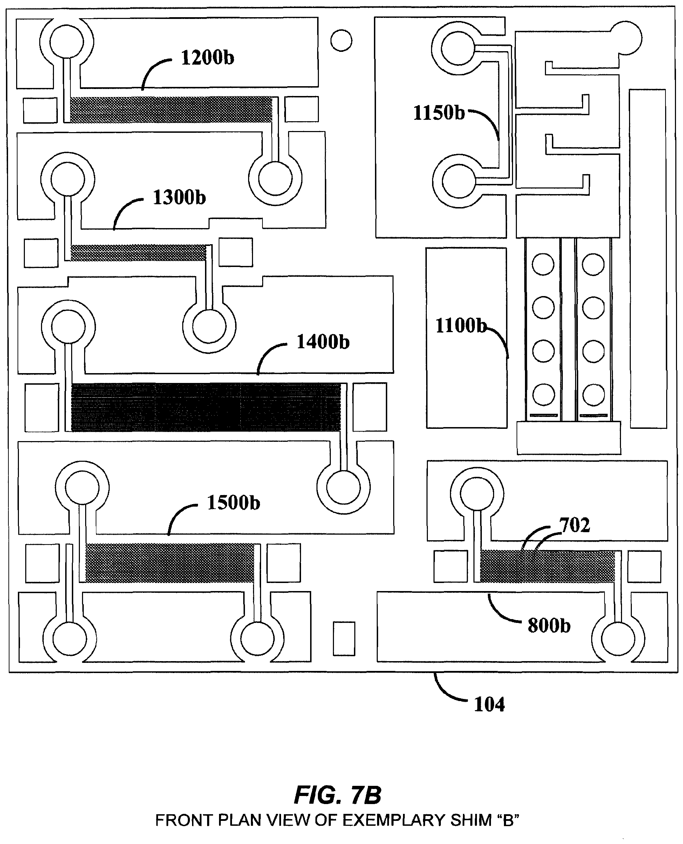

FIGS. 7A and 7B are front plan views illustrating exemplary representations of shim A **102** and shim B **104,** respectively, according to one embodiment of the present system. FIGS. 7A and 7B essentially illustrate front plan views of the layers of the heat and mass transfer system components defined by pluralities of shims A and B as shown and described previously in conjunction with FIGS. 6A and 6B. Accordingly, each of the heat and mass transfer system components in an exemplary microscale, absorption heat pump is shown; specifically, the recuperative solution heat exchanger **800a, 800b,** the desorber **1100a, 1100b,** the rectifier **1150a, 1150b,** the condenser **1200a, 1200b,** the recuperative refrigerant heat exchanger **1300a, 1300b,** the evaporator **1400a, 1400b,** and the absorber **1500a, 1500b.**

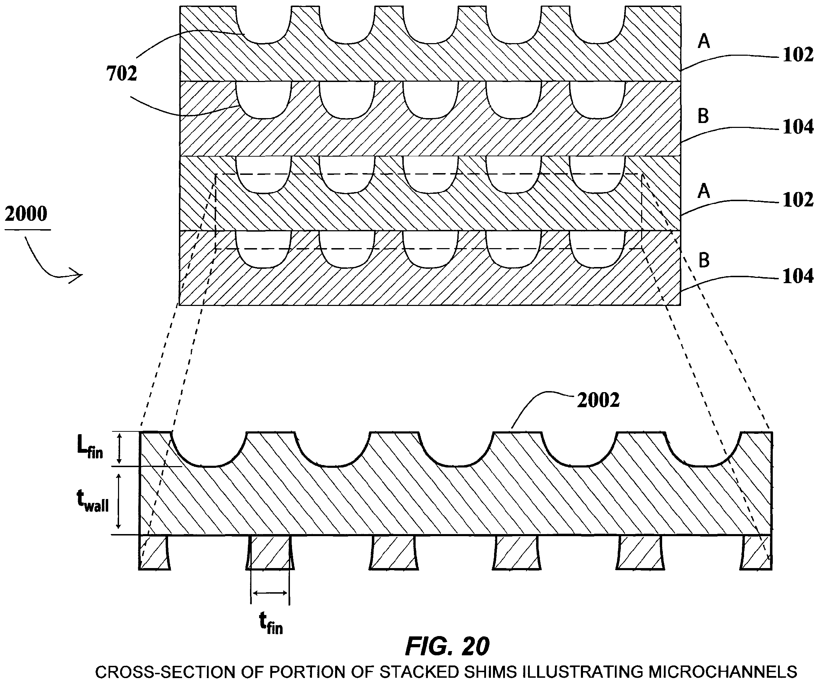

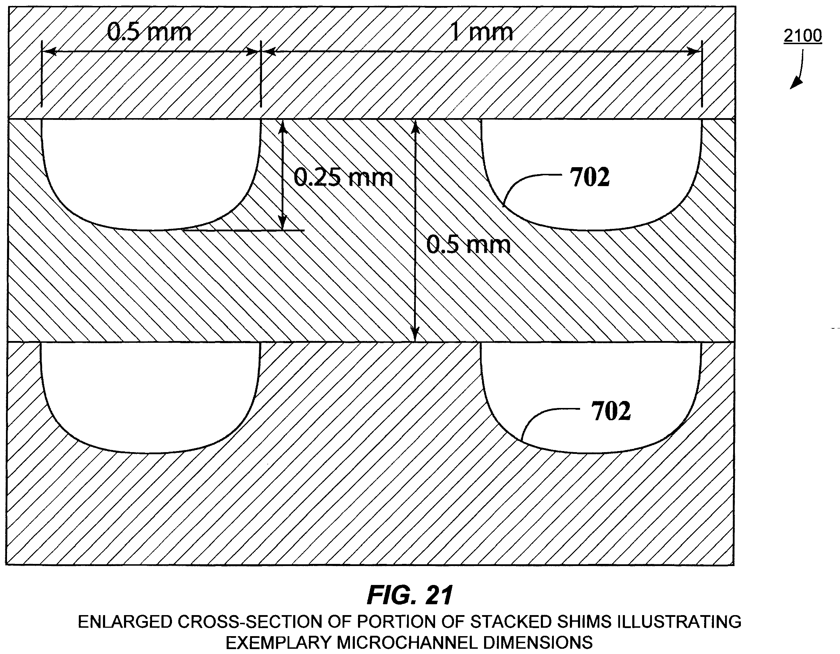

Also shown in FIGS. 7A and 7B are microchannels **702** that enable fluid flow and resulting heat transfer within individual heat and mass transfer components within the system. As will be understood and appreciated, these microchannels **702** comprise varying dimensions and are included in varying numbers according to various embodiments of the present apparatus. According to one exemplary embodiment described herein, these microchannels have dimensions comprising a channel etch depth of approximately half the shim thickness (e.g., 0.25 mm), a channel width of approximately 0.5 mm, and a nominal channel hydraulic diameter of approximately 306 µm. Again, however, these microchannel dimensions are provided for illustrative purposes only, and are not intended to limit the scope of the present invention(s) in any way. Representative dimensions and microchannel cross-sections are shown and described in greater detail below in conjunction with FIGS. 20 and 21 associated with an exemplary system embodiment.

As noted in the glossary, for example, even though an exemplary embodiment utilizes microchannels comprising hydraulic diameters of 306 µm, microchannel fluid flow and heat and mass transfer phenomena may be exploited in channels with hydraulic diameters ranging from 1 µm to about 1 mm (and greater). In fact, channels may exhibit fluid flow and heat transfer phenomena specific to microchannels at somewhat larger hydraulic diameters, even up to about 3 mm, depending upon the fluid properties and operating conditions, the corresponding vapor bubble formation phenomena and critical bubble diameters, and varying effects of surface tension, gravity, and inertial forces in these channels at different pressures and temperatures for different fluids and fluid mixtures.

Further, according to one embodiment, the microchannel sizes are the same (e.g., hydraulic diameter of 306 µm) throughout each heat and mass transfer system component in the system. In other embodiments, the microchannel dimensions vary on a percomponent basis (e.g., microchannels in the absorber **1500** may comprise different dimensions than those in the condenser **1200**). Additionally, in still other embodiments, microchannel dimensions may vary for shim A **102** as compared to shim B **104,** even within the same heat and mass transfer component. As will be understood and appreciated, various microchannel dimensions are used according to various system embodiments as needed.

Additionally, according to various embodiments, the microchannels are formed via photochemical etching, stamping, cutting, or other machining techniques. Further, the cross-sectional shapes of the microchannels in the shims comprise, depending on the embodiment, square, rectangular, semi-circular, semi-elliptical, triangular, or other singly-connected cross-sections to enable fluid flow in single-phase or two-phase state, as necessary, wherein the microchannel cross-section shape and dimensions are determined based on heat and mass transfer requirements, operating pressures, structural strength of the assembled apparatus, manufacturing constraints for dimensional tolerances and bonding of the shims and cover plates, and other similar application-specific factors.

### Discussion of Discrete, Exemplary Heat and Mass Transfer System Components

As described, embodiments of the present system generally comprise microscale heat or heat and mass transfer systems or heat-driven cycle apparatuses. More particularly, exemplary embodiments comprise monolithic, microscale absorption heating and/or cooling apparatuses including discrete but integrated heat and mass transfer system components, such as recuperative solution heat exchangers, desorbers, rectifiers, condensers, recuperative refrigerant heat exchangers, evaporators, absorbers, and other similar components. The particular architectures and functions of these discrete components and the operative connections between the components as represented by an exemplary embodiment (e.g., absorption heat pump) of the present system are described in greater detail below.

### Recuperative Solution Heat Exchanger

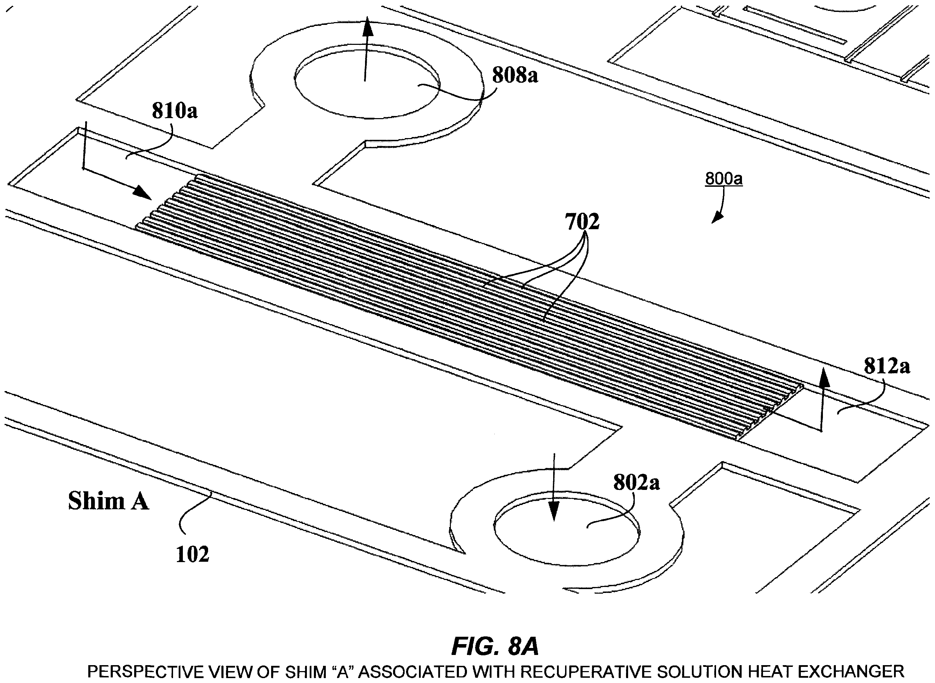

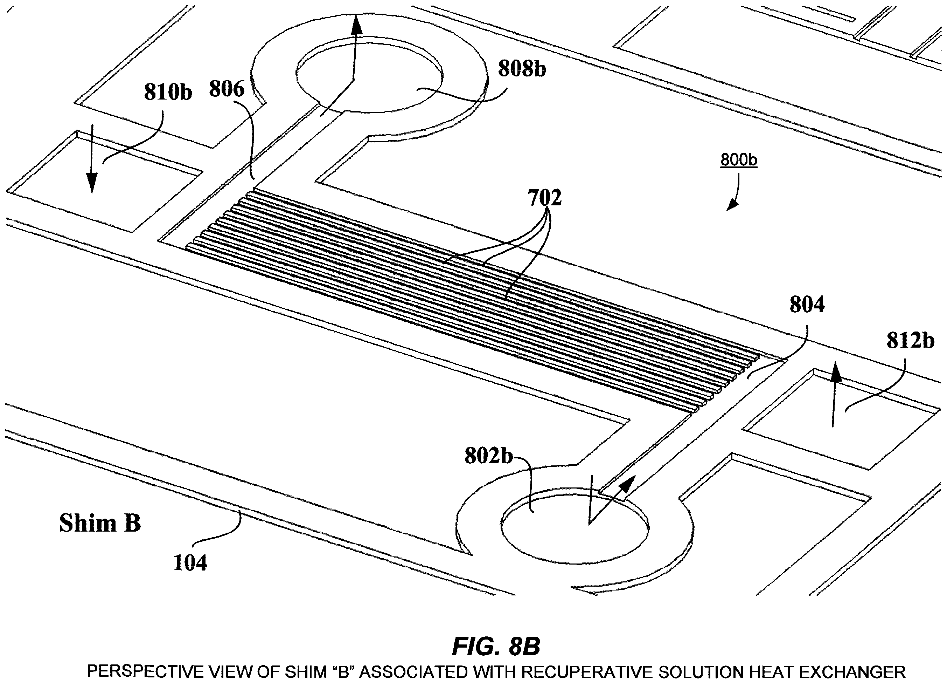

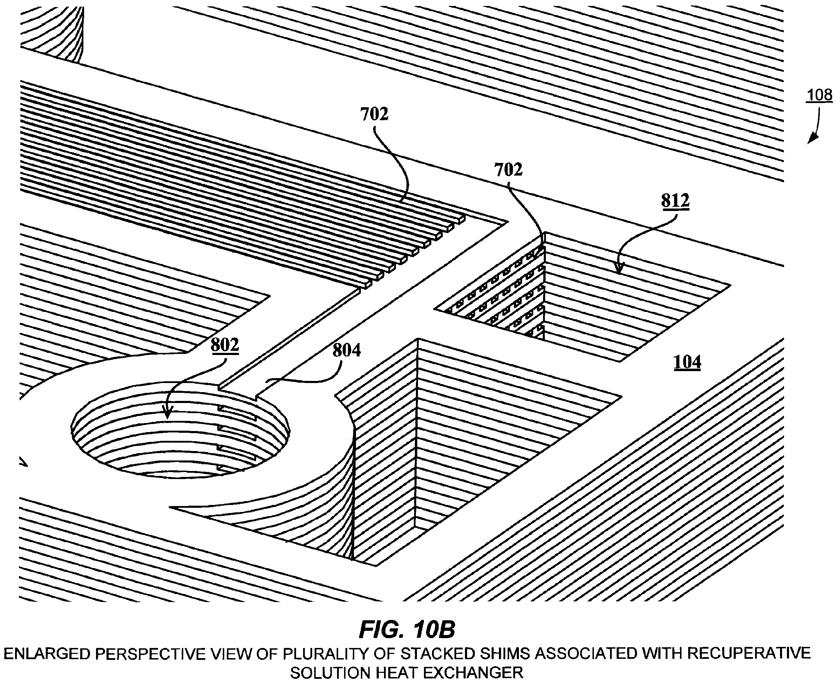

FIGS. 8A and 8B show perspective views of portions of shims A **102** and B **104,** respectively, associated with a recuperative solution heat exchanger **800** according to an embodiment of the present apparatus **10.** As shown, dilute ammonia-water solution enters the apparatus (and, specifically, the recuperative solution heat exchanger **800**) at an inlet header through void **802** (also referred to herein as a "stacked-up void") formed by a plurality of shim pairs combined together (shown and described in more detail in conjunction with FIGS. 10A and 10B). As described below, the void **802** (and other system voids) enables fluid flow in to or out of individual heat and mass transfer components or microchannels within the system, and also allows or restricts flow in to or out of particular shims.

The dilute ammonia-water solution enters the recuperative solution heat exchanger **800** via external tubing (not shown) from solution pump **502** (generally initiated from absorber **1500).** In the exemplary embodiment shown in FIG. 8A, in the plane of shim A **102,** the void **802a** comprises a blind hole that does not allow fluid flow across the shim. In the plane of shim B **104** shown in FIG. 8B, however, the void **802b** includes an entrance to fluid distribution passage **804,** which allows the dilute ammonia-water solution to be distributed into the plurality of microchannels **702,** which are in thermal contact with similar microchannels in shim A **102** (which are, in turn, carrying concentrated ammonia-water solution received from the desorber **1100** in an orientation counterflow to the dilute ammonia-water solution). Upon flowing through the plurality of microscale channels **702** in shim B, dilute solution exits through an exit passage **806,** similar in construction to distribution passage **804** at the inlet. Passage **806** conveys the dilute solution to the voids **808a, 808b** formed by the assembly of stacked shims A **102** and B **104,** wherein this void serves as the exit header for the dilute solution (wherein the dilute solution is subsequently conveyed to the solution expansion valve **512.**

Still referring to FIGS. 8A and 8B, concentrated ammonia-water solution enters the recuperative solution heat exchanger **800** through the stacked assembly of alternating voids **810a** and **810b** in shims A **102** and B **104,** respectively. According to the embodiment shown, and in an arrangement complementary to the voids **802a, 802b** receiving dilute solution, void **810b** on shim B comprises a blind hole that does not allow fluid flow across the shim. The corresponding void **810a** on shim A, however, allows distributed concentrated solution flow from void **810a** into microscale passages **702.** Upon exiting the microscale passages **702,** concentrated solution enters void **812a,** and exits the solution heat exchanger through an exit header formed by alternating stacked voids **812a, 812b,** where it is subsequently conveyed to the desorber **1100.**

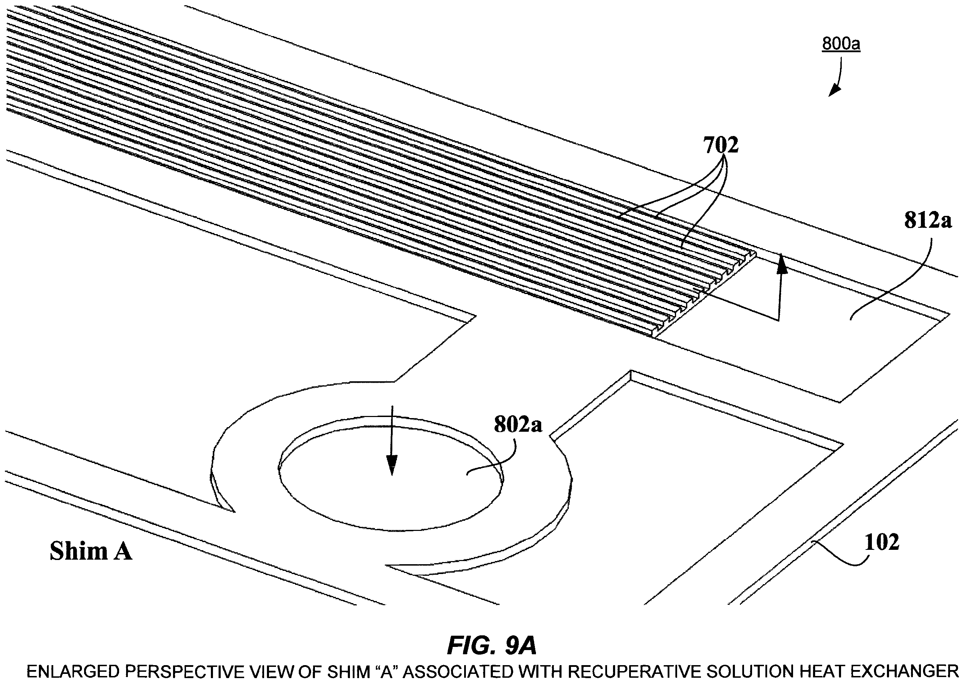

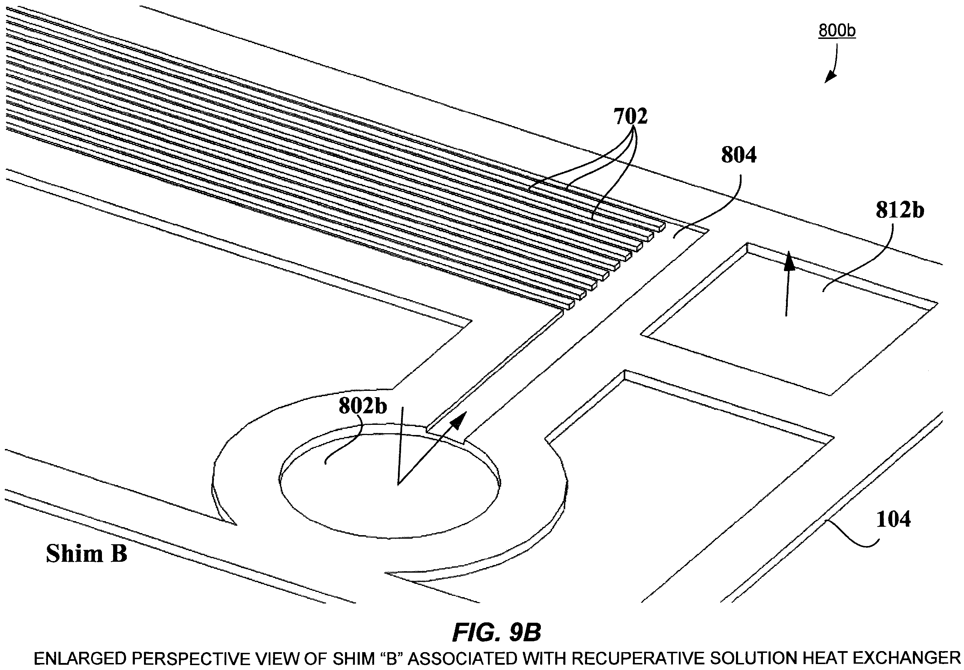

FIGS. 9A and 9B are enlarged perspective views of portions of shims A **102** and B **104,** respectively, associated with a recuperative solution heat exchanger **800** according to an embodiment of the present apparatus **10** (i.e., these figures are enlarged views of FIGS. 8A and 8B). FIGS. 9A and 9B illustrate in more detail the arrangement of inlet voids **802a** and **802b** on shims A and B, respectively, for the dilute solution, as well as fluid passage **804** for carrying dilute solution from the void **802b** to the plurality of microscale channels **702** in shim B. Also shown are the corresponding plurality of microscale channels **702** in shim A for carrying concentrated (ammonia-water) solution, and exit voids **812a** and **812b** for transferring concentrated solution out of the recuperative solution heat exchanger **800.**

As shown in FIG. 9B, distribution passage **804** includes a rectangular, uniform cross-section. In other embodiments, however, if necessary to ensure uniform flow distribution through the microchannels **702** in shim B **104,** this cross-section is tapered in the direction of fluid flow to better manage the fluid pressure drops in distribution passage **804,** as well as in the microchannels **702,** which leads to improved flow distribution. According to various embodiments, the cross-sections of the microchannels **702** in shims A **102** and B **104,** respectively, are square, rectangular, semi-circular, semi-elliptical, triangular, or comprise other similar singly-connected shapes based on the desired flow rates and heat transfer rates for each specific application. Further, the cross-sections of the microchannels **702** on shims A and B are not necessarily the same; different microscale passage geometries can be adopted for the two sets of passages (on shims A and B, respectively) to accommodate different flow rates and thermal capacities of the dilute and concentrated solution streams flowing therein, resulting in better matching of thermal resistances.

According to various embodiments of the present system, voids **802a, 802b, 812a, 812b,** and other voids associated with the recuperative solution heat exchanger **800,** as well as other heat and mass transfer system components of the apparatus described herein, comprise varying cross-sections as desired or necessitated by the particular embodiment. For example, voids **812** comprise a square cross-section, whereas voids **802** comprise a circular cross-section for the embodiment shown in FIGS. 9A and 9B. Other shapes are utilized according to other embodiments, however, such as rectangular shapes, and other similar cross-sections. In one embodiment, D-shaped voids are used, such that the straight line portion of the "D" is aligned along the entrance to the microchannels to reduce pressure resistance (but simultaneously ensure that the microchannels have identical flow lengths).

As briefly discussed previously, FIGS. 10A and 10B illustrate enlarged, perspective views of portions of a plurality of stacked shims A **102** and B **104** associated with a recuperative solution heat exchanger **800** according to an embodiment of the present apparatus **10.** As shown, the top shim in FIG. 10A is a representative shim A **102,** whereas the top shim in FIG. 10B is a representative shim B **104.** The plurality of stacked shims shown in FIGS. 10A and 10B illustrate in more detail the operative connections between voids **802** and distribution passages **804,** as well as voids **812** and microchannels **702.** As described previously, the geometries of passages **804** on shim B enable solution to pass into shim B from void **802.** Additionally, microchannels **702** on shim A enable solution to pass from the microchannels to void **812.** As also shown, because shims A do not include distribution passages **804,** solution is restricted from flowing into shims A from void **802.** Further, because shims B do not include microchannel connections to void **812,** solution is restricted from passing in to or out of this void **812** from shim B. As will be understood and appreciated, other similar passages, voids, and microchannel arrangements are utilized in other heat and mass transfer components within embodiments of the present system, as described in greater detail below.

### Desorber /Rectifier

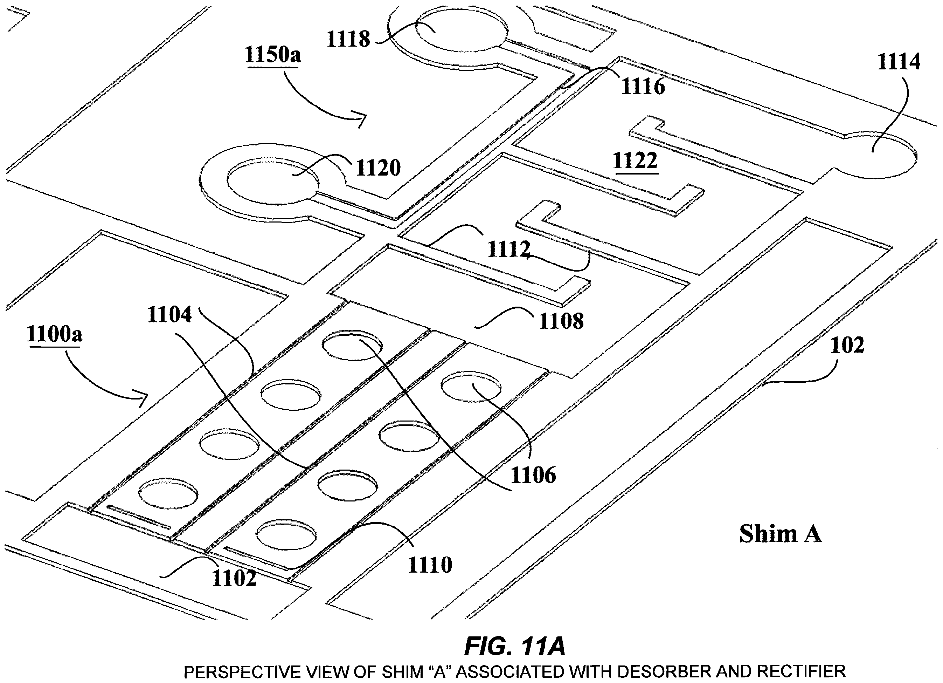

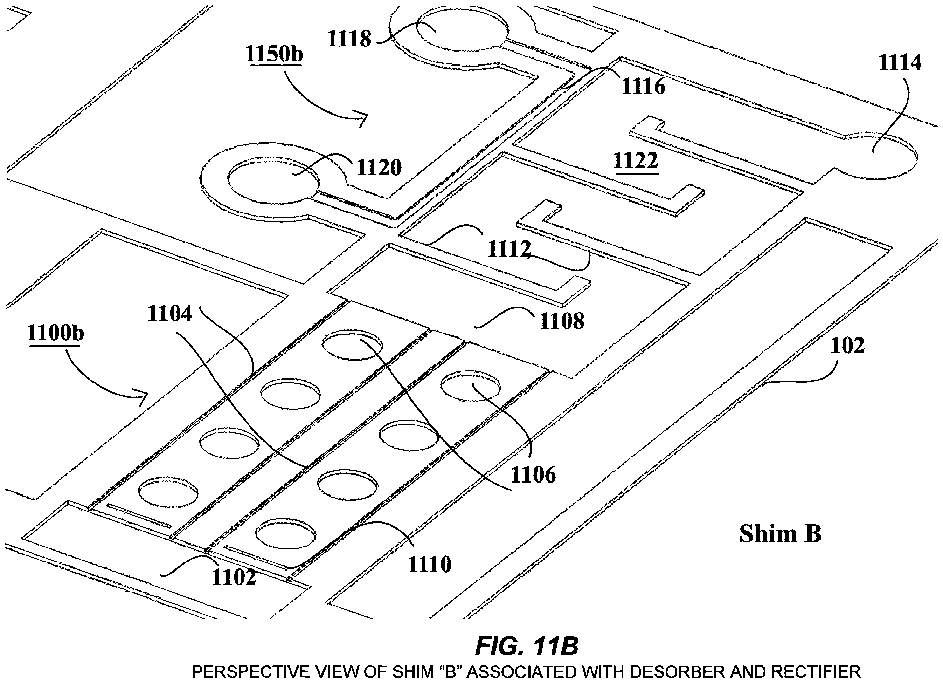

FIGS. 11A and 11B illustrate perspective views of portions of shims A **102** and B **104,** respectively, associated with a desorber **1100** and rectifier **1150,** according to an embodiment of the present apparatus **10.** As described previously, the features, arrangement of passages, etc., for the desorber **1100** are the same for shim A as compared to shim B. Similarly, the features, arrangement of passages, etc., for the rectifier **1150** are the same for shim A as compared to shim B. Thus, the representations of the embodiments shown in FIGS. 11A and 11B are identical. As will be understood and appreciated, however, alternate embodiments of the present system utilize alternating or counterflow microscale passages (similarly to other heat and mass transfer components herein described), such that the arrangement of microscale features in shims A and B need not be the same.

Referring to the embodiment of the desorber **1100** shown in FIGS. 11A and 11B, concentrated ammonia-water solution enters the desorber from the recuperative solution heat exchanger **800** via inlet headers **1102** formed by the stacked-up voids defined by the plurality of shim pairs A and B. The concentrated solution then enters a plurality of passages **1104** on shims A and B, and as the solution flows through these passages, is heated by an external heat source (via voids **1106**), therefore producing ammonia-water refrigerant vapor and dilute ammonia-water solution. As shown, the external heat source is provided to the concentrated solution through a plurality of voids **1106** in shims A and B, respectively. According to various embodiments, heat from the heat source is provided through voids **1106** by a hot gas stream, e.g., a flue gas stream, condensing steam, or other high pressure condensing fluid, or externally-heated solid conductive heaters, or a heat transfer coupling fluid coupled to an external heat source, or by other similar techniques. The crossflow orientation between the concentrated ammonia-water solution in passages **1104** and the external heat source in voids **1106** shown in the embodiment in FIGS. 11A and 11B is but one possible configuration for this flow. For example, in alternate embodiments, counterflow orientation between the ammonia-water solution and the external heat source is provided by orienting the voids **1106** in shims A and B in parallel with the corresponding solution passages **1104,** as opposed to the perpendicular orientation to the shims, as shown in FIGS. 11A and 11B.

Slot voids **1110** in shims A and B near the inlet headers **1102** provide thermal isolation between the recuperative solution heat exchanger component **800** and the desorber heat source voids **1106,** so that the external heat is maximally applied to the concentrated solution. According to other embodiments and aspects, similar voids are used in various locations throughout the present system to effect thermal separation between heat exchange components that should be maintained at hot and cold temperatures. The dilute ammonia-water solution and ammonia-water vapor mixture exiting the desorber passages **1104** collect in the desorber outlet headers **1108** formed by the stacked-up voids defined by the plurality of shim pairs A and B, and subsequently flow into the rectifier **1150.**

Generally, the ammonia-water vapor from the desorber outlet headers **1108** flows into the rectifier vapor space **1122** formed by rectifier trays **1112** on shims A and B. As the vapor proceeds along the rectifier **1150,** cooling by a coupling fluid flowing in counterflow orientation to the ammonia-water vapor through passages **1116** along the side walls of the vapor space chamber **1122** effects rectification of the vapor. Depending on the particular embodiment, this coupling fluid comprises medium temperature coupling fluid or concentrated ammonia-water solution exiting the solution pump **502** (described previously). The coupling fluid enters the assembly **10** at inlet headers formed by stacked-up voids **1118** in shims A and B, and exits from outlet headers formed by stacked-up voids **1120** in shims A and B. During the rectification process, reflux liquid (i.e., dilute ammonia-water solution) collects in trays **1112** and flows back into the desorber exit headers **1108** where it mixes with the dilute ammonia-water solution therein before exiting the desorber. According to one embodiment, the dilute ammonia-water solution exits the desorber exit headers **1108** via a hole in a cover plate (not shown). Rectified, high concentration ammonia-water vapor exits the rectifier vapor space **1122** through vapor outlet headers formed by stacked-up voids **1114** in shims A and B, and is subsequently transferred to the condenser **1200.**

According to one embodiment, coupling fluid flowing between stacked-up voids **1118** and **1120** via passage **1116** in shims A and B is in forced-convective flow. On the other hand, as the ammonia-water vapor passes through the rectifier **1150** and is rectified, reflux liquid flows back down the rectifier and collects at exit header **1108.** This counterflow of vapor and reflux liquid within the rectifier **1150** comprises a gravity/buoyancy-driven flow (unlike the forced-convective flow on the coupling fluid side) that further enhances the rectification of the vapor from the dilute ammonia-water solution. The varying geometries possible due to the shim, passage, and microchannel geometries incorporated into various embodiments of the present system enable the combination of co- and counterflow forced-convective and gravity/buoyancy-driven flows for different fluid streams, as desired, in the various heat and mass transfer system components, such as the rectifier **1150** and desorber **1100,** in embodiments of the heat or heat and mass transfer system. As will be understood and appreciated, for this flow to occur, the overall system **10** should be oriented such that the rectifier **1150** is aligned vertically above the desorber **1100.** Thus, for example, when in use, the embodiment of the system herein described should be oriented similarly to that shown in FIGS. 1, 2, etc., and not in a relatively flat arrangement (as shown in FIGS. 4A-4D, etc.).

### Condenser

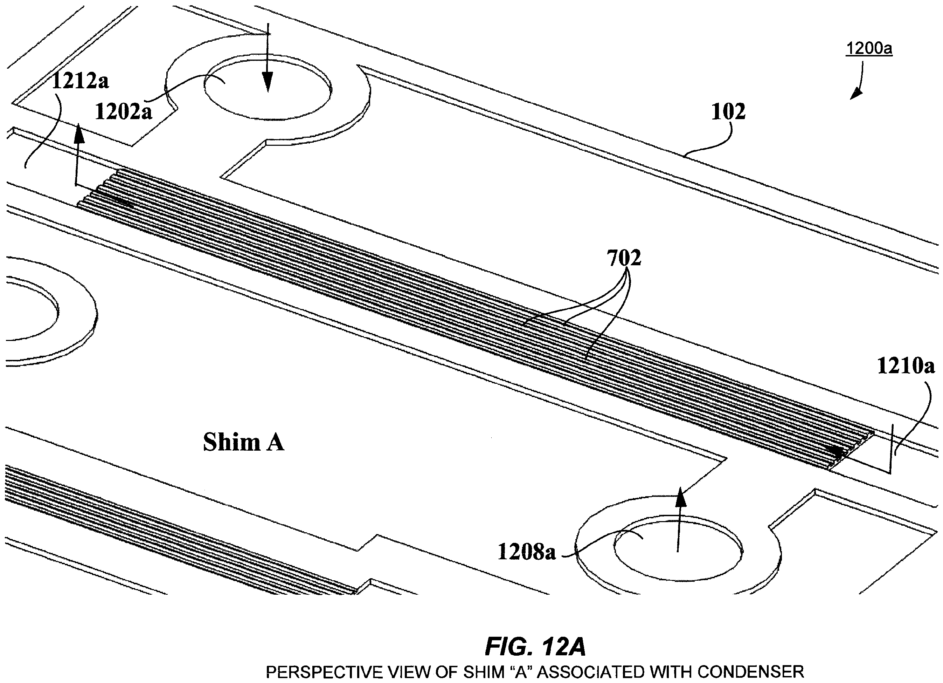

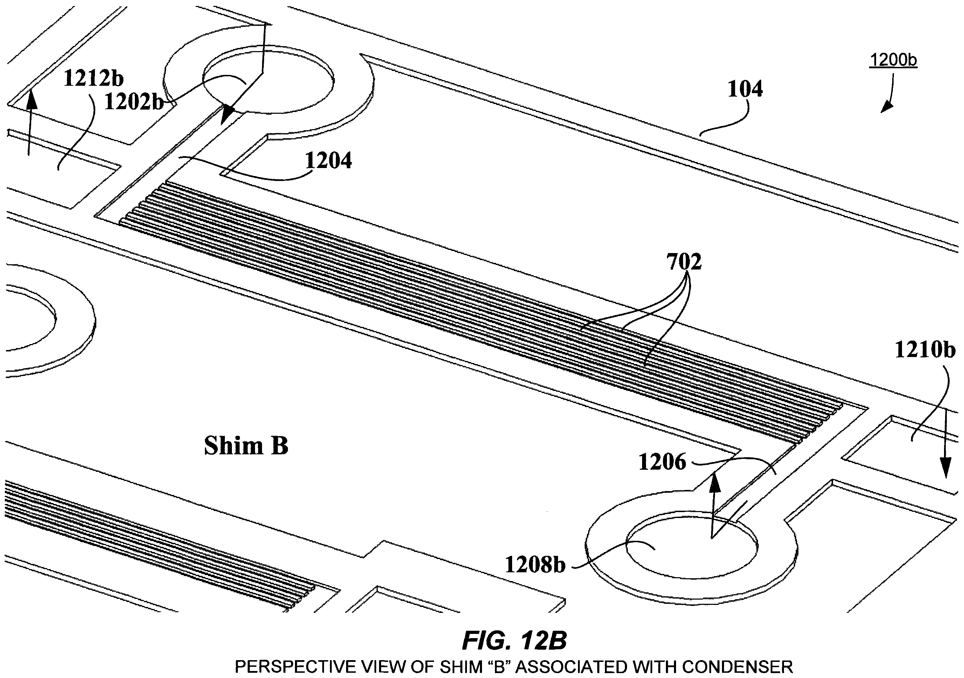

FIGS. 12A and 12B illustrate perspective views of portions of shims A **102** and B **104,** respectively, associated with a condenser **1200** according to an embodiment of the present apparatus **10.** The architecture and geometry of the condenser is relatively similar to that of the recuperative solution heat exchanger **800** discussed previously in conjunction with FIGS. 8A and 8B. In the embodiment shown, medium-temperature coupling fluid enters the condenser **1200** through inlet headers formed by stacked-up voids **1202a, 1202b** in shims A and B, respectively. Void **1202b** in shim B leads to passage **1204** that enables distributed flow of coupling fluid into the plurality of microchannels **702** on shim B. As the coupling fluid passes through these microchannels **702,** it is heated by the working fluid passing through microchannels in shim A. The heated coupling fluid then flows to exit passage **1206** on shim B, which in turn leads to exit headers formed by stacked-up voids **1208a, 1208b** on shims A and B, respectively, and is returned to the medium temperature hydronic fluid line (e.g., coupled to the ambient).

As shown, ammonia-water vapor from the rectifier **1150** enters the condenser component **1200** through inlet headers formed by the stacked-up voids **1210a, 1210b** in shims A **102** and B **104,** respectively. Void **1210a** in shim A leads to a plurality of microchannels **702,** which enable flow of condensing vapor in counterflow orientation to, and in thermal contact with, the coupling fluid flowing through similar microchannels **702** on shim B. The condensed and subcooled refrigerant liquid exits microscale channels **702** in shim A and flows into outlet headers formed by the stacked-up voids **1212a, 1212b** in shims A and B, respectively. Variations, options, and other details associated with microchannel geometries, coupling fluid inlet and outlet passages **1204, 1206,** and voids for the condenser **1200,** including shapes, cross-sections, and dimensions, apply equally and are similar to those described previously in conjunction with the recuperative solution heat exchanger **800.**

### Recuperative Refrigerant Heat Exchanger

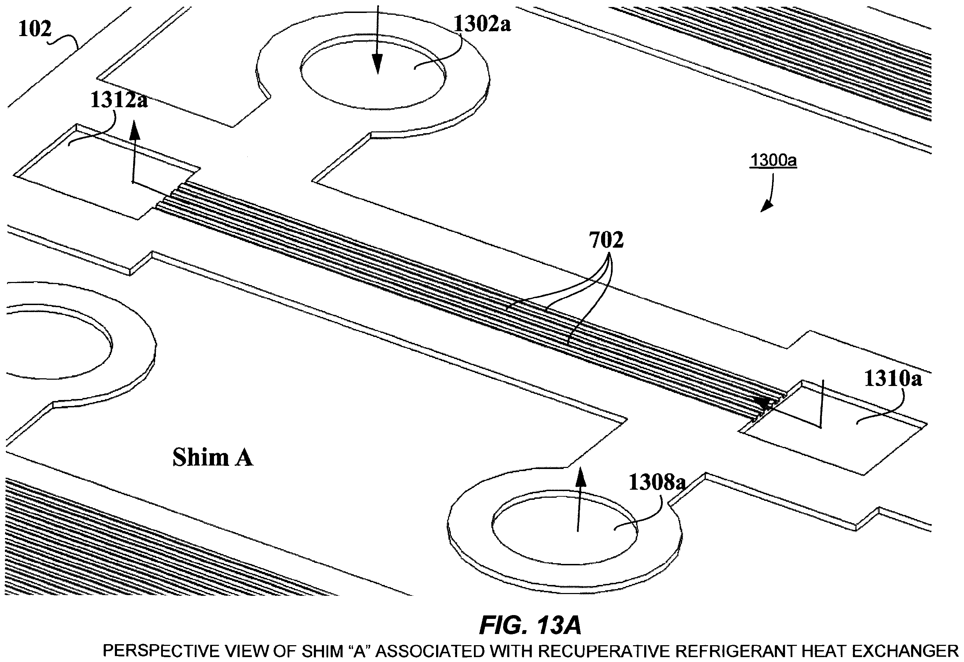

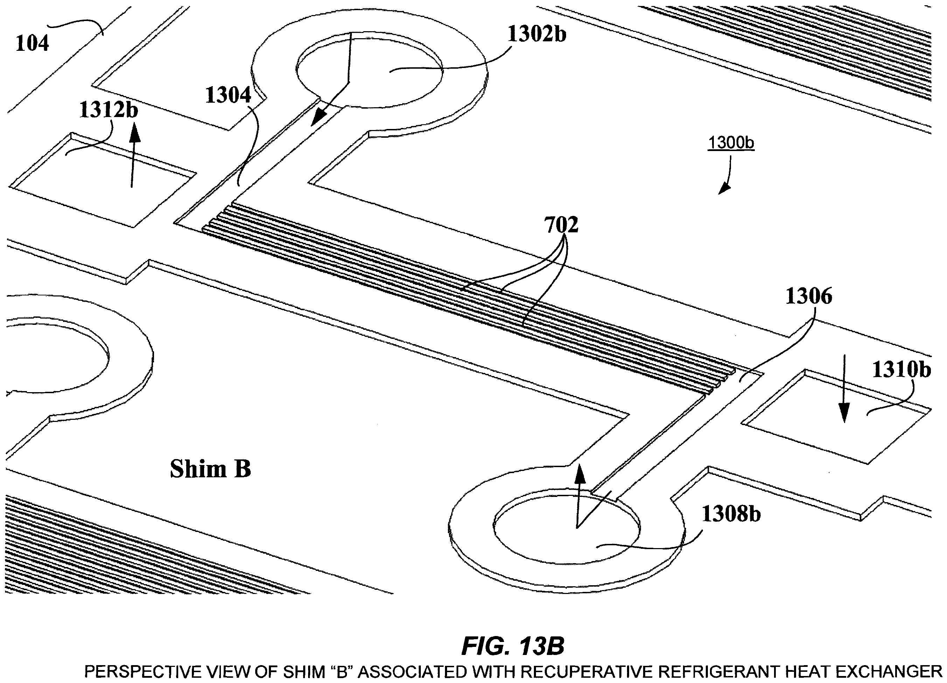

FIGS. 13A and 13B illustrate perspective views of portions of shims A **102** and B **104,** respectively, associated with a recuperative refrigerant heat exchanger **1300** according to an embodiment of the present apparatus **10.** The architecture and geometry of the recuperative refrigerant heat exchanger is relatively similar to that of the recuperative solution heat exchanger **800** discussed previously in conjunction with FIGS. 8A and 8B. In the embodiment shown, high-pressure liquid refrigerant (i.e., ammonia) from the condenser **1200** enters the recuperative refrigerant heat exchanger through inlet headers formed by the stacked-up voids **1302a, 1302b** in shims A and B, respectively. As shown, void **1302b** in shim B leads to passage **1304** that enables distributed flow of liquid refrigerant into the plurality of microchannels **702** on shim B. As the liquid refrigerant flows through the microchannels on shim B, the liquid refrigerant is cooled by low-pressure refrigerant vapor simultaneously flowing through microchannels **702** in shim A. Subsequently, the cooled refrigerant fluid flows to exit passage **1306** on shim B, which in turn leads to exit headers formed by stacked-up voids **1308a, 1308b** on shims A and B, respectively.

Low-pressure vapor from the evaporator **1400** enters the recuperative refrigerant heat exchanger **1300** through inlet headers formed by the stacked-up voids **1310a, 1310b** in shims A **102** and B **104,** respectively. Void **1310a** in shim A leads to a plurality of microscale passages **702,** which enable flow of low-pressure refrigerant vapor as coolant for, in counterflow orientation to, and in thermal contact with, high-pressure refrigerant liquid flowing through similar microscale passages **702** on shim B. The refrigerant vapor exits microscale passages **702** and flows into outlet headers formed by the stacked-up voids **1312a, 1312b** in shims A and B, respectively. Variations, options, and other details associated with microchannel geometries, high-pressure refrigerant liquid inlet and outlet passages **1304, 1306,** and voids for the recuperative refrigerant heat exchanger **1300,** including shapes, cross-sections, and dimensions, apply equally and are similar to those described previously in conjunction with the recuperative solution heat exchanger **800.**

### Evaporator

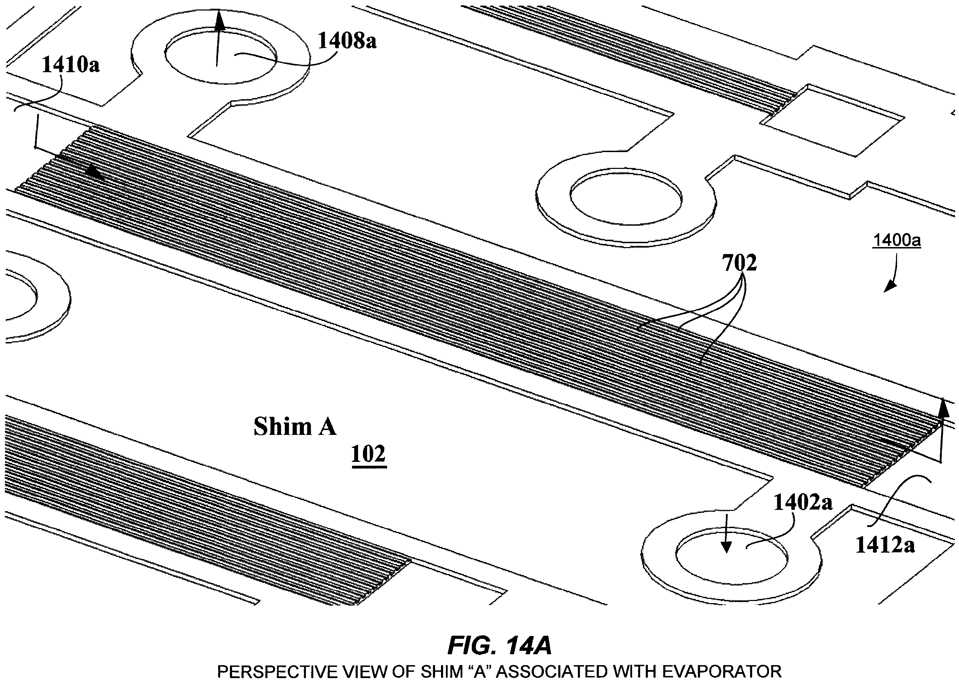

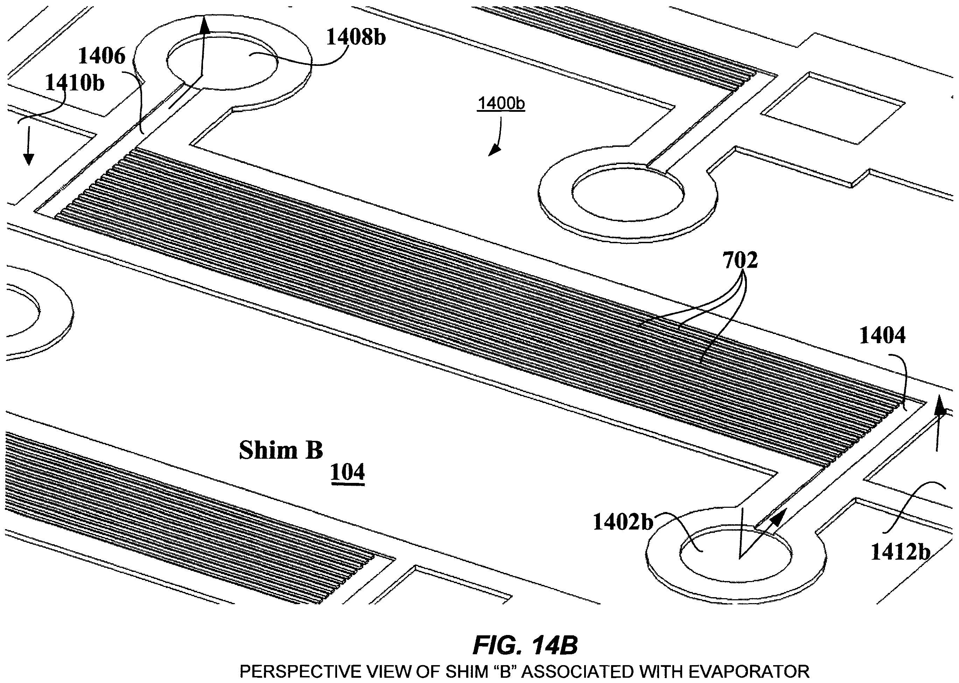

FIGS. 14A and 14B illustrate perspective views of portions of shims A **102** and B **104,** respectively, associated with an evaporator **1400** according to an embodiment of the present apparatus **10.** The architecture and geometry of the evaporator is relatively similar to that of the condenser **1200** discussed previously in conjunction with FIGS. 12A and 12B. In the embodiment shown, low-temperature coupling fluid enters the evaporator through inlet headers formed by voids **1402a, 1402b** in shims A and B, respectively. Void **1402b** in shim B leads to passage **1404** that enables distributed flow of coupling fluid into the plurality of microchannels **702** on shim B. As the coupling fluid flows through the microchannels on shim B, it is cooled by the ammonia-water two-phase mixture (from the recuperative refrigerant heat exchanger **1300** via the expansion valve **534**) flowing through microchannels **702** in shim A. The cooled coupling fluid then flows to the exit passage **1406** on shim B, which in turn leads to exit headers formed by voids **1408a, 108b** on shims A and B, respectively, and is subsequently used for cooling a conditioned space, or other similar application.

As shown, ammonia-water two-phase mixture from fluid line **536** (see FIG. 5 and associated discussion) leaving the expansion valve **534** enters the evaporator component **1400** through inlet headers formed by voids **1410a, 1410b** in shims A and B, respectively. Void **1410a** in shim A leads to a plurality of microchannels **702,** which enable flow of evaporating vapor in counterflow orientation to, and in thermal contact with, the coupling fluid flowing through similar microchannels **702** on shim B. The evaporated refrigerant vapor exits the microchannels in shim A and flows into outlet headers formed by voids **1412a, 1412b** in shims A and B, respectively. Variations, options, and other details associated with microchannel geometries, coupling fluid inlet and outlet passages **1404, 1406,** and voids for the evaporator **1400,** including shapes, cross-sections, and dimensions, apply equally and are similar to those described previously in conjunction with the recuperative solution heat exchanger **800.**

### Absorber

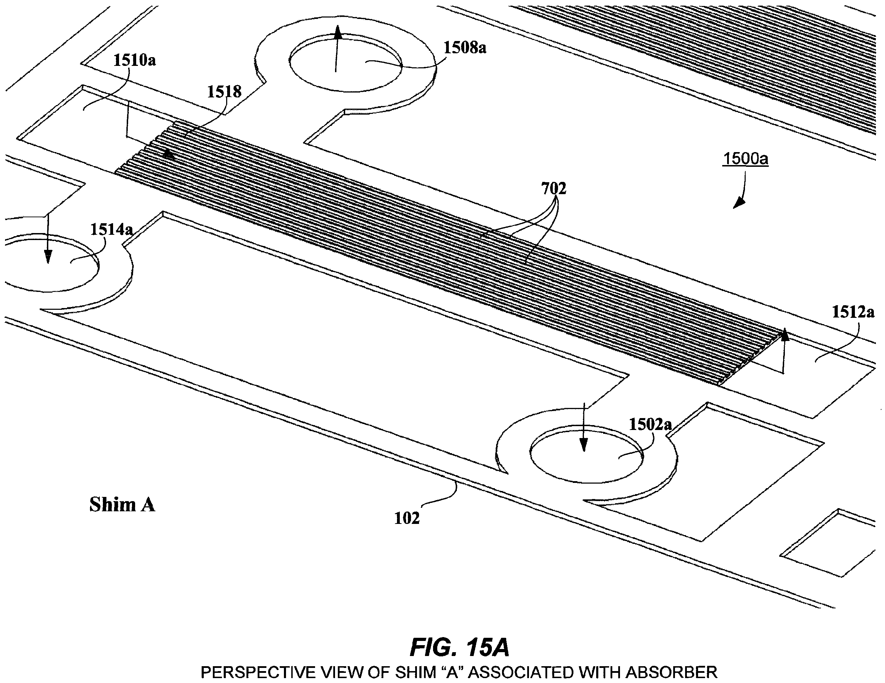

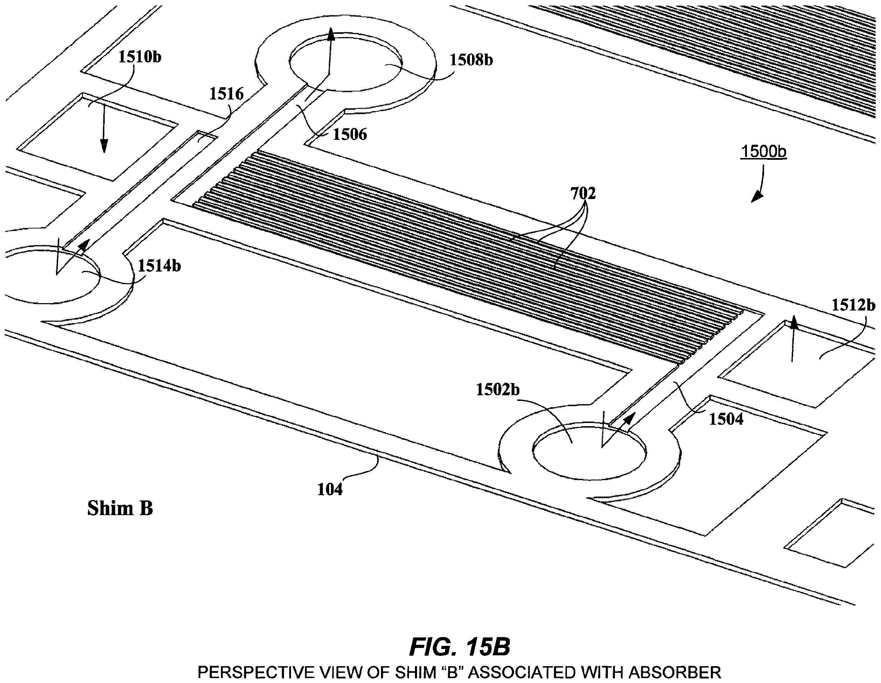

FIGS. 15A and 15B illustrate perspective views of portions of shims A **102** and B **104,** respectively, associated with an absorber **1500** according to an embodiment of the present apparatus **10.** In the embodiment shown, medium-temperature coupling fluid enters the absorber **1500** through inlet headers formed by voids **1502a, 1502b** in shims A and B, respectively. As shown, void **1502b** in shim B leads to passage **1504** that enables distributed flow of coupling fluid into the plurality of microchannels **702** on shim B. The coupling fluid is heated via thermal contact with dilute ammonia-water solution and refrigerant vapor flowing through microchannels **702** on shim A. The heated coupling fluid then flows to the exit passage **1506** on shim B, which in turn leads to exit headers formed by voids **1508a, 1508b** on shims A and B, respectively.

In the embodiment shown, dilute ammonia-water solution from fluid line **514** (see FIG. 5 and associated discussion) leaving the solution expansion valve **512** enters the absorber component **1500** through inlet headers formed by voids **1510a, 1510b** in shims A and B, respectively. Void **1510a** in shim A leads to a plurality of microchannels **702,** which enable flow of dilute solution and refrigerant vapor (the mixture of which is described below) in counterflow orientation to, and in thermal contact with, the coupling fluid flowing through similar microchannels **702** on shim B. The medium temperature coupling fluid removes heat of absorption from the dilute solution and refrigerant vapor mixture, thereby forming concentrated ammonia-water solution in the microchannels in shim A. The concentrated ammonia-water solution exits microchannels **702** and flows into outlet headers formed by voids **1512a, 1512b** in shims A and B, respectively.

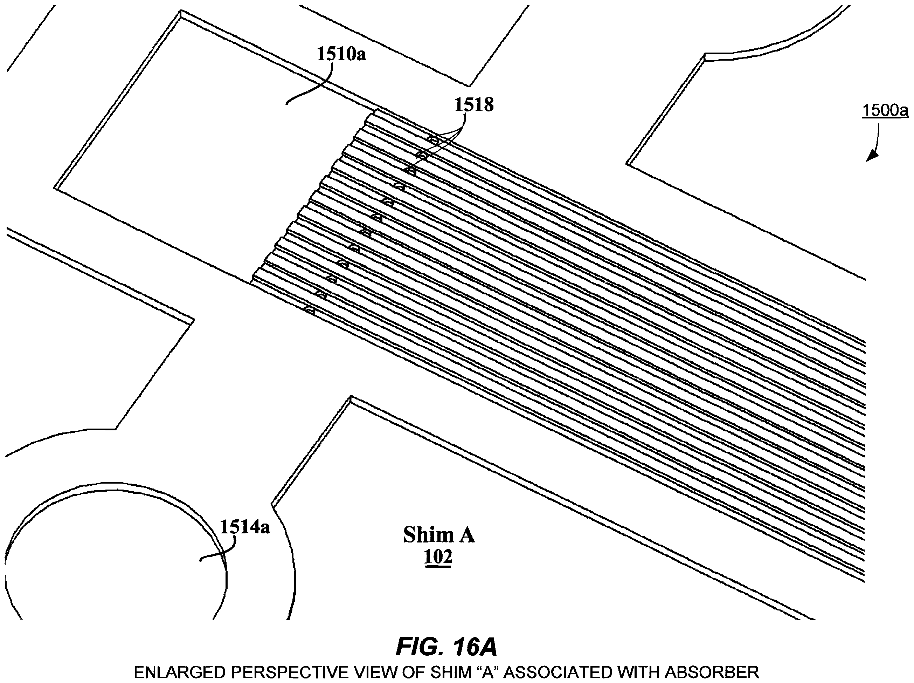

According to one embodiment, ammonia-water vapor from fluid line **516** (see FIG. 5 and associated discussion) leaving the recuperative refrigerant heat exchanger **1300** enters the absorber **1500** through inlet headers formed by voids **1514a, 1514b** in shims A and B, respectively. Void **1514b** in shim B leads to passage **1516** that supplies the ammonia-water vapor stream to microchannels **702** in shim A through vapor inlet holes **1518** in shim A. The location of inlet holes **1518** is indicated in FIG. 15A, and is shown in greater detail in FIG. 16A.

According to the embodiment shown, microchannels **702** on shim A extend in length further toward inlet header **1510a** than do microchannels **702** on shim B for purposes of enabling entry of incoming ammonia-water vapor into the microchannels on shim A through vapor inlet holes **1518.** The mixed two-phase flow of dilute ammonia-water solution entering microchannels **702** on shim A through header **1510a** and the ammonia-water vapor entering these same microchannels through inlet holes **1518,** upon absorption, exits the microchannels as concentrated solution into outlet headers formed by voids **1512a, 1512b** in shims A and B, respectively. As will be understood, the vapor enters microchannels **702** via inlet holes **1518** based on forced convective flow, which also prevents the dilute solution from flowing into inlet holes **1518.** Variations, options, and other details associated with microchannel geometries, coupling fluid inlet and outlet passages **1504, 1506, 1516,** and voids for the absorber **1500,** including shapes, cross-sections, and dimensions, apply equally and are similar to those described previously in conjunction with the recuperative solution heat exchanger **800.**

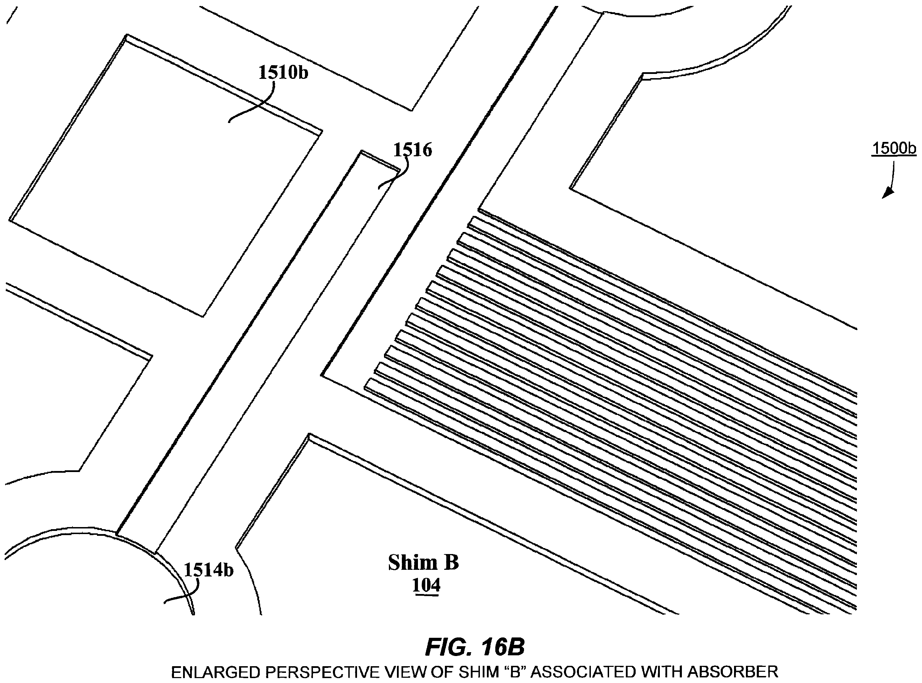

FIGS. 16A and 16B are enlarged perspective views of portions of shims A **102** and B **104,** respectively, associated with an absorber **1500** according to an embodiment of the present apparatus **10.** Specifically, FIGS. 16A and 16B illustrate one embodiment of the locations of vapor inlet holes **1518** in microchannels **702** in shim A **102.** As shown, the inlet holes **1518** in shim A map to passage **1516** in shim B to enable vapor flowing from passage **1516** to flow into microchannels **702** in shim A and mix with dilute ammonia-water solution in the microchannels. As will be understood and appreciated, vapor inlet holes **1518** comprise various cross-sectional shapes, areas, arrangements, etc., according to various embodiments of the present system.

### Alternate Embodiment Comprising Modular Components

FIG. 17 illustrates a modular embodiment, which does not form part of the present invention, comprising discrete heat and mass transfer components associated with an exemplary absorption cooling and/or heating system. The discrete heat and mass transfer components shown in FIG. 17 define an exemplary absorption heat pump in discrete component-by-component assemblies, which facilitates modular and versatile assembly of absorption heat pumps (and/or other heat or heat and mass transfer systems) with larger cooling and/or heating capacities than those typically associated with the preferred, monolithic apparatus previously discussed. The heat and mass transfer components comprising the recuperative solution heat exchanger **800,** desorber **1100,** rectifier **1150,** condenser **1200,** recuperative refrigerant heat exchanger **1300,** evaporator **1400,** and absorber **1500** are shown as individual heat and/or mass exchangers arranged according to one layout for the system assembly. Generally, the system architectures, features, and functions of each of these heat and mass transfer components are similar to those previously described. For example, each component shown in FIG. 17 includes a plurality of shim pairs; however, each shim only includes the microscale features necessary to accomplish the individual heat and mass transfer functions of its respective component.

To avoid unnecessary cluttering, the fluid lines and connections to coupling fluids, etc., are not shown in FIG. 17. As will be understood, however, fluid connecting lines or other passages should be included in system embodiments to transfer working fluids and coupling fluids within and/or between components as appropriate. According to one embodiment, the discrete components shown in FIG. 17 are incorporated into an integrated structure, such as a large, insulated unit, such that although the individual heat and mass transfer components are formed as discrete components, the overall absorption heating and/or cooling assembly may be contained in an integral package, if necessary.

### Description of Particular Exemplary Embodiment

The discussion below relates to specifics for a particular, exemplary embodiment of the present system described herein. Specifically, described below are calculations, manufacturing processes, design details, dimensions, feature arrangements, exemplary working fluids and coupling fluids, and other similar details associated with the described, exemplary embodiment and methods of making the same. As will be understood and appreciated, the specific embodiment and application described below is but one embodiment of the present system, and is not intended to limit the scope of the present disclosure, or the invention(s) and systems described herein, in any way.

Specifically, the discussion below describes the design and fabrication of a miniaturized (i.e., microscale), monolithic absorption heat pump system utilizing microchannel heat and mass transfer system components. An exemplary embodiment of the present system was built according to the specifications, parameters, etc., outlined below, and the achieved performance results for the exemplary embodiment under specified parameters are provided herein.

### Manufacturing Techniques

The manufacturing techniques used to build the exemplary apparatus allow multiple microchannel heat and mass transfer components or heat exchange components (i.e., heat exchangers) to be fabricated at the same time in a single, monolithic structure. For this exemplary embodiment, the microchannels **702** are first formed on stainless steel shims **102, 104** by a wet chemical etching process. The shims are then diffusion bonded together to form the overall apparatus **10.** By placing shims with different microchannel configurations in an alternating pattern, the fluid streams of each heat and mass transfer component are allowed to come into close thermal contact. The steps according to one embodiment of the microchannel manufacturing process are outlined in greater detail below.

### Photochemical Etching

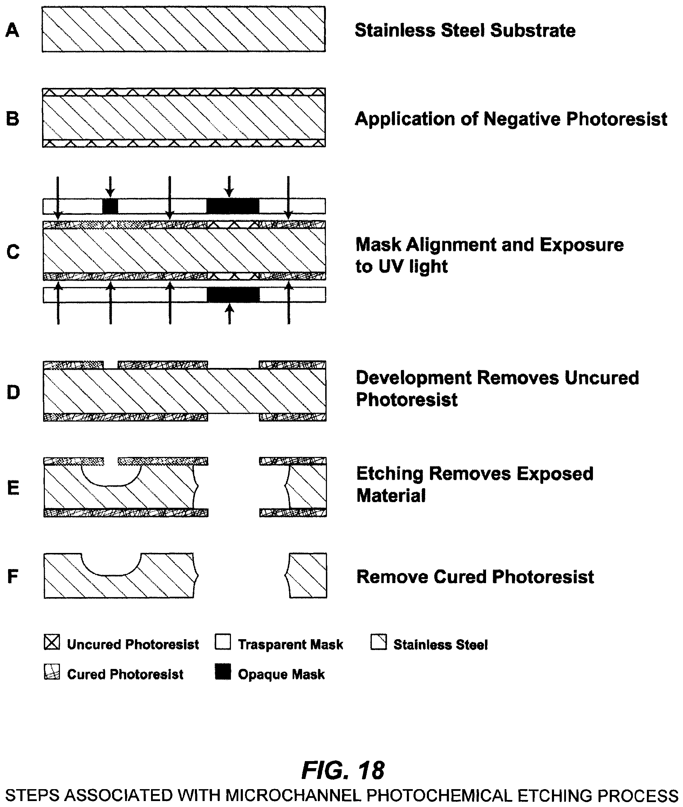

FIG. 18 illustrates the steps associated with one embodiment of the photochemical etching process for manufacturing microchannels **702** according to an exemplary embodiment as described herein. As will be understood and appreciated, other processes and manufacturing techniques may be used to manufacture microchannels, as described previously. The photochemical etching process begins with cleaning the stainless steel shims **102, 104** to remove any oils, greases, metal working fluids or other contaminants on the surface. The shims are then cleaned with hydrochloric acid to remove any scale or oxides on the surface of the metal.

A photosensitive material (photoresist) is then applied to both sides of the given shim **102, 104.** The photo resist material used in the production of the exemplary apparatus is a dry film, negative resist. The portions of the resist exposed to UV light cure and protect the underlying steel during the etching process.

A mask containing the image of the required flow channels (i.e., microchannels) is created for both sides of each of the two shim designs (i.e., shims A 102 and B 104). The mask is a film with opaque sections representing the areas to be etched and transparent sections representing areas wherein the photo resist should remain to protect the base material from the etching chemicals. The masks are mounted to both sides of the shim and aligned to ensure features match up on both sides of the steel.

The arrangement of the steel, photoresist, and mask is then exposed to ultra violet light to cure the photoresist. The uncured photoresist is then removed in a developing process. The metal with the cured photoresist is then passed through the etching process, wherein a ferric chloride solution (i.e., acid solution) is used as the etchant. This acid solution removes the exposed metal and forms the microchannels and holes in the steel shim.

Once the shim is removed from the etching process, the remaining photoresist material is similarly removed. During the etching process, the shims remain connected to the process sheets by several tabs. Leaving the shims tabbed to the sheets ensures consistent etching. After the photoresist material is removed, the individual shims are removed from the process sheet. The photoresist application and the etching process are generally conducted in a clean room to reduce the risk of dust contamination which could cause manufacturing defects during the etching process.

### Diffusion Bonding

In the exemplary embodiment described herein, the shims are joined using a diffusion bonding process. As will be understood, the shims may be combined via other bonding or combination processes according to various embodiments, as described previously. The diffusion bonding process begins with cleaning the shims **102, 104** and an inspection to ensure there are no burrs or foreign objects on the shim material. The shims are coated with a nickel plating in an electroless nickel plating procedure. The nickel coating is applied to aid in creating a hermetic seal during the diffusion bonding process.

The shims **102, 104** and cover plates **110, 111** are then arranged in the correct order (e.g., alternating shims A and B) and proper alignment of the shims is carefully monitored (e.g., via alignment notches **602, 604** described previously). Two pins are inserted into alignment notches in the front plate **110,** end plate **111,** and shim group **108,** respectively. In this particular embodiment, all shims and the back end cover plate **111** each have at least one alignment notch. This alignment scheme enables the steel shims to lie flat, even if there are minor inconsistencies in the position of the alignment notches. It also allows the steel to expand and contract due to thermal expansion during the bonding process without causing buckling or delimitation while achieving alignment tolerances of ±0.05 mm.

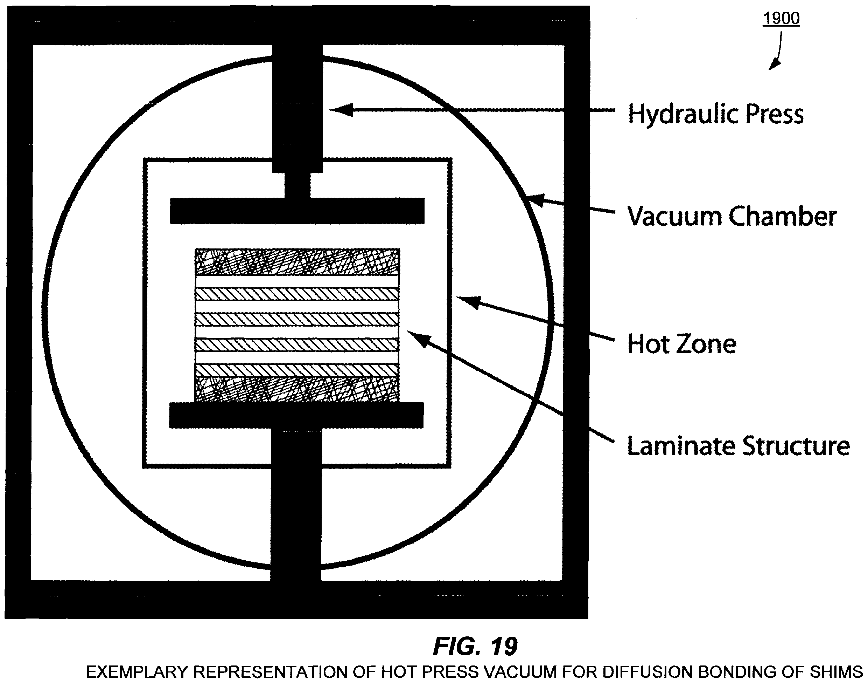

The assembled system **10** is then placed in a hot press vacuum furnace **1900,** illustrated and represented by FIG. 19. The evacuation in the hot press furnace **1900** removes any air from between the shims (i.e., laminates) as well as from the voids within the assembled shims. The system is then raised to an elevated temperature (e.g., approximately 1000°C) in the vacuum conditions and a load is applied to the system to raise the interfacial stress between adjoining components to a required value (e.g., approximately 10 MPa). The system remains at these conditions for a sufficient period of time (e.g., approximately 5 hours) for the bonding process to occur.

During the bonding process, the surface asperities on contacting surfaces begin to deform plastically. The deformation continues until the pores between the surfaces have been eliminated. The atoms from adjacent surfaces can then diffuse across the interface, allowing the grain boundaries to reorganize in the interface region. This process forms a bond with a strength approaching the yield strength of the bulk material.

### Cycle Design Calculations

A thermodynamic model for the exemplary system was developed by choosing representative design conditions for the operation of a single-effect absorption cycle in the cooling mode. Throughout this section and for ease of reference, previously-presented reference numerals are used to identify various system components. Particularly, reference is made to FIG. 5, which shows the schematic functional representation of the internal heat and mass transfer components and the fluid flows between the components according to one embodiment of the present system. Principally, the external heat source input, desired cooling, and ambient conditions are established to enable the cycle design. With a representative heat sink (i.e., heat rejection **140)** temperature of 37°C, a thermal power input (i.e., heat source **130)** of 800 W, and specified desired cooling **150** of 300 W, system design calculations are initiated. As mentioned, these selected parameters are chosen purely for purposes of describing an exemplary system embodiment, and are in no way intended to limit system parameters, capacities, etc.

These specified representative external conditions for heat source and sink, combined with allowances for temperature differences between the external conditions and the working fluid that yield reasonable component surface area requirements, result in high and low side operating pressures of approximately1600 and 400 kPa, respectively. Thus, the high-side pressure is established by the choice of a driving temperature difference between the condensed refrigerant (i.e., ammonia) and an ambient sink in the condenser **1200.** Similar consideration of the driving temperature difference at the desorber component **1100** and the already established high-side pressure yields a dilute solution outlet temperature and concentration, i.e., fraction of ammonia in an ammonia-water solution. Using the corresponding concentrated solution inlet temperature at the desorber **1100,** the high-side pressure, and the equilibrium properties of ammonia-water mixtures, a solution inlet enthalpy is obtained. Coupled with the dilute solution outlet enthalpy at the desorber **1100,** the heat input is related to the concentrated solution flow rate through an energy balance between the heat source and the working fluid. For the representative design point calculation, the resulting concentrated solution mass flow rate and ammonia mass fraction are 2.7×10⁻³ kg/s and 0.37, respectively. The energy balance calculation and the equilibrium relationships also yield the vapor quality (ratio of ammonia-water vapor mixture to total ammonia-water two-phase flow rate) and concentration at the desorber **1100** outlet. A summary of key operating conditions for this representative, exemplary cycle is provided in Table 1.

**Table 1 - State Points for Exemplary Absorption Heat Pump Cycle**

| **State Point** | **T, °C** | **P, kPa** | **x, kg/kg** |
|---|---|---|---|
| Solution/Refrigerant State Points | | | |
| Absorber Concentrated Solution out | 50.4 | 400 | 0.37 |
| Rectifier Concentrated Solution In | 50.8 | 1600 | 0.37 |
| Recuperative Solution Heat Exchanger Concentrated Solution In | 63.7 | 1600 | 0.37 |
| Recuperative Solution Heat Exchanger Concentrated Solution Out | 109 | 1600 | 0.37 |
| Desorber Out | 128.2 | 1600 | 0.37 |
| Rectifier Vapor In | 128.2 | 1600 | 0.876 |
| Rectifier Reflux Out | 128.2 | 1600 | 0.285 |
| Recuperative Solution Heat Exchanger Dilute Solution In | 128.2 | 1600 | 0.285 |
| Recuperative Solution Heat Exchanger Dilute Solution Out | 75.7 | 1600 | 0.285 |
| Absorber Dilute Solution In | 73.2 | 400 | 0.285 |
| Rectifier Refrigerant Out | 85 | 1600 | 0.984 |
| Condenser Refrigerant Out | 39.6 | 1600 | 0.984 |
| Recuperative Refrigerant Heat Exchanger High Out | 30.2 | 1600 | 0.984 |
| Evaporator Refrigerant In | -1.4 | 400 | 0.984 |
| Evaporator Refrigerant Out | 8.6 | 400 | 0.984 |
| Recuperative Refrigerant Heat Exchanger Low Out | 18 | 400 | 0.984 |

| Coolant State Points | | | |
|---|---|---|---|
| Evaporator Coolant In | 9 | 101.3 | NA |
| Evaporator Coolant Out | 5.5 | 101.3 | NA |
| Absorber Coolant In | 37 | 101.3 | NA |
| Absorber Coolant Out | 45.6 | 101.3 | NA |
| Condenser Coolant In | 37 | 101.3 | NA |
| Condenser Coolant Out | 42.6 | 101.3 | NA |

A low vapor concentration exiting the desorber **1100** would cause severe temperature glide penalties in the evaporator **1400,** resulting in rising refrigerant temperatures that would unduly restrict cooling. To ensure an adequately pure ammonia refrigerant stream, the vapor stream should be cooled in the rectifier **1150** to strip off extra water vapor. Accordingly, the design outlet temperature of the saturated vapor stream leaving the rectifier is set to provide a minimum ammonia concentration of 98% for this exemplary embodiment.

Generally, the reflux liquid that is condensed out of the refrigerant stream in the rectifier **1150** flows back into the separation chamber where it mixes with the dilute solution before exiting the desorber **1100.** An energy balance on the rectifier vapor inlet and outlet and liquid streams yields the rectifier cooling load.

In this embodiment, for the design calculations to provide the required cooling, the concentrated solution stream leaving the solution pump **502** (see FIG. 5) is assumed to be the cooling source for the rectifier **1150** (i.e., via cooling fluid line **524**). The aforementioned energy balance also yields the outlet enthalpy and temperature of the concentrated solution upon cooling the vapor stream in the rectifier. Additionally, mass and species balances on the rectifier yield the refrigerant and reflux mass flowrates. The reflux mixes with the remaining liquid solution in the separation chamber in the bottom of the rectifier and exits towards the recuperative solution heat exchanger **800.** Mass and species balances on this mixing process yield the dilute solution flowrate and concentration.

The refrigerant vapor leaving the rectifier **1150** flows to the condenser **1200.** With an assumption of a subcooled liquid refrigerant outlet from the condenser, the refrigerant concentration and the high-side pressure, and the condenser refrigerant outlet temperature are established. The condenser heat load is also calculated using an energy balance. In addition, this condenser heat load is used in combination with a set coolant (i.e., coupling fluid) flow rate to determine the coolant outlet temperature from the condenser (i.e., via medium temperature fluid line **528**). After leaving the condenser **1200,** the refrigerant flows through the recuperative refrigerant heat exchanger **1300** where it is further cooled by the refrigerant leaving the evaporator.

The expansion of the refrigerant exiting the recuperative refrigerant heat exchanger **1300** through the expansion valve **534** (see FIG. 5) is assumed to be isenthalpic for this exemplary embodiment, which yields the evaporator **1400** inlet temperature. With a fixed evaporator temperature glide requirement, the evaporator outlet temperature is determined, which also yields the cooling load in the evaporator. The calculated cooling load, in conjunction with a set chilled water (i.e., coupling fluid) flowrate and inlet temperature, yields the chilled water outlet temperature (i.e., to desired cooling **150**) from an energy balance. A similar energy balance is conducted on the recuperative refrigerant heat exchanger **1300** to obtain the low pressure vapor state at the outlet of this heat exchanger, which is also the absorber refrigerant inlet condition for this exemplary embodiment.

Returning to the solution circuit, according to the described exemplary embodiment, the concentrated solution inlet to the recuperative solution heat exchanger **800** is determined by the outlet of the rectifier **1150.** An energy balance on the recuperative solution heat exchanger yields the dilute solution and concentrated solution outlet conditions from this heat exchanger, as well as its heat load. The solution expansion valve **534** is assumed to be isenthalpic. Regarding the absorber **1500,** with the inlet conditions to the absorber fixed (as described above), and with an assumed solution subcooling at the absorber outlet, the absorber heat load is calculated from an energy balance.

Once the state points are fixed (as described above) using mass, species and enthalpy balances for each exemplary heat and mass transfer system component, the heat transfer rates of each component necessary to yield the desired cooling load are also fixed. Subsequent calculations are conducted to obtain the required heat and mass transfer component surface area requirements based on these desired heat loads and the relevant heat and mass transfer models and correlations. Varying levels of detail may be incorporated into such component design calculations, but for the fabrication of this particular exemplary embodiment, the component heat and mass transfer calculations are conducted by treating each component as one single, integrated component, with the fluid properties averaged over the component. Thus, the heat and mass transfer component sizes are obtained based on the component heat loads, the coupled heat and mass transfer resistances, and the driving log-mean temperature differences. This technique is valid for heat exchangers where the heat capacity rates of the two fluid streams (e.g., the working fluid and coupling fluid) are constant along the length of the heat exchanger. For ammonia-water systems, in some components, the thermal capacities vary along the length, but this technique may be applied to obtain reasonable estimates of component sizes, with proper accounting of the driving temperature differences. The heat and mass transfer component geometries are generally determined based on these heat and mass transfer calculations to satisfy the required heat loads, as well as on dimensional requirements based on manufacturing techniques discussed herein.

### Component Design Calculations

As described above, according to the described exemplary embodiment, the required size (overall heat transfer conductance, UA) of each heat transfer component is determined from the cycle model. The specific fluid channel configuration (i.e., microchannels, voids, and distribution passages) of each heat and mass transfer component is determined by estimating the overall heat transfer resistance of each individual component.

FIG. 20 illustrates a cross-section **2000** of a portion of a plurality of stacked shims A **102** and B **104** showing representative arrangements of microchannels **702** within the shims according to an exemplary embodiment of the present system. The cross-section **2000** specifically illustrates the relative positioning, sizing, thermal contact, etc., of microchannels **702** in combined shims A and B for a given heat exchange component described herein. As will be understood and appreciated, the cross-section arrangement **2000** illustrated in FIG. 20 is shown for exemplary purposes only, and other embodiments of the present system utilize other microchannel arrangements as will occur to one of ordinary skill in the art.

As shown in FIG. 20, heat exchange fluids (e.g., coupling fluids and working fluids) flow through the microchannels on alternating shims A **102** and B **104** in a counterflow arrangement (although, as is understood, the flows do not necessarily have to be counterflow depending on the specific embodiment). The analysis of each heat exchange component begins by considering the extracted and enlarged cross-section **2002,** which illustrates various microchannel and shim dimensions (described in greater detail below).

According to the described embodiment and as shown in FIG. 20, the wet chemical etching process to create microchannels creates channel cross-sections of rounded rectangular shape. During the etching process, the etchant acts laterally as well as vertically, removing material under the edge of the cured photoresist, creating rounded features as shown in FIG. 20.

According to the described, exemplary embodiment, each heat and mass transfer component in the system is modeled by computing the thermal resistance presented by each fluid flowing through the respective microchannels in shims A **102** and B **104,** in addition to the conductive thermal resistance presented by the intervening metal wall between the shims (as illustrated in FIG. 20 as t_{wall}). Furthermore, the total surface area of the microchannels is treated as a combination of surfaces in direct and indirect thermal contact with the fluid on the other side of the wall. The indirect thermal contact presented by the microchannel side walls is accounted for by computing the effective heat transfer area based on the appropriate fin efficiencies. (For the range of heat transfer coefficients encountered in this design process (380 - 38,000 W/m²-K), and the range of channel and shim geometries of interest, the fin efficiencies approach unity and the entire area of the microchannel walls can be treated as prime surface.) The heat transfer coefficient for each of the fluid streams is determined from applicable correlations.

Based on the heat exchange component heat and mass transfer design approach outlined above, the microchannel width, microchannel length, and number of microchannels for each component are determined to satisfy the design heat loads at the pertinent operating conditions computed from thermodynamic cycle analyses. As will be understood, however, the approach outline above is but one approach to determine appropriate microchannel dimensions, and other approaches are used in other embodiments as will occur to one of skill in the art.

FIG. 21 illustrates an enlarged cross-section **2100** of shims A **102** and B **104** illustrating a close-up view of specific, exemplary shim and microchannel dimensions according to an exemplary embodiment of the present system. In order to simplify the design procedure for this exemplary embodiment, a single microchannel size is used for all heat exchange components and/or heat and mass transfer system components mentioned above, as shown in FIG. 21. As shown, a shim thickness of 0.5 mm (i.e., approximately 0.02 in) is chosen based, in part, on the range of microchannel sizes that can be fabricated on the shim. With a microchannel etch depth of half the shim thickness and a microchannel width of 0.5 mm, the nominal channel hydraulic diameter for this exemplary embodiment is 306 µm, with a channel horizontal transverse pitch of 1 mm and vertical pitch of 0.5 mm. These dimensions are illustrated in FIG. 21. As will be understood, these dimensions are presented for illustrative purposes only, and embodiments of the present system are not limited in any way by the indicated dimensions shown and described.

In the described, exemplary embodiment, the flows of all coupling fluids are in single-phase laminar liquid flow. Similarly, working fluid flows in the recuperative solution heat exchanger **800** and the recuperative refrigerant heat exchanger **1300** are in single-phase laminar flow. According to the described embodiment, the heat transfer coefficient and friction factor for such single-phase flows in the exemplary microchannel shape (shown in FIG. 21) and other similar shapes (such as rectangular channels for the coolant in the rectifier **1150**) are estimated using the correlations reported in Kakac et al., Handbook of Single-Phase Convective Heat Transfer, New York, Wiley (1987).

According to one embodiment, for vapor-to-liquid phase change processes such as condensation, correlations described in Shah, M. M., A General Correlation for Heat Transfer During Film Condensation Inside Pipes, International Journal of Heat and Mass Transfer, Vol. 22(4), pp. 547-556 (1979), and Kandlikar, S., Garimella, S., Li, D., Colin, S. and King, M. R., Heat Transfer and Fluid Flow in Minichannels and Microchannels, Elsevier Science (2005), are used, as applicable, for each particular phase change process. Other guidance for addressing single-component and multi-component phase-change heat and mass transfer in condensers, absorbers, evaporators, desorbers, and rectifiers is taken from the models, correlations, and techniques outlined in Carey, V. P., Liquid-Vapor Phase-Change Phenomena: An Introduction to the Thermophysics of Vaporization and Condensation Processes in Heat Transfer Equipment, Washington, D.C., Taylor & Francis Series, Hemisphere Pub. Corp. (1992), and Hewitt, G. F., Shires, G. L. and Bott, T. R., Process Heat Transfer, Boca Raton, CRC Press, Begell House (1994). Two-phase pressure drops are estimated using the two-phase pressure drop multiplier approach of Mishima et al., Some Characteristics of Air-Water Two-Phase Flow in Small Diameter Vertical Tubes, International Journal of Multiphase Flow, Vol. 22(4), pp. 703-712 (1996). Nonlinear variations of vapor quality with heat exchanger length, even in these integrated analyses, are accounted for by evaluating these correlations at the integrated average properties along the component length. Conservative estimates of two-phase pressure drops are obtained by computing the greatest pressure gradient in the heat and mass transfer component as a function of vapor quality or component length and applying that to the total length of the heat and mass transfer component.

Generally, evaporation heat transfer coefficients are calculated using the correlation from Kandlikar et al., Predicting Heat Transfer During Flow Boiling in Minichannels and Microchannels, Chicago, IL, Soc. Heating, Ref. Air-Conditioning Eng. Inc., pp. 667-676 (2003) and Kandlikar et al., An Extension of the Flow Boiling Correlation to Transition, Laminar, and Deep Laminar Flows and Microchannels, Heat Transfer Engineering, Vol. 25(3), pp. 86-93 (2004). The mean heat transfer coefficient for the evaporating stream is calculated at a representative integrated average vapor quality along the evaporator length to account for the non-linear variation of vapor quality with evaporator length.

According to the described exemplary embodiment, desorption (vapor generation from the concentrated solution) is achieved in the desorber **1100** using eight 150 W electrical cartridge heaters for a maximum heat input of 1200 W. Heat fluxes supplied by the heaters at a design desorber heat input rate of 800 W were found to be well below critical heat flux limitations estimated using the correlation for parallel mini/microchannels from Qu et al., Measurement and Correlation of Critical Heat Flux in Two-Phase Micro-Channel Heat Sinks, International Journal of Heat and Mass Transfer, Vol. 47(10-11), pp. 2045-2059 (2004).

For the exemplary rectifier **1150** design, the liquid reflux and the vapor stream are assumed to be in thermal equilibrium so that the temperature of the reflux leaving the rectifier is equal to the temperature of the vapor entering the rectifier. In order to facilitate the approach to this equilibrium, four trays are included in the exemplary rectifier to hold the liquid reflux and allow heat and mass transfer interaction with the counterflow vapor. The heat transfer coefficient on the refrigerant side is estimated using the laminar film condensation correlation from Sadasivan et al., Sensible Heat Correction in Laminar Film Boiling and Condensation, Journal of Heat Transfer, Transactions ASME, Vol. 109(2), pp. 545-547 (1987). Only the area of the single wall in thermal contact with the concentrated solution is used for heat transfer estimation in the rectifier for the particular exemplary embodiment of the present system. The heat and mass transfer area associated with the trays is not included in this calculation in order to produce a more conservative result. The additional area of the trays further enhances the performance of this heat and mass transfer component.

Further details of the correlations mentioned above in reference to various articles and texts can be found in the cited literature. Representative dimensions of the exemplary heat and mass transfer system components resulting from the calculations described above are presented in Table 2. As will be understood and appreciated, the dimensions and geometric details shown in Table 2 are presented for illustrative purposes only, and pertain to the specific, described, exemplary embodiment of a single-effect absorption cycle, and are in no way intended to limit or exclude other combinations of system geometries, arrangements of various heat exchange components or heat and mass transfer components, channel hydraulic diameters, numbers of channels, shim thicknesses, numbers of shims, etc., used in other embodiments of the present system.

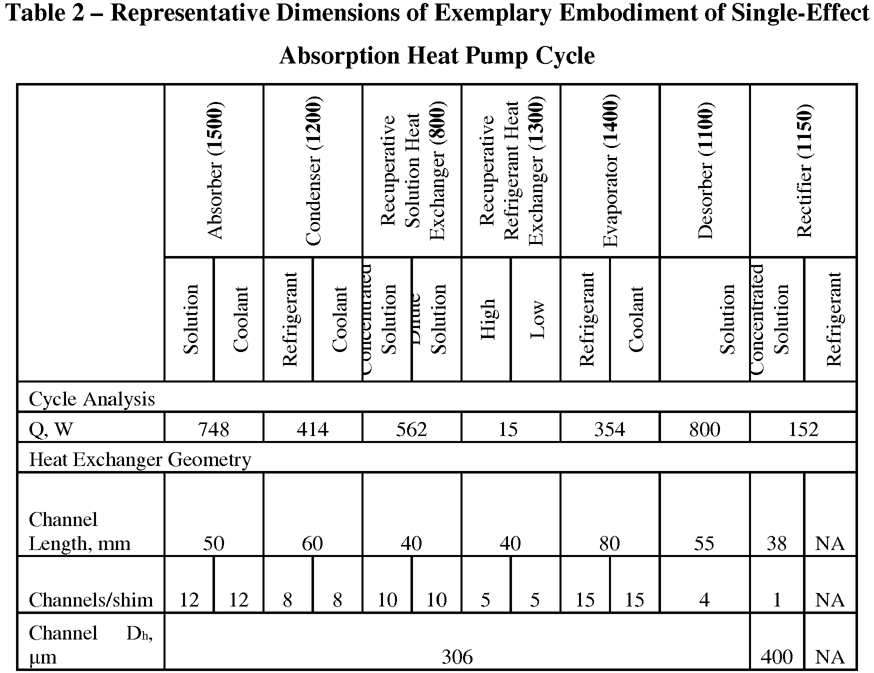

### Packaging and Bonding Considerations

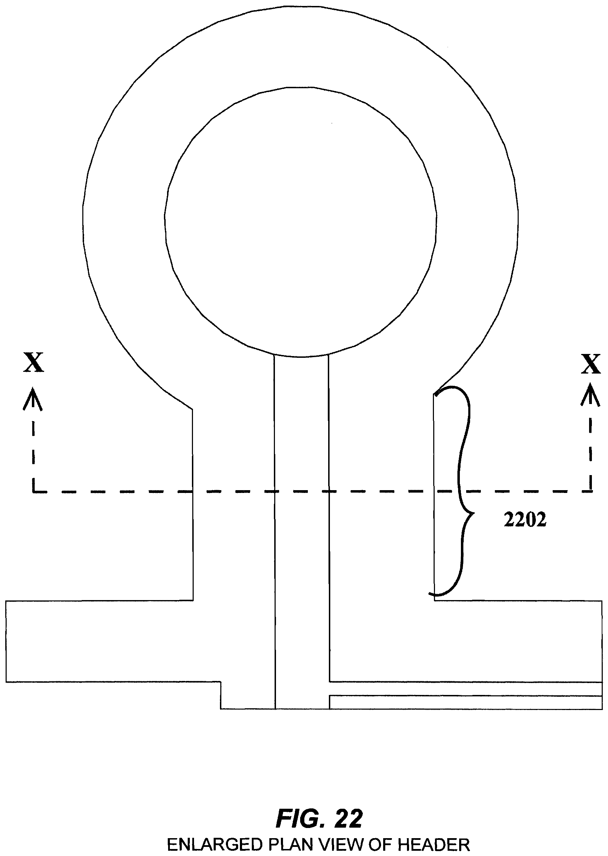

FIG. 22 shows an enlarged plan view of a header (e.g., header created by stacked-up voids **808a, 808b** in the recuperative solution heat exchanger **800**) used in a heat and mass transfer component according to an embodiment of the present system. In the embodiment shown, the fluid distribution passage (e.g., passage **806** in the recuperative solution heat exchanger **800**) within necked region **2202** creates an area where bonding pressure is not transmitted directly through the stacked shims during the diffusion bonding process. A similar area is present below the microchannels **702** as they enter a heat exchanger core from a header (e.g., microchannel entry from void **810a** in the recuperative solution heat exchanger); however, the fluid distribution passages (e.g., **806**) are generally much wider than individual microchannels, and thus the fluid distribution passages represent a critical bonding point.

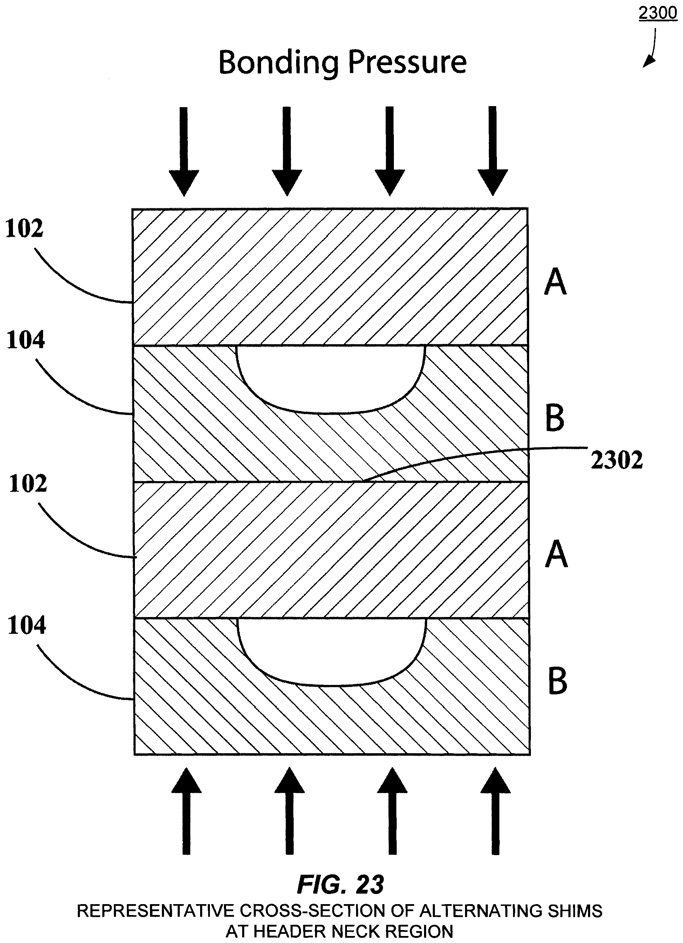

FIG. 23 shows a representative cross-section **2300** of a portion of alternating shims A **102** and B **104** taken from cross-section **XX** of the header in FIG. 22 according to one embodiment of the present system. According to the exemplary, described embodiment, the bonding pressure should be transmitted laterally underneath the fluid distribution passages on shims B **104** to ensure a hermetic seal at the critical bonding point **2302.** Passage widths of 2 mm are used in this exemplary embodiment to ensure sufficient bonding, although wider or narrower widths are used according to other system embodiments.

As described previously, preferred embodiments of the present system comprise microscale, monolithic heat or heat and mass transfer systems. Because it is often desirable, depending on the particular embodiment, to include more than one heat and mass transfer system component within an integrated, monolithic structure, system embodiments should account for extraneous heat transferred between internal heat and mass transfer system components. To account for this extraneous heat transfer, certain factors are taken into account in various embodiments, such as overall size of the microscale heat or heat and mass transfer system, spacing between heat and mass transfer components within the system, arrangement and type of fluid connections between various system components, and other similar factors as will occur to one of ordinary skill in the art.

As will be understood and as described previously, the exemplary embodiment described herein, and its associated operating parameters, temperature ranges, etc., are provided for illustrative purposes only, and are not intended to limit the scope of the present systems or apparatuses in any way. Generally, various operating temperature and pressure ranges are envisioned depending on the application under consideration. Thus, for example, when applied for waste heat recovery from high temperature combustion processes such as automotive exhaust, the heat source temperature could range from 300°C to 900°C, while for low temperature waste heat recovery, the source temperature could be as low as 40°C. Similarly, for chiller applications, the cooled fluid temperature is typically about 5-15°C, whereas for refrigeration applications, the temperature could be well below 0°C. For heat rejection temperatures in air conditioning applications, ambient temperatures in 20-55°C are contemplated. However, as will be understood, the specific values of these individual external temperatures are less important than the relationship between the heat source, heat sink, and the cooling temperature. Because a thermally-activated heat pump is generally known as a three temperature (i.e., low temperature cooling, medium temperature heat rejection, and high temperature input heat source) system, the temperatures for which the subject heat and mass transfer system may be applied should provide at least a minimal lift, i.e., temperature difference, between the low and medium temperatures to effect the desired output, and the medium and high temperatures to provide the driving force necessary to effect the desired output.

### Form Factor Comparison and Representative Parameters of Exemplary Embodiment

As described previously, one exemplary embodiment of the present system comprises a microscale, monolithic absorption cooling and/or heating system. The following section provides a comparison of the described, exemplary embodiment of the present system in the form of such an absorption cooling and/or heating system to a traditional vapor-compression system used for residential cooling. This section also provides representative parameters associated with the exemplary embodiment described herein. As will be understood and appreciated, the following discussion is provided for illustrative purposes only, and is in no way intended to limit the scope of the present disclosure, or the invention(s) and systems described herein.

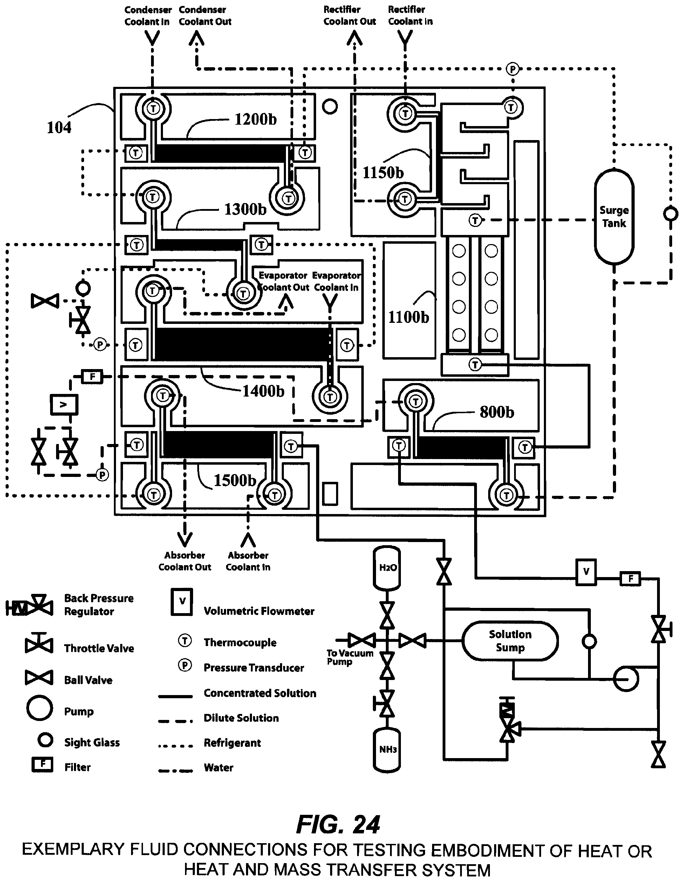

The exemplary embodiment of the present system described above (i.e., a microscale, monolithic absorption heat pump) was manufactured and tested under realistic ambient, chilled fluid, and heat source conditions on a breadboard test facility. FIG. 24 illustrates a front plan view of exemplary fluid connections and external plumbing arrangements for testing an embodiment of the present system. The manufactured exemplary system embodiment comprised overall dimensions of 200 × 200 × 34 mm³, including 20 pairs of 0.5 mm thick shims A and B (i.e., 40 shims total), with previously described microchannels of 306 µm hydraulic diameter. The exemplary, manufactured system comprised other dimensions, system arrangements, etc., as described above.

During testing of the exemplary embodiment, nominal 300 W of cooling were delivered for an 800 W heat input at representative ambient and chilled fluid conditions. Furthermore, the exemplary system was demonstrated to operate in cooling mode over a wide range of ambient temperatures (i.e., 20-35°C) and at different heat input rates (i.e., 500-800 W). A nominal coefficient of performance (COP) of 0.375 was achieved in a system volume of 200 × 200 × 34 mm³, representing a volumetric cooling capacity of 221 kW/m³. With a system mass of 7 kg, the corresponding specific cooling capacity is 0.043 kW/kg. The exemplary embodiment was purposely designed with all heat and mass transfer system component fluid inlets and outlets external (i.e., outside) to the apparatus, with wide spacing to enable installation of temperature and pressure instrumentation at the inlet and/or outlet of each component. An alternate embodiment, with internal flow passages and elimination of extra space for instrumentation, comprises projected dimensions of 120 × 120 × 25 mm³, with a mass of 3 kg. The corresponding volumetric cooling capacity of such an embodiment comprises 833 kW/m³, while the specific cooling capacity is 0.10 kW/kg.

By comparison, conventional 10.55 kW cooling capacity residential electric-vapor compression systems are on the order of 0.91 x 0.91 x 0.91 m³ and weigh about 225 kg, representing volumetric cooling capacities on the order of only 13.8 kW/m³ and specific cooling capacities of 0.047 kW/kg. Therefore, on both volumetric and mass bases, the subject exemplary system embodiment represents a substantial reduction in size of cooling systems, while providing a similar cooling capacity to those of much larger, conventional vapor-compression systems.

When compared to conventional absorption cooling systems (as opposed to vapor-compression systems), the benefits of the exemplary system embodiment described above become even more evident. As described previously, absorption cooling systems are generally much larger than vapor-compression systems due to the additional heat and mass transfer components needed in absorption systems. Thus, as will be understood, comparison of the exemplary, described embodiment to a conventional 10.55 kW cooling capacity absorption cooling system indicates advanced volumetric or specific cooling capacities of the exemplary embodiment (due to the larger size and weight of conventional absorption cooling systems exhibiting an unchanged cooling capacity, as compared to the vapor-compression system discussed above). Additionally, because many fluid connections between heat and mass transfer system components are included within a monolithic, microscale structure of a system embodiment, leak reduction is enhanced, and required fluid inventory is substantially lower than that of conventional systems.

The foregoing description of the exemplary embodiments has been presented only for the purposes of illustration and description and is not intended to be exhaustive or to limit the inventions to the precise forms disclosed. Many modifications and variations are possible in light of the above teaching.

Accordingly, the scope of the present invention is defined by the appended claims rather than the foregoing description and the exemplary embodiments described therein.

## Claims

1. An integrated heat and mass transfer apparatus (10) comprising:
a heat and mass transfer system utilizing absorption and having a plurality of heat exchange regions for effecting a heat transfer function of a particular component, wherein the plurality of heat exchange regions comprises an absorber (1500), a desorber (1100), a rectifier (1150), a condenser (1200), a recuperative solution heat exchanger (800), a recuperative refrigerant heat exchanger (1300) and an evaporator (1400);
a fluid coupling means for coupling a thermally modified flow of a coupling fluid through at least one heat exchange region; and
a pair of cover plates (110, 111) that include ports for introducing a working fluid and the coupling fluid into functional components and for transporting the working fluid and the coupling fluid out of the functional components;
wherein the condenser, evaporator, absorber, recuperative refrigerant heat exchanger and recuperative solution heat exchanger of the plurality of heat exchange regions are defined by a plurality of rows of microchannels (702) of a plurality of shims (102, 104), the shims being stacked, planar, and heat conducting shims, each shim comprising:
openings that define a plurality of fluid voids for containing:
the working fluid; and
the coupling fluid for conveying thermal energy into or out of the heat and mass transfer system;
the plurality of rows of microchannels (702) being formed by microscale indentations on the plurality of shims (102, 104);
wherein the plurality of rows of microchannels (702) comprise:
a first row of microchannels for communicating a first flow of the working fluid from an inlet fluid void associated with the particular component of the heat and mass transfer system into an outlet fluid void associated with the particular component of the heat and mass transfer system; and
a second row of microchannels for communicating either a second flow of the working fluid associated with the particular component of the heat and mass transfer system or a flow of the coupling fluid for the heat transfer function of the heat exchange regions, wherein the second row of microchannels are in thermal contact with the first row of microchannels to conduct heat between the first flow of the working fluid in the first row of microchannels and either the second flow of the working fluid or the flow of the coupling fluid in the second row of microchannels for the heat transfer function of the at least one heat exchange region;
wherein each one of the shims (102, 104) forms a portion of the absorber (1500), the desorber (1100), the rectifier (1150), the condenser (1200) the recuperative refrigerant heat exchanger (1300), the recuperative solution heat exchanger (800) and the evaporator (1400);
wherein in the absorber, in use mass is transferred between a first fluid stream in the microchannels on a second shim and a second fluid stream in the microchannels on an adjacent first shim such that a refrigerant is absorbed by an absorbent via vapor inlet holes (1518) formed in a row of the microchannels on the first shim through which a vapor component of the first fluid stream is able to mix with the second fluid stream; and
wherein the system provides a heating or cooling or mass transfer function via the thermally modified flow of the coupling fluid.

2. The integrated heat and mass transfer apparatus (10) of claim 1, wherein the system is configured to operate as a heat pump, wherein the fluid coupling means comprises:
a first fluid coupling means for coupling a first flow of a heated coupling fluid through a an initial stage heat exchange region of the heat and mass transfer system for receiving thermal energy into the system;
a second fluid coupling means for coupling a thermally modified second flow of coupling fluid through a subsequent stage heat exchange region of the heat and mass transfer system; and
a third fluid coupling means for coupling a heat rejection flow of coupling fluid through a heat exchange region of a stage of the heat and mass transfer system.

3. The integrated heat and mass transfer apparatus (10) of any preceding claim, wherein the plurality of shims (102, 104) are arranged as a plurality of pairs of shims of a first type and a second type that when paired together define the microchannels (702) for communicating working fluid and/or coupling fluid between fluid voids of the particular component of the heat and mass transfer system.

4. The integrated heat and mass transfer apparatus (10) of claim 3, wherein each of the pairs of shims comprise a predetermined single element of a multi-element array of the shims that have dimensions determined by input/output thermal properties and fluid flow characteristics of the heat and mass transfer system.

5. The integrated heat and mass transfer system (10) of any preceding claim, wherein the particular component of the heat and mass transfer system comprises a refrigerant absorber, wherein a plurality of vapor inlet holes (1518) formed in a row of the microchannels on a first shim provide for vapor flowing from a passage in an adjacent second shim to flow into the microchannels of the first shim and mix with absorbent in the microchannels of the first shim.

6. The integrated heat and mass transfer apparatus (10) of any preceding claim, wherein one of the plurality of fluid voids comprises a fluid header for directing a flow of working fluid or coupling fluid for the particular component into a fluid distribution passage that directs the fluid into a row of microchannels (702).

7. The integrated heat and mass transfer apparatus (10) of any preceding claim, wherein the microscale indentations comprise a shape formed in a top surface of a first shim of one of the plurality of shims (102, 104) for conducting fluid alongside and thermal energy into a corresponding and adjacent bottom surface of an adjacent second shim of the plurality of shims (102, 104) that encloses the indentations so as to form the microchannels (702).

8. The integrated heat and mass transfer apparatus (10) of any preceding claim, wherein the microscale indentations are selected from the group consisting of machined grooves, cut grooves, photoetched grooves, chemically etched grooves, laser etched grooves, molded grooves, stamped grooves, and particle blasted grooves, or combinations thereof.

9. The integrated heat and mass transfer apparatus (10) of any preceding claim, wherein the plurality of stacked shims (102, 104) and pair of cover plates (110, 111) are physically bonded to form a unitary structure.

10. The integrated heat and mass transfer apparatus (10) of claim 9, wherein the physical bonding is performed by a method selected from the group consisting of diffusion bonding, gluing, brazing, welding, and pressing.

11. The integrated heat and mass transfer apparatus (10) of any preceding claim, wherein a particular implementation of the heat and mass transfer system comprises an absorption heat pump with the working fluid of the absorption heat pump being selected from the group consisting of ammonia-water and lithium-bromide-water admixture.

12. The integrated heat and mass transfer apparatus (10) of claim 11, wherein the heat pump is configured to be a half-effect, single-effect, a double-effect, a triple-effect, or a generator-absorber-heat exchange (GAX) cycle.

13. The integrated heat and mass transfer apparatus (10) of any preceding claim, further comprising one or more fluid pumps for moving the working fluid or the coupling fluid between the functional components.

14. The integrated heat and mass transfer apparatus (10) of any preceding claim, wherein the flow of working fluid in the first row of microchannels is substantially counterflow, parallel-flow, co-flow or crossflow in direction to the direction of flow of fluid in the second row of microchannels.

15. The integrated heat and mass transfer apparatus (10) of any preceding claim, wherein the particular component of the heat and mass transfer system comprises a refrigerant rectifier of an absorption heat pump, and further comprises a plurality of fluid-retaining ribs formed within the monolithic support structure that form trays for containing a quantity of liquid and enable a flow of vapor and liquid in opposite directions, with the fluid and vapor in direct mass contact across a surface of liquid contained by the trays and in thermal contact with a coupling fluid or working fluid, with a reflux of liquid collecting and exiting the rectifier in a generally downward fashion to join a desorber solution flow.

16. The integrated heat and mass transfer apparatus (10) of any preceding claim, wherein the heat and mass transfer system is an absorption heat pump or a multi-component fluid processing system that includes a forced convective flow of fluids in some regions within the system and a gravity/buoyancy driven flow of fluids in other regions of the system such that desired liquid or vapor temperatures, species concentrations, and species concentration gradients during phase change are achieved, and further comprising passages formed within the monolithic structure that provide for downward liquid flow in conjunction with upward vapor flow in a counterflow arrangement within the passages, whereby conditions promoting the boiling or desorption of vapor and/or higher refrigerant vapor purities are effected.

## Patentansprüche

1. Integrierte Wärme- und Masseübertragungsvorrichtung (10), umfassend:
ein Wärme- und Masseübertragungssystem, das Absorption nutzt und eine Mehrzahl von Wärmetauschregionen aufweist, um eine Wärmeübertragungsfunktion einer bestimmten Komponente zu bewirken, wobei die Mehrzahl von Wärmetauschregionen einen Absorber (1500), einen Desorber (1100), einen Gleichrichter (1150), einen Kondensator (1200), einen rekuperativen Lösungswärmetauscher (800), einen rekuperativen Kältemittelwärmetauscher (1300) und einen Verdampfer (1400) umfasst;
ein Fluidkopplungsmittel zur Kopplung eines thermisch modifizierten Flusses eines Kopplungsfluids durch wenigstens eine Wärmetauschregion; und
ein Paar von Abdeckplatten (110, 111), die Anschlüsse zum Einführen eines Arbeitsfluids und des Kopplungsfluids in Funktionskomponenten sowie zur Beförderung des Arbeitsfluids und des Kopplungsfluids aus den Funktionskomponenten aufweisen;
wobei der Kondensator, Verdampfer, Absorber, rekuperative Kältemittelwärmetauscher und rekuperative Lösungswärmetauscher der Mehrzahl von Wärmetauschregionen durch eine Mehrzahl von Reihen von Mikrokanälen (702) einer Mehrzahl von Scheiben (102, 104) definiert sind, wobei die Scheiben gestapelte, ebene und wärmeleitende Scheiben sind, wobei jede Scheibe folgendes umfasst:
Öffnungen, die eine Mehrzahl von Fluidporen definieren, um folgendes aufzunehmen:
das Arbeitsfluid; und
das Kopplungsfluid zur Übermittlung von Wärmeenergie in das oder aus dem Wärme- und Masseübertragungssystem;
wobei die Mehrzahl von Reihen von Mikrokanälen (702) durch Vertiefungen im Mikromaßstab auf der Mehrzahl von Scheiben (102, 104) ausgebildet sind;
wobei die Mehrzahl von Reihen von Mikrokanälen (702) folgendes umfasst:
eine erste Reihe von Mikrokanälen zur Kommunikation eines ersten Flusses des Arbeitsfluids von einer der bestimmten Komponente des Wärme- und Masseübertragungssystems zugeordneten Einlassfluidpore in eine der bestimmten Komponente des Wärme- und Masseübertragungssystems zugeordnete Auslassfluidpore; und
eine zweite Reihe von Mikrokanälen zur Kommunikation entweder eines zweiten Flusses des Arbeitsfluids, der der bestimmten Komponente des Wärme- und Masseübertragungssystems zugeordnet ist, oder eines Flusses des Kopplungsfluids für die Wärmeübertragungsfunktion der Wärmetauschregionen, wobei sich die zweite Reihe von Mikrokanälen in thermischem Kontakt mit der ersten Reihe von Mikrokanälen befindet, um Wärme zwischen dem ersten Fluss des Arbeitsfluids in der ersten Reihe von Mikrokanälen und entweder dem zweiten Fluss des Arbeitsfluids oder dem Fluss des Kopplungsfluids in der zweiten Reihe von Mikrokanälen für die Wärmeübertragungsfunktion der wenigstens einen Wärmetauschregion zu leiten;
wobei jede der Scheiben (102, 104) einen Teil des Absorbers (1500), des Desorbers (1100), des Gleichrichters (1150), des Kondensators (1200), des rekuperativen Kältemittelwärmetauschers (1300), des rekuperativen Lösungswärmetauschers (800) und des Verdampfers (1400) bildet;
wobei im Einsatz in dem Absorber Masse zwischen einem ersten Fluidstrom in den Mikrokanälen auf einer zweiten Scheibe und einem zweiten Fluidstrom in den Mikrokanälen auf einer benachbarten ersten Scheibe übertragen wird, so dass ein Kältemittel durch ein Absorptionsmittel über in einer Reihe der Mikrokanäle auf der ersten Scheibe ausgebildete Dampfeinlasslöcher (1518) absorbiert wird, wodurch sich eine Dampfkomponente des ersten Fluidstroms mit dem zweiten Fluidstrom mischen kann; und
wobei das System eine Erwärmungs- oder Kühlungs- oder Masseübertragungsfunktion über den thermisch modifizierten Fluss des Kopplungsfluids bereitstellt.

2. Integrierte Wärme- und Masseübertragungsvorrichtung (10) nach Anspruch 1, wobei das System so gestaltet ist, dass es als eine Wärmepumpe arbeitet, wobei das Fluidkopplungsmittel folgendes umfasst:
ein erstes Fluidkopplungsmittel zur Kopplung eines ersten Flusses eines erwärmten Kopplungsfluids durch eine Wärmetauschregion der ersten Stufe des Wärme- und Masseübertragungssystems zum Empfang von Wärmeenergie in dem System;
ein zweites Fluidkopplungsmittel zur Kopplung eines thermisch modifizierten zweiten Flusses von Kopplungsfluid durch eine folgende Stufe des Wärme- und Masseübertragungssystems; und
ein drittes Fluidkopplungsmittel zur Kopplung eines Wärmeabgabeflusses von Kopplungsfluid durch eine Wärmetauschregion einer Stufe des Wärme- und Masseübertragungssystems.

3. Integrierte Wärme- und Masseübertragungsvorrichtung (10) nach einem der vorstehenden Ansprüche, wobei die Mehrzahl von Scheiben (102, 104) als eine Mehrzahl von Scheibenpaaren eines ersten Typs und eines zweiten Typs angeordnet ist, die bei einer Paarzusammenstellung die Mikrokanäle (702) zur Kommunikation von Arbeitsfluid und/oder Kopplungsfluid zwischen Fluidporen der bestimmten Komponente des Wärme- und Masseübertragungssystems definieren.

4. Integrierte Wärme- und Masseübertragungsvorrichtung (10) nach Anspruch 3, wobei jedes der Scheibenpaare ein vorbestimmtes einzelnes Element einer Mehrelementanordnung der Scheiben umfasst, die Abmessungen aufweisen, die durch die thermischen Eigenschaften bei Eingang/Ausgang und die Fluidflusseigenschaften des Wärme- und Masseübertragungssystems bestimmt sind.

5. Integrierte Wärme- und Masseübertragungsvorrichtung (10) nach einem der vorstehenden Ansprüche, wobei die Komponente des Wärme- und Masseübertragungssystems einen Kältemittelabsorber umfasst, wobei eine Mehrzahl von Dampfeinlasslöchern (1518), die in einer Reihe von Mikrokanälen auf einer ersten Scheibe ausgebildet ist, dafür sorgen, dass von einem Durchgang in einer benachbarten zweiten Scheibe fließender Dampf in die Mikrokanäle der ersten Scheibe fließt und sich mit dem Absorptionsmittel in den Mikrokanälen der ersten Scheibe vermischt.

6. Integrierte Wärme- und Masseübertragungsvorrichtung (10) nach einem der vorstehenden Ansprüche, wobei eine der Mehrzahl von Fluidporen einen Fluidverteiler zum Leiten eines Flusses von Arbeitsfluid oder Kopplungsfluid für die bestimmte Komponente in einen Fluidverteilungsdurchgang umfasst, der das Fluid in eine Reihe von Mikrokanälen (702) leitet.

7. Integrierte Wärme- und Masseübertragungsvorrichtung (10) nach einem der vorstehenden Ansprüche, wobei die Vertiefungen im Mikromaßstab eine in einer oberen Oberfläche einer ersten Scheibe der Mehrzahl von Scheiben (102, 104) ausgebildete Form umfassen, um Fluid entlang und Wärmeenergie in eine entsprechende und angrenzende untere Oberfläche einer benachbarten zweiten Scheibe der Mehrzahl von Scheiben (102, 104) zu leiten, welche die Vertiefungen einschließt, um die Mikrokanäle (702) zu bilden.

8. Integrierte Wärme- und Masseübertragungsvorrichtung (10) nach einem der vorstehenden Ansprüche, wobei die Vertiefungen im Mikromaßstab ausgewählt sind aus der Gruppe bestehend aus maschinell hergestellten Rillen, geschnittenen Rillen, fotogeätzten Rillen, chemisch geätzten Rillen, lasergeätzten Rillen, geformten Rillen, gestanzten Rillen und partikelgestrahlten Rillen oder Kombinationen dieser.

9. Integrierte Wärme- und Masseübertragungsvorrichtung (10) nach einem der vorstehenden Ansprüche, wobei die Mehrzahl gestapelter Scheiben (102, 104) und das Paar von Abdeckplatten (110, 111) physikalisch verbunden sind, so dass sie eine unitäre Struktur bilden.

10. Integrierte Wärme- und Masseübertragungsvorrichtung (10) nach Anspruch 9, wobei die physikalische Verbindung durch ein Verfahren durchgeführt wird, das ausgewählt ist aus Gruppe bestehend aus Diffusionsverbindung, Kleben, Löten, Schweißen und Pressen.

11. Integrierte Wärme- und Masseübertragungsvorrichtung (10) nach einem der vorstehenden Ansprüche, wobei eine bestimmte Implementierung des Wärme- und Masseübertragungssystems eine Absorptionswärmepumpe umfasst, wobei das Arbeitsfluid der Absorptionswärmepumpe ausgewählt ist aus der Gruppe bestehend aus Ammoniakwasser und Lithium-Bromid-Wasser-Gemisch.

12. Integrierte Wärme- und Masseübertragungsvorrichtung (10) nach Anspruch 11, wobei die Wärmepumpe so gestaltet ist, dass sie einen Halbeffekt, einen einfachen Effekt, einen doppelten Effekt, einen dreifachen Effekt oder einen Generator-Absorber-Wärmetauschzyklus darstellt.

13. Integrierte Wärme- und Masseübertragungsvorrichtung (10) nach einem der vorstehenden Ansprüche, ferner umfassend eine oder mehrere Fluidpumpen zur Bewegung des Arbeitsfluids oder des Kopplungsfluids zwischen den Funktionskomponenten.

14. Integrierte Wärme- und Masseübertragungsvorrichtung (10) nach einem der vorstehenden Ansprüche, wobei der Fluss des Arbeitsfluids in der ersten Reihe von Mikrokanälen im Wesentlich Gegenstrom, Parallelstrom, Gleichstrom oder Querstrom in Richtung zu der Richtung des Fluidflusses in der zweiten Reihe von Mikrokanälen ist.

15. Integrierte Wärme- und Masseübertragungsvorrichtung (10) nach einem der vorstehenden Ansprüche, wobei die bestimmte Komponente des Wärme- und Masseübertragungssystems einen Kältemittelgleichrichter einer Absorptionswärmepumpe umfasst, und wobei sie ferner eine Mehrzahl von Kältemittelrückhalterippen umfasst, die in der monolithischen Trägerstruktur ausgebildet sind, welche Schalen bilden, um eine Flüssigkeitsmenge zu speichern und eine Strömung von Dampf und Flüssigkeit in entgegengesetzte Richtungen ermöglichen, wobei sich das Fluid und der Dampf über eine Oberfläche der sich in den Schalen befindenden Flüssigkeit in direktem Massekontakt befinden und in thermischem Kontakt mit einem Kopplungsfluid oder Arbeitsfluid, mit einem Rückfluss von Flüssigkeit, die sich in dem Gleichrichter sammelt und aus diesem allgemein nach unten austritt, so dass sie mit einem Desorberlösungsfluss zusammentrifft.

16. Integrierte Wärme- und Masseübertragungsvorrichtung (10) nach einem der vorstehenden Ansprüche, wobei das Wärme- und Masseübertragungssystem eine Absorptionswärmepumpe oder ein Mehrkomponenten-Fluidverarbeitungssystem ist, das in bestimmten Regionen in dem System eine erzwungene Fluidkonvektionsströmung aufweist und eine durch Gravität/Auftrieb gesteuerte Fluidströmung in anderen Regionen des Systems, so dass gewünschte Flüssigkeits- oder Dampftemperaturen, Spezieskonzentrationen und Spezieskonzentrationsgradienten während einer Phasenänderung erreicht werden, und ferner umfassend Durchgänge, die in der monolithischen Struktur ausgebildet sind, die einen Abwärtsflüssigkeitsfluss in Verbindung mit einem Aufwärtsdampffluss in einer Gegenströmungsanordnung in den Durchgängen bereitstellen, wodurch Zustände erreicht werden, welche das Sieden oder die Desorption von Dampf und/oder höhere Kältemitteldampfreinheiten fördern.

## Revendications

1. Appareil intégré de transfert de chaleur et de masse (10) comprenant :
un système de transfert de chaleur et de masse utilisant l'absorption et ayant une pluralité de régions d'échange de chaleur pour effectuer une fonction de transfert de chaleur d'un composant particulier, la pluralité de régions d'échange de chaleur comprenant un absorbeur (1500), un désorbeur (1100), un redresseur (1150), un condenseur (1200), un échangeur de chaleur de solution de récupération (800), un échangeur de chaleur de fluide frigorifique de récupération (1300) et un évaporateur (1400) ;
un moyen de couplage de fluide pour coupler un flux thermiquement modifié d'un fluide de couplage à travers au moins une région d'échange de chaleur ; et
une paire de plaques de recouvrement (110, 111) qui comprennent des orifices pour introduire un fluide de travail et le fluide de couplage dans les composants fonctionnels et pour transporter le fluide de travail et le fluide de couplage hors des composants fonctionnels ;
le condenseur, l'évaporateur, l'absorbeur, l'échangeur de chaleur de fluide frigorifique de récupération et l'échangeur de chaleur de solution de récupération de la pluralité de régions d'échange de chaleur étant définis par une pluralité de rangées de microcanaux (702) d'une pluralité de cales (102, 104), les cales étant empilées, planes et conductrices de chaleur, chaque cale comprenant :
des ouvertures qui définissent une pluralité de vides de fluide pour contenir :
le fluide de travail ; et
le fluide de couplage pour transporter l'énergie thermique dans ou hors du système de transfert de chaleur et de masse ;
la pluralité de rangées de microcanaux (702) étant formée par des empreintes à l'échelle micro sur la pluralité de cales (102, 104) ;
la pluralité de rangées de microcanaux (702) comprenant :
une première rangée de microcanaux pour communiquer un premier flux du fluide de travail d'un vide de fluide d'entrée associé au composant particulier du système de transfert de chaleur et de masse dans un vide de fluide de sortie associé au composant particulier du système de transfert de chaleur et de masse ; et
une seconde rangée de microcanaux pour communiquer un second flux du fluide de travail associé au composant particulier du système de transfert de chaleur et de masse ou un flux du fluide de couplage pour la fonction de transfert de chaleur des régions d'échange de chaleur, la seconde rangée de microcanaux étant en contact thermique avec la première rangée de microcanaux pour conduire la chaleur entre le premier flux du fluide de travail dans la première rangée de microcanaux et le second flux du fluide de travail ou le flux du fluide de couplage dans la seconde rangée de microcanaux pour la fonction de transfert de chaleur de l'au moins une région d'échange de chaleur ;
chacune des cales (102, 104) formant une partie de l'absorbeur (1500), du désorbeur (1100), du redresseur (1150), du condenseur (1200), de l'échangeur de chaleur de fluide frigorifique de récupération (1300), de l'échangeur de chaleur de solution de récupération (800) et de l'évaporateur (1400) ;
dans l'absorbeur, lors de l'utilisation la masse étant transférée entre un premier courant de fluide dans les microcanaux sur une seconde cale et un second courant de fluide dans les microcanaux sur une première cale adjacente de sorte qu'un fluide frigorifique soit absorbé par un absorbant par l'intermédiaire de trous d'entrée de vapeur (1518) formés dans une rangée des microcanaux sur la première cale à travers laquelle un composant vapeur du premier courant de fluide peut se mélanger avec le second courant de fluide ; et
le système fournissant une fonction de chauffage ou de refroidissement ou de transfert de masse par l'intermédiaire du flux thermiquement modifié du fluide de couplage.

2. Appareil intégré de transfert de chaleur et de masse (10) selon la revendication 1, le système étant conçu pour fonctionner comme une pompe à chaleur, le moyen de couplage de fluide comprenant :
un premier moyen de couplage de fluide pour coupler un premier flux d'un fluide de couplage chauffé à travers une région d'échange de chaleur d'étage initial du système de transfert de chaleur et de masse pour recevoir de l'énergie thermique dans le système ;
un deuxième moyen de couplage de fluide pour coupler un second flux de fluide de couplage modifié thermiquement à travers une région d'échange de chaleur d'étage suivant du système de transfert de chaleur et de masse ; et
un troisième moyen de couplage de fluide pour coupler un flux de rejet de chaleur d'un fluide de couplage à travers une région d'échange de chaleur d'un étage du système de transfert de chaleur et de masse.

3. Appareil intégré de transfert de chaleur et de masse (10) selon l'une quelconque des revendications précédentes, la pluralité de cales (102, 104) étant disposées comme une pluralité de paires de cales d'un premier type et d'un second type qui, lorsqu'elles sont appariées, définissent les microcanaux (702) pour communiquer un fluide de travail et/ou un fluide de couplage entre des vides de fluide du composant particulier du système de transfert de chaleur et de masse.

4. Appareil intégré de transfert de chaleur et de masse (10) selon la revendication 3, chacune des paires de cales comprenant un élément unique prédéfini d'un réseau à éléments multiples des cales qui ont des dimensions déterminées par les propriétés thermiques d'entrée/de sortie et les caractéristiques de flux de fluide du système de transfert de chaleur et de masse.

5. Système intégré de transfert de chaleur et de masse (10) selon l'une quelconque des revendications précédentes, le composant particulier du système de transfert de chaleur et de masse comprenant un absorbeur de fluide frigorifique, une pluralité de trous d'entrée de vapeur (1518) formés dans une rangée des microcanaux sur une première cale permettant à la vapeur s'écoulant d'un passage dans une seconde cale adjacente de s'écouler dans les microcanaux de la première cale et de se mélanger avec de l'absorbant dans les microcanaux de la première cale.

6. Appareil intégré de transfert de chaleur et de masse (10) selon l'une quelconque des revendications précédentes, l'un de la pluralité de vides de fluide comprenant un collecteur de fluide pour diriger un flux de fluide de travail ou de fluide de couplage pour le composant particulier dans un passage de distribution de fluide qui dirige le fluide dans une rangée de microcanaux (702).

7. Appareil intégré de transfert de chaleur et de masse (10) selon l'une quelconque des revendications précédentes, les empreintes à l'échelle micro comprenant une forme formée dans une surface supérieure d'une première cale de l'une de la pluralité de cales (102, 104) pour conduire le fluide le long de et l'énergie thermique dans une surface inférieure correspondante et adjacente d'une seconde cale adjacente de la pluralité de cales (102, 104) qui enferme les empreintes de sorte à former les microcanaux (702).

8. Appareil intégré de transfert de chaleur et de masse (10) selon l'une quelconque des revendications précédentes, les empreintes à l'échelle micro étant choisies dans le groupe constitué par les rainures usinées, rainures coupées, rainures photodécoupées, rainures gravées chimiquement, rainures gravées au laser, rainures moulées, rainures estampées et rainures sablées par particules, ou des combinaisons de celles-ci.

9. Appareil intégré de transfert de chaleur et de masse (10) selon l'une quelconque des revendications précédentes, la pluralité de cales empilées (102, 104) et une paire de plaques de recouvrement (110, 111) étant physiquement liées pour former une structure unitaire.

10. Appareil intégré de transfert de chaleur et de masse (10) selon la revendication 9, la liaison physique étant effectuée par un procédé choisi dans le groupe constitué par la liaison par diffusion, le collage, le brasage, le soudage et le pressage.

11. Appareil intégré de transfert de chaleur et de masse (10) selon l'une quelconque des revendications précédentes, une mise en oeuvre particulière du système de transfert de chaleur et de masse comprenant une pompe à chaleur à absorption, le fluide de travail de la pompe à chaleur à absorption étant choisi dans le groupe constitué par un mélange ammoniac-eau et lithium-bromure-eau.

12. Appareil intégré de transfert de chaleur et de masse (10) selon la revendication 11, la pompe à chaleur étant conçue pour être un cycle à demi-effet, simple effet, double effet, triple effet ou générateur-absorbeur-échange de chaleur (GAX).

13. Appareil intégré de transfert de chaleur et de masse (10) selon l'une quelconque des revendications précédentes, comprenant en outre une ou plusieurs pompes à fluide pour déplacer le fluide de travail ou le fluide de couplage entre les composants fonctionnels.

14. Appareil intégré de transfert de chaleur et de masse (10) selon l'une quelconque des revendications précédentes, le flux du fluide de travail dans la première rangée de microcanaux étant sensiblement à contre-courant, à flux parallèle, à co-flux ou à flux croisé dans la direction de flux du fluide dans la seconde rangée de microcanaux.

15. Appareil intégré de transfert de chaleur et de masse (10) selon l'une quelconque des revendications précédentes, le composant particulier du système de transfert de chaleur et de masse comprenant un redresseur de fluide frigorifique d'une pompe à chaleur à absorption, et comprenant en outre une pluralité de nervures de rétention de fluide formées dans la structure de support monolithique qui forment des plateaux pour contenir une quantité de liquide et permettent un flux de vapeur et de liquide dans des directions opposées, le fluide et la vapeur étant en contact de masse direct sur une surface de liquide contenue par les plateaux et en contact thermique avec un fluide de couplage ou fluide de travail, avec un reflux de liquide collectant et sortant du redresseur d'une manière généralement vers le bas pour joindre un flux de solution de désorbeur.

16. Appareil intégré de transfert de chaleur et de masse (10) selon l'une quelconque des revendications précédentes, le système de transfert de chaleur et de masse étant une pompe à chaleur à absorption ou un système de traitement de fluide à plusieurs composants qui comprend un flux convectif forcé de fluides dans certaines régions du système et un flux de fluides entraîné par gravité/poussée dans d'autres régions du système de sorte que les températures de liquide ou de vapeur souhaitées, les concentrations d'espèces et les gradients de concentration d'espèces pendant le changement de phase soient atteints, et comprenant en outre des passages formés dans la structure monolithique qui fournissent un flux de liquide vers le bas en conjonction avec un flux de vapeur vers le haut dans un agencement à contre-courant dans les passages, moyennant quoi des conditions favorisant l'ébullition ou la désorption de vapeur et/ou de puretés de vapeur de fluide frigorifique supérieures sont atteintes.
